# EUROPEAN PATENT APPLICATION

(11) **EP 4 303 657 A2**
(43) Date of publication of application: **10.01.2024**
(21) Application number: 23183890.5
(22) Date of filing: 06.07.2023
(51) Int. Cl.: G03F 7/09, H01L 21/02

(54) **COMPOSITION FOR FORMING METAL OXIDE FILM, PATTERNING PROCESS, AND METHOD FOR FORMING METAL OXIDE FILM**

(30) Priority: 08.07.2022 JP 2022110193
(71) Applicant: SHIN-ETSU CHEMICAL CO., LTD., Tokyo 1000005 (JP)
(72) Inventor: Kobayashi, Naoki, Niigata (JP); Nagamachi, Nobuhiro, Niigata (JP); Kori, Daisuke, Niigata (JP)
(74) Representative: Sonnenhauser, Thomas Martin

(57) **Abstract**

The present invention is a composition for forming a metal oxide film including (A) an organic-inorganic composite material and (B) a solvent, (A) the organic-inorganic composite material being a reaction product of a metal source (I) and an organic source (II), the metal source (I) containing one or more compounds derived from a metal compound represented by the general formula (I-1), and the organic source (II) containing a compound having a unit represented by the general formula (II-1) and a cardo structure. The present invention provides a composition for forming a metal oxide film which has excellent coatability relative to a previously-known material for forming a metal oxide film and also has high filling and planarizing properties, a patterning process using the material, and a method for forming a metal oxide film.

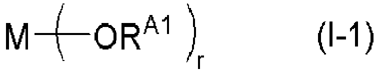

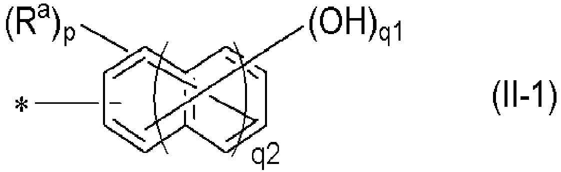

## Description

### TECHNICAL FIELD

The present invention relates to a composition for forming a metal oxide film that can be used for fine patterning by way of a multilayer resist method in a semiconductor device production process, a patterning process using the composition, and a method for forming a metal oxide film.

### BACKGROUND ART

Along with high integration and high processing speed of LSI, miniaturization of pattern size is rapidly advancing. Along with the miniaturization, lithography technology has achieved a fine patterning by shortening wavelength of a light source and selecting an appropriate resist composition accordingly. The composition mainly used is a positive photoresist composition for monolayer. The monolayer positive photoresist composition not only allows a resist resin to have a skeleton having etching resistance against dry etching with chlorine- or fluorine-based gas plasma, but also provides a switching mechanism that makes an exposed portion soluble, thereby dissolving the exposed portion to form a pattern and processing a substrate to be processed by dry etching using the remaining resist pattern as an etching mask.

However, when the pattern becomes finer, that is, the pattern width is reduced without changing the thickness of the photoresist film to be used, resolution performance of the photoresist film is lowered. In addition, pattern development of such a photoresist film with a developer excessively increases a so-called aspect ratio of the pattern, resulting in pattern collapse. Therefore, the photoresist film has been thinned along with the miniaturization of the pattern.

On the other hand, a substrate to be processed has been generally processed by dry etching using a pattern-formed photoresist film as an etching mask. However, there is no practical dry etching method capable of providing an absolute etching selectivity between the photoresist film and the substrate to be processed. The photoresist film is thus also damaged and collapses during processing of the substrate, and the resist pattern cannot be accurately transferred to the substrate to be processed. Accordingly, higher dry etching resistance has been required in a resist composition along with the miniaturization of the pattern. However, on the other hand, a resin used for the photoresist composition needs to have low light absorption at exposure wavelength in order to improve the resolution. For this reason, the resin shifted to a novolak resin, polyhydroxystyrene, and a resin having an aliphatic polycyclic skeleton as the exposure light shifted from i-line to KrF and ArF, which have shorter wavelength. However, this shift actually accelerated an etching rate under dry etching condition for processing the substrate, and recent photoresist compositions having high resolution rather tend to have low etching resistance.

As a result, the substrate to be processed has to be dry etched with a thinner photoresist film having lower etching resistance. Therefore, a demand for finding a material used in this processing and the process therefor has become urgent.

A multilayer resist method is one of the solutions for the above problems. This method is as follows: a resist middle layer film with a different etching selectivity from a photoresist film (i.e., a resist upper layer film) is placed between the resist upper layer film and a substrate to be processed; a pattern is formed in the resist upper layer film; the pattern is transferred to the resist middle layer film by dry etching using the resist upper layer film pattern as a dry etching mask; the pattern is further transferred to the substrate to be processed by dry etching using the resist middle layer film as a dry etching mask.

One of the multilayer resist methods is a three-layer resist method, which can be performed with a typical resist composition used in the monolayer resist method. For example, this three-layer resist method includes the following steps: an organic film containing a novolak resin or the like is formed as a resist underlayer film on a substrate to be processed; a silicon-containing resist middle layer film is formed thereon as a resist middle layer film; and a usual organic photoresist film is formed thereon as a resist upper layer film. Since the organic resist upper layer film ensures an excellent etching selectivity ratio relative to the silicon-containing resist middle layer film when dry etching is performed with fluorine-based gas plasma, the resist upper layer film pattern can be transferred to the silicon-containing resist middle layer film by dry etching with fluorine-based gas plasma. This method allows the pattern to be transferred to the silicon-containing resist middle layer film (resist middle layer film) even by using a resist composition that is difficult to form a pattern having a sufficient film thickness for directly processing the substrate to be processed or a resist composition that has insufficient dry etching resistance for processing the substrate. Then, further performing dry etching with oxygen gas plasma or hydrogen gas plasma allows the pattern to be transferred to the organic film (resist underlayer film) containing a novolak resin or the like, which has a sufficient dry etching resistance for processing the substrate. As to the organic film described above, many materials are already known, such as those disclosed in Patent Document 1.

On the other hand, in recent years, with the rapid miniaturization of DRAM memory, there is a growing need for further improvement in dry etching resistance, as well as a need for an organic film having excellent filling and planarizing properties. As a coating-type organic underlayer film material excellent in filling and planarizing properties, for example, the composition disclosed in Patent Document 2 has been reported. However, in view of application of this composition in the advanced generation, there is a concern about dry etching resistance. The application limit of the previously-known coating-type organic underlayer film material is thus approaching.

In view of the problematic dry etching resistance of the coating-type organic underlayer film material, a method of using a metal oxide film as the resist underlayer film is drawing attention (Patent Document 3). However, the common soluble metal compounds for forming metal oxide films, such as metal alkoxides, are highly unstable to moisture in the air, which raises concerns about insufficient storage stability. Further, when only a metal compound is used, the flowability is insufficient, and it is difficult to perform high-level filling and planarization. Therefore, a composition to which an organic material is added in order to increase the flowability has been developed.

Such a composition obtained by adding an organic material to a metal compound is reported in Patent Document 4. By using a polymer functionalized with an alkynyloxy group as an organic material, this technique is characterized by providing a composition with excellent stability even for a mixed composition with a metal compound. Although the Examples of Patent Document 4 nowhere disclose evaluation of dry etching resistance, because of the use of a metal compound having terminals modified with a Si-containing organic group, the dry etching resistance to fluorocarbon-based gases may be insufficient.

Patent Document 5 reports a mixed composition of a metal compound and an aromatic compound that generates a hydroxyl group by heat or acid. Although Patent Document 5 nowhere discloses evaluation of filling property, because of the large volume shrinkage of the metal compound associated with ligand elimination during heating, voids may be formed if the stepped substrate is heated at a high temperature after being filled. Further, as the problem of the mixed composition, if the compatibility between the metal compound and the organic polymer is insufficient, aggregation of each component is likely to occur during the coating, which may result in poor film forming.

In view of the above, an alternative method that can be used instead of those using mixed compositions of metal compound and organic material has been in demand.

Non-Patent Document 1 reports formation of an organic-inorganic composite material by a condensation reaction of a metal alkoxide and an organic polymer. Non-Patent Document 1 uses a polymer as the organic component, and it is assumed that flowability needs to be improved to ensure filling property of patterns with high aspect ratios.

### CITATION LIST

### PATENT LITERATURE

Patent Document 1: Japanese Laid-Open Patent Application Publication No. 2004-205685
Patent Document 2: JP6714493B
Patent Document 3: JP6189758B
Patent Document 4: Japanese Laid-Open Patent Application Publication (Translation of PCT Application) No. 2022-521531
Patent Document 5: JP5756134B

### NON-PATENT LITERATURE

Non-Patent Document 1: Chem. Commun., 2015, 51, 13523-13526

### SUMMARY OF INVENTION

### TECHNICAL PROBLEM

The present invention has been made in view of the above circumstances, and an object thereof is to provide a composition for forming a metal oxide film which has excellent coatability relative to a previously-known material for forming a metal oxide film and also has high filling and planarizing properties, a patterning process using the composition, and a method for forming a metal oxide film.

### SOLUTION TO PROBLEM

In order to achieve the above object, the present invention provides a composition for forming a metal oxide film, comprising (A) an organic-inorganic composite material and (B) a solvent.
(A) The organic-inorganic composite material is a reaction product of a metal source (I) and an organic source (II). The metal source (I) comprises one or more compounds selected from a metal compound represented by the following general formula (1-1), a hydrolysate of the metal compound represented by the general formula (1-1), and a hydrolysis condensate of the metal compound represented by the general formula (1-1). The organic source (II) comprises a compound having a constituent unit represented by the following general formula (II-1) and a cardo structure, 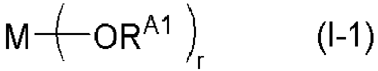 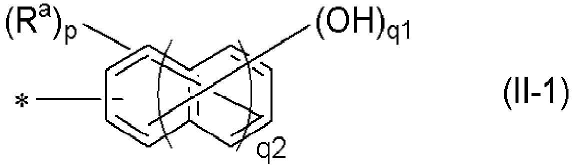 wherein M is a metal; and each R^{A1} may be identical to or different from one another, and represents a monovalent organic group having 1 to 30 carbon atoms with 0 or 1 hydroxy group, adjacent R^{A1} may be bonded to each other to form a spiro ring, and to form a ring together with O and M to which these R^{A1} are bonded; and r is an integer of 3 to 6; R^{a} is an optionally substituted saturated monovalent organic group having 1 to 10 carbon atoms or an optionally substituted unsaturated monovalent organic group having 2 to 10 carbon atoms; "p" is an integer of 0 to 5; q₁ is an integer of 1 to 6; p+q₁ is an integer of 1 or more and 6 or less; q₂ is 0 or 1; and * represents a bonding site.

Such a composition for forming a metal oxide film has excellent coatability relative to a previously-known material for forming a metal oxide film, as well as high filling and planarizing properties. In particular, since the organic-inorganic composite material, which is a reaction product of a metal source (I) with excellent dry etching resistance and an organic source (II) having the constituent unit represented by the above general formula (II-1) with excellent reactivity, is used, it is possible to desirably form a metal oxide film with excellent dry etching resistance.

Since the above organic source (II) contains a cardo structure, it is possible to improve dry etching resistance and heat resistance of the composition for forming a metal oxide film. Further, by the action of the cardo structure introduced into the molecule, the interaction between the molecules is alleviated and the solubility in an organic solvent is imparted; therefore, the compatibility of the organic-inorganic composite material is improved and the film forming property at the time of forming a coating film is improved. In addition, despite the introduction of a plurality of condensed carbon rings having a high carbon density, it is possible to achieve both heat resistance and filling and planarizing properties, which are contradictory to each other.

In the present invention, the organic source (II) preferably has the constituent unit represented by the following general formula (II-2), in addition to the constituent unit represented by the general formula (II-1) and a cardo structure. 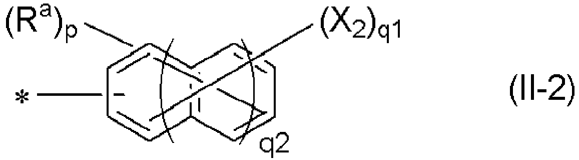 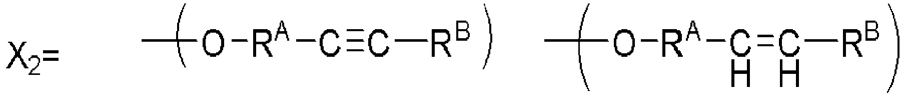 In the above general formula (II-2), R^{A} is an optionally substituted divalent organic group having 1 to 10 carbon atoms, R^{B} is a hydrogen atom or an optionally substituted monovalent organic group having 1 to 10 carbon atoms, and R^{a}, p, q₁, q₂, and * are as defined in the above general formula (II-1).

Since such a composition for forming a metal oxide film has the constituent unit represented by the above general formula (II-2) having excellent thermal flowability, in addition to the constituent unit represented by the above general formula (II-1) having excellent reactivity with the metal source (I), the filling and planarizing properties with respect to a pattern substrate can be further improved.

When the proportion of the constituent unit represented by the above general formula (II-1) is "a" and the proportion of the constituent unit represented by the above general formula (II-2) is "b", the organic source (II) as a whole preferably satisfies the relationships: a+b=1 and 0.2≤b≤0.8.

When the contents of the above general formula (II-1) and the above general formula (II-2) are within the above ranges, various physical properties required when used to form a metal oxide film, such as filling and planarizing properties, dry etching resistance, substrate adhesiveness, and the like, can be adjusted within an appropriate range. To improve the dry etching resistance, a higher content of the above general formula (II-1) is preferable because the metal content in the organic-inorganic composite material needs to be increased. To improve the filling and planarizing properties, a higher content of the above general formula (II-2) with excellent thermal flowability is preferable.

In the general formula (II-2) above, X₂ is preferably a compound represented by the following general formula (X-1), 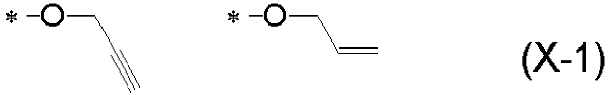 wherein * represents a bonding site.

Since the general formula (II-2) has the constituent represented by (X-1) above, it is possible to obtain an organic-inorganic composite material having excellent thermal flowability and heat resistance, thereby further improving the filling and planarizing properties of the composition for forming a metal oxide film.

In the present invention, the above organic source (II) preferably comprises the compounds represented by the following general formulae (1) to (3), 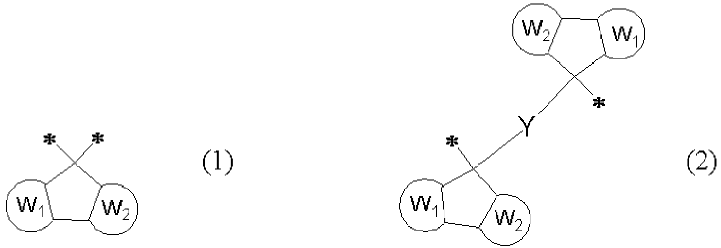 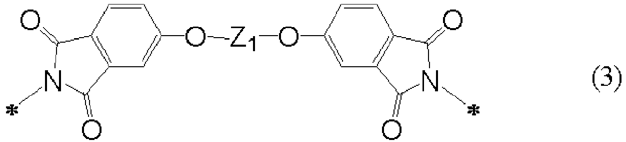 wherein W₁ and W₂ each independently represent a benzene ring or a naphthalene ring, and hydrogen atoms in the benzene ring and the naphthalene ring are optionally substituted with a hydrocarbon group having 1 to 6 carbon atoms; Y is a group represented by the following general formula (4); Z₁ is a group represented by the following general formula (5); * is a site bonded with the constituent unit represented by the above general formula (II-1), 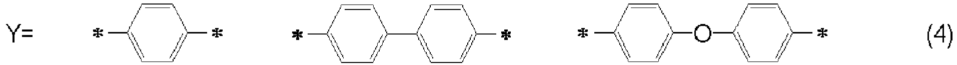 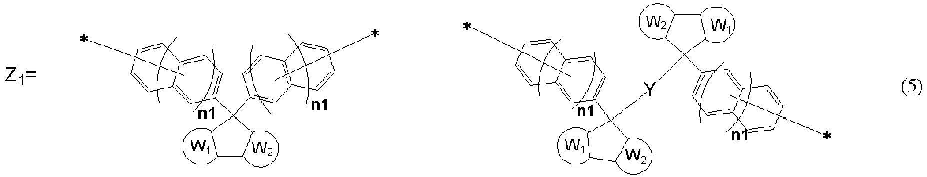 where W₁, W₂, and Y are as defined above, and n₁ is 0 or 1. In the above general formulae (4) and (5), * represents a bonding site.

When the organic source (II) is a compound from those represented by the above general formulae (1) to (3), an organic-inorganic composite material with excellent heat resistance can be obtained. Further, because of its excellent thermal flowability compared with a high molecular weight compound, a composition for forming a metal oxide film with excellent filling and planarizing properties with respect to a pattern substrate can be provided.

The ratio Mw/Mn (dispersity) in the compound contained in the organic source (II) is preferably in the range of 1.00≤Mw/Mn≤1.25, the Mw/Mn being a ratio of the weight average molecular weight Mw to the number average molecular weight Mn on polystyrene basis according to gel permeation chromatography.

With the compound having such a range of dispersity, the organic-inorganic composite material exhibits more excellent thermal flowability. Thus, when it is added to the composition for forming a metal oxide film, it is possible to not only desirably fill a fine structure formed on the substrate but also form a metal oxide film with the entire substrate planarized.

In the present invention, M in the above general formula (I-1) preferably comprises a metal selected from the group consisting of Zr, Ta, Hf, Ti, Sn, Nb, Mo, Ge, and W.

By using the metal source (I) having such M, it is possible to prepare a composition for forming a metal oxide film with excellent dry etching resistance.

In the present invention, the composition may further comprise (C) a flowability accelerator having a weight reduction rate in a range from 30°C to 190°C of less than 30% and a weight reduction rate in a range from 30°C to 350°C of 98% or more.

The above component (C) is characterized by having a weight reduction rate in a range from 30°C to 190°C of less than 30% and a weight reduction rate in a range from 30°C to 350°C of 98% or more. This contributes to improvement in the flowability of the composition during the coating, while the component (C) is excluded from the film after baking at 350°C, thus improving the filling and planarizing properties without degrading the dry etching resistance. In addition, it is also possible to suppress the occurrence of defects caused by drying, thereby contributing to improvement in yield in the semiconductor manufacturing.

In this case, (C) the flowability accelerator preferably comprises one or more compounds selected from the following general formulae (i) to (iii), 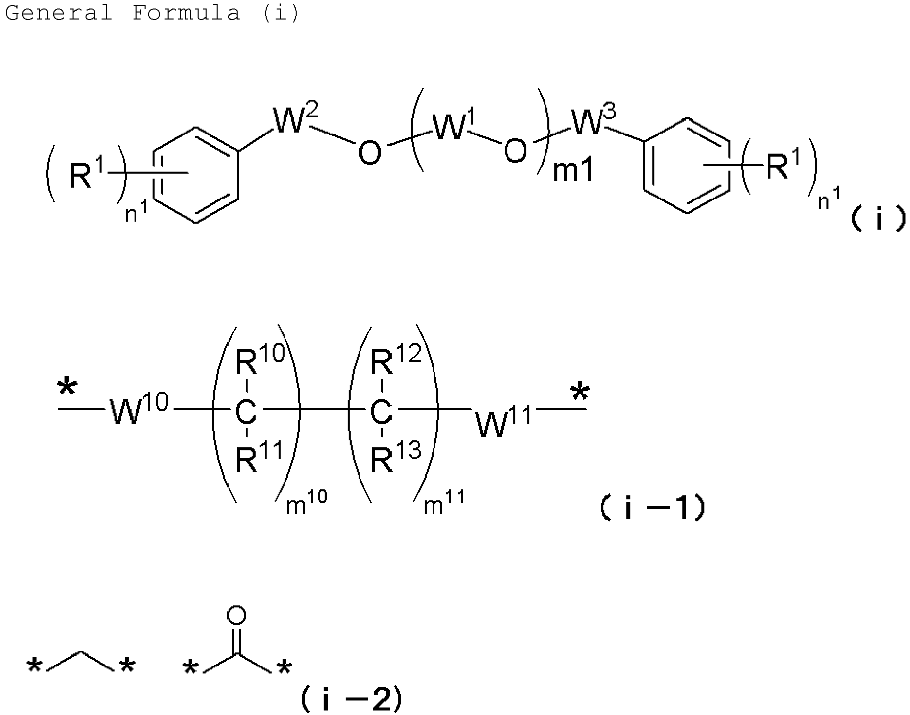 wherein R¹ independently represents a hydrogen atom, a hydroxyl group, or an optionally substituted organic group having 1 to 10 carbon atoms; W¹ is a phenylene group or a divalent group represented by the general formula (i-1); each of W² and W³ is a single bond or any of the divalent groups represented by the general formula (i-2); m¹ is an integer of 1 to 10; n¹ is an integer of 0 to 5; * represents a bonding site; and each of R¹⁰, R¹¹, R¹², and R¹³ represents a hydrogen atom, a hydroxyl group, or an organic group having 1 to 10 carbon atoms; W¹⁰ and W¹¹ independently represents a single bond or a carbonyl group; and each of m¹⁰ and m¹¹ is an integer of 0 to 10, and m¹⁰+m¹¹≥1, 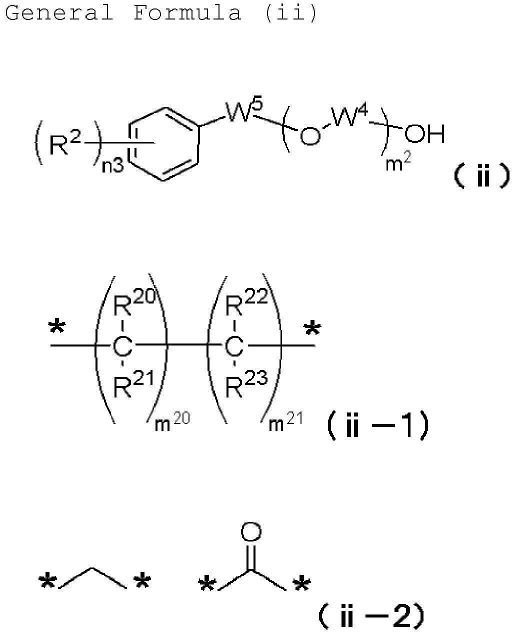 wherein R² independently represents a hydrogen atom, a hydroxyl group, or an optionally substituted organic group having 1 to 10 carbon atoms; W⁴ is a divalent group represented by the general formula (ii-1); W⁵ is a single bond or any of the divalent groups represented by the general formula (ii-2); m² is an integer of 2 to 10; n³ is an integer of 0 to 5; * represents a bonding site; and each of R²⁰, R²¹, R²², and R²³ represents a hydrogen atom, a hydroxyl group, or an organic group having 1 to 10 carbon atoms; and each of m²⁰ and m²¹ is an integer of 0 to 10, and m²⁰+m²¹≥1, and 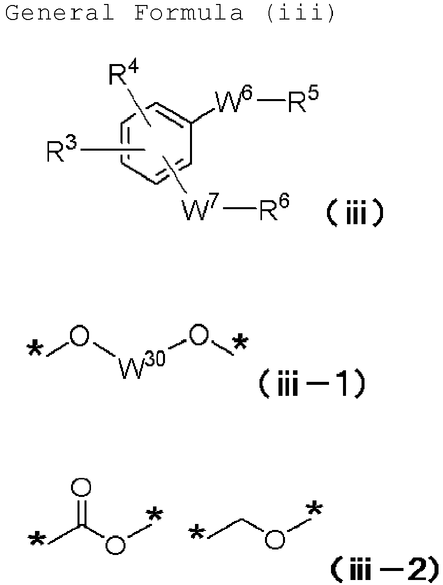 wherein each of R³ and R⁴ represents a hydrogen atom, a hydroxyl group, or an optionally substituted organic group having 1 to 10 carbon atoms, and R³ and R⁴ may be bonded to each other to form a cyclic structure; each of R⁵ and R⁶ is an organic group having 1 to 10 carbon atoms, and R⁵ is a group containing either an aromatic ring or a divalent group represented by the general formula (iii-1); each of W⁶ and W⁷ is a single bond or any of the divalent groups represented by the general formula (iii-2), and at least one of W⁶ and W⁷ is one of the divalent groups represented by the general formula (iii-2); W³⁰ is an organic group having 1 to 4 carbon atoms; and * represents a bonding site.

By using the above compound having an aromatic ring serving as the hydrophobic part and the following (C-1) structure serving as the hydrophilic part, it is possible to improve the flowability of the composition for forming a metal oxide film without decreasing the stability of the organic-inorganic composite material in the composition, 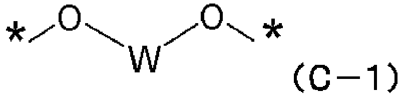 wherein * represents a bonding site; and W is an organic group having 1 to 4 carbon atoms.

In the present invention, the composition for forming a metal oxide film may further comprise (D) a metal oxide nanoparticle having an average primary particle size of 100 nm or less.

(D) The metal oxide nanoparticle is preferably one or more selected from the group consisting of zirconium oxide nanoparticles, hafnium oxide nanoparticles, titanium oxide nanoparticles, tin oxide nanoparticles, and tungsten oxide nanoparticles.

By using such a metal oxide nanoparticle, the metal content in the composition can be easily increased, and the dry etching resistance of the composition for forming a metal oxide film can be further improved.

In the present invention, the composition preferably further contains one or more of a crosslinking agent, a surfactant, an acid generator, and a plasticizer.

The composition for forming a metal oxide film containing these additives is more excellent in coatability, dry etching resistance, and filling and planarizing properties.

Further, the present invention provides a patterning process for forming a pattern in a substrate to be processed, the process comprising the steps of:
(I-1) applying the composition for forming a metal oxide film onto a substrate to be processed, followed by heating to form a metal oxide film;
(I-2) forming a resist upper layer film on the metal oxide film by using a photoresist material;
(I-3) subjecting the resist upper layer film to pattern exposure and then development with a developer to form a pattern in the resist upper layer film;
(I-4) transferring the pattern to the metal oxide film by dry etching while using the resist upper layer film having the formed pattern as a mask; and
(I-5) processing the substrate to be processed while using the metal oxide film having the formed pattern as a mask to form the pattern in the substrate to be processed.

The patterning process by way of the above two-layer resist process makes it possible to form fine patterns on the body to be processed (substrate to be processed).

Further, the present invention provides a patterning process for forming a pattern in a substrate to be processed, the process comprising the steps of:
(II-1) applying the composition for forming a metal oxide film onto a substrate to be processed, followed by heating to form a metal oxide film;
(II-2) forming a resist middle layer film on the metal oxide film;
(II-3) forming a resist upper layer film on the resist middle layer film by using a photoresist material;
(II-4) subjecting the resist upper layer film to pattern exposure and then development with a developer to form a pattern in the resist upper layer film;
(II-5) transferring the pattern to the resist middle layer film by dry etching while using the resist upper layer film having the formed pattern as a mask;
(II-6) transferring the pattern to the metal oxide film by dry etching while using the resist middle layer film having the transferred pattern as a mask; and
(II-7) processing the substrate to be processed while using the metal oxide film having the formed pattern as a mask to form the pattern in the substrate to be processed.

The patterning process by way of the above three-layer resist process makes it possible to form fine patterns on the substrate to be processed with a high degree of accuracy.

Further, the present invention provides a patterning process for forming a pattern in a substrate to be processed, the process comprising the steps of:
(III-1) applying the composition for forming a metal oxide film onto a substrate to be processed, followed by heating to form a metal oxide film;
(III-2) forming an inorganic hard mask middle layer film selected from a silicon oxide film, a silicon nitride film, and a silicon oxynitride film on the metal oxide film;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the metal oxide film by dry etching while using the inorganic hard mask middle layer film having the transferred pattern as a mask; and
(III-8) processing the substrate to be processed while using the metal oxide film having the formed pattern as a mask to form the pattern in the substrate to be processed.

The patterning process by way of the above four-layer resist process makes it possible to form fine patterns on the substrate to be processed with a high degree of accuracy.

Further, the present invention provides a patterning process for forming a pattern in a substrate to be processed, the process comprising the steps of:
(IV-1) forming a resist underlayer film on a substrate to be processed;
(IV-2) forming a resist middle layer film, or a combination of an inorganic hard mask middle layer film selected from a silicon oxide film, a silicon nitride film, and a silicon oxynitride film and an organic thin film on the resist underlayer film;
(IV-3) forming a resist upper layer film on the resist middle layer film, or the combination of the inorganic hard mask middle layer film and the organic thin film by using a photoresist material;
(IV-4) subjecting the resist upper layer film to pattern exposure and then development with a developer to form a pattern in the resist upper layer film;
(IV-5) transferring a pattern to the resist middle layer film or the organic thin film and the inorganic hard mask middle layer film by dry etching while using the resist upper layer film having the formed pattern as a mask;
(IV-6) transferring a pattern to the resist underlayer film by dry etching while using the resist middle layer film or the inorganic hard mask middle layer film having the transferred pattern as a mask;
(IV-7) applying the composition for forming a metal oxide film onto the resist underlayer film having the formed pattern, followed by heating to cover the resist underlayer film with a metal oxide film, thereby filling a space between the resist underlayer film patterns with the metal oxide film;
(IV-8) etching back the metal oxide film covering the resist underlayer film having the formed pattern by a chemical stripper or dry etching to uncover an upper surface of the resist underlayer film having the formed pattern;
(IV-9) removing the resist middle layer film or the hard mask middle layer film remaining on the upper surface of the resist underlayer film by dry etching;
(IV-10) removing the resist underlayer film having the formed pattern with its surface uncovered by dry etching to form a reverse pattern of an original pattern in the metal oxide film;
(IV-11) processing the substrate to be processed while using the metal oxide film having the formed reversal pattern as a mask to form a reversal pattern in the substrate to be processed.

The patterning process by way of the above reverse process makes it possible to form fine patterns on the substrate to be processed with a further higher degree of accuracy.

A substrate having a step or a structure with a height of 30 nm or more may be used as the substrate to be processed.

In the present invention, for example, the above-mentioned substrates can be used as the substrate to be processed.

The present invention also provides a method for forming a metal oxide film to act as a planarizing film used in a semiconductor device production process, the method comprising applying the composition for forming a metal oxide film described above onto a substrate to be processed, followed by heating at a temperature of 100°C or more and 600°C or less for 10 to 600 seconds to form a cured film.

The present invention also provides a method for forming a metal oxide film to act as a planarizing film used in a semiconductor device production process, the method comprising applying the composition for forming a metal oxide film described above onto a substrate to be processed, followed by heating under an atmosphere having an oxygen concentration of 0.1 volume % or more and 21 volume % or less to form a cured film.

Such a method accelerates the crosslinking reaction of the composition for forming a metal oxide film when the metal oxide film is formed, thus highly suppressing mixing with the upper layer film. Moreover, appropriate adjustment of the heating temperature, the time, and the oxygen concentration within the above ranges allows the metal oxide film to have filling and planarizing properties and curing properties suitable for use.

The present invention also provides a method for forming a metal oxide film to act as a planarizing film used in a semiconductor device production process, the method comprising applying the composition for forming a metal oxide film described above onto a substrate to be processed, followed by heating under an atmosphere having an oxygen concentration of less than 0.1 volume % to form a cured film.

Such a method accelerates the crosslinking reaction of the composition for forming a metal oxide film when the metal oxide film is formed without causing deterioration of a substrate to be processed even when the substrate to be processed contains a material unstable to heating in an oxygen atmosphere, further highly and effectively suppressing mixing with the upper layer film, and thus is useful.

### ADVANTAGEOUS EFFECTS OF INVENTION

As explained above, the composition for forming a metal oxide film, the patterning process, and the method for forming a metal oxide film of the present invention are suitably used particularly in a multilayer resist process, including filling and planarization of a substrate to be processed having steps, level differences, and are significantly useful in fine patterning for the manufacture of semiconductor devices. Specifically, since the composition for forming a metal oxide film contains a reaction product of a metal compound and a specific compound, it is possible to suppress coating failure due to incompatibility between the metal source and the organic source and suppress void generation defects in the filling film caused by volume shrinkage of the metal compound during the heating, thus exhibiting excellent coatability and filling and planarizing properties compared with the previously-known composition for forming a metal oxide film obtained by mixing a metal compound and a resin. In particular, in a fine patterning process using a multilayer resist method in a semiconductor device production process, even on a substrate to be processed having a portion where filling and planarization are difficult, such as portion with a dense fine pattern structure portion with a high aspect ratio typified by a DRAM memory under prosperous miniaturization, filling can be performed without causing defects such as voids and peeling; further, owing to remarkably high dry etching resistance relative to previously-known coating-type organic underlayer film materials, a fine pattern can be formed on a substrate to be processed with a higher degree of accuracy.

### BRIEF DESCRIPTION OF DRAWINGS

FIG. 1 is an explanatory view of an example (three-layer resist process) of the patterning process of the present invention.
FIG. 2 is an explanatory view of an example (forming reverse SOC pattern in a three-layer resist process) of the patterning process (tone-reversal patterning process) of the present invention.
FIG. 3 is an explanatory view of a method for evaluating filling property.

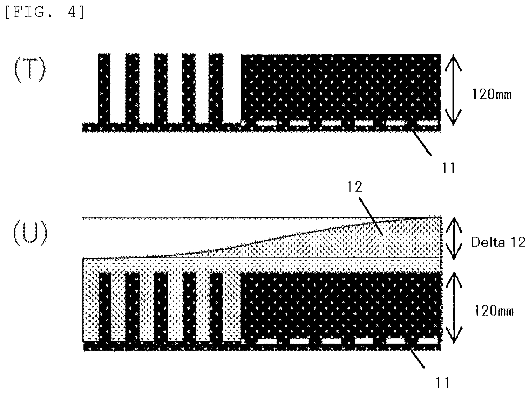

FIG. 4 is an explanatory view of a method for evaluating planarizing property.

### DESCRIPTION OF EMBODIMENTS

As described above, a fine patterning process using a multilayer resist method in a semiconductor device production process has demanded an underlayer film material that enables filling/planarization without causing defects such as voids and peeling even on a substrate to be processed having a portion where filling and planarization are difficult, such as portion with a dense fine pattern structure portion with a high aspect ratio typified by a DRAM memory under prosperous miniaturization, that has excellent dry etching resistance relative to previously-known coating-type organic underlayer film materials, and that is capable of transferring a resist pattern onto a substrate to be processed with a higher degree of accuracy.

In this regard, it is assumed that, since Non-Patent Document 1 produces a condensate of a metal compound and an organic substance, there is no concern about poor compatibility unlike a mixture of a metal compound and an organic component, thereby capable of forming a film with excellent coatability. Further, since the metal compound is condensed with an organic component, there is no ligand elimination from the metal compound during the baking, and the influence of volume shrinkage is small; therefore, film formation with excellent filling property with respect to stepped substrates can be expected. However, since this study was made in a view different from those in the semiconductor field, the coatability and filling property were uncertain and they need to be improved.

As a possible solution of this problem, compositions for forming a metal oxide film are attracting attention. However, in the previously-known compositions obtained by mixing a metal compound and an organic polymer, if the compatibility between the metal compound and the organic polymer is insufficient, aggregation of each component is likely to occur during the coating, which may result in poor film forming. Further, because of the large volume shrinkage of the metal compound associated with ligand elimination during heating, voids may be formed if the stepped substrate is heated at a high temperature after being filled. In view of the above, an alternative method that can be used instead of those using mixed compositions of metal compound and organic material has been in demand.

The present inventors have conducted extensive study to solve the above problems, and have investigated various metal oxide film materials and patterning processes so as to develop a composition for forming a metal oxide film with excellent coatability that can achieve both high-level filling and planarization by the formation of an underlayer film and excellent dry etching resistance in a multilayer resist method using an underlayer film. As a result, the inventors found that a patterning process using a composition for forming a metal oxide film comprising an organic-inorganic composite material, which is a reaction product of a metal source (I) having excellent dry etching resistance and an organic source (II) having a constituent unit represented by the above general formula (II-1) and a cardo structure with excellent reactivity, is very effective, and completed the present invention.

Specifically, the present invention is a composition for forming a metal oxide film, comprising (A) an organic-inorganic composite material and (B) a solvent, wherein (A) the organic-inorganic composite material is a reaction product of a metal source (I) and an organic source (II), the metal source (I) comprises one or more compounds selected from a metal compound represented by the following general formula (I-1), a hydrolysate of the metal compound represented by the general formula (I-1), and a hydrolysis condensate of the metal compound represented by the general formula (I-1), and the organic source (II) comprises a compound having a constituent unit represented by the following general formula (II-1) and a cardo structure, 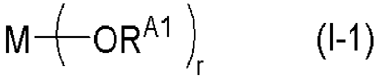 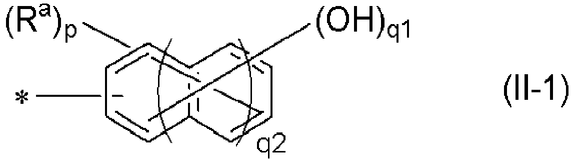 wherein M is a metal; and each R^{A1} may be identical to or different from one another, and represents a monovalent organic group having 1 to 30 carbon atoms with 0 or 1 hydroxy group, adjacent R^{A1} may be bonded to each other to form a spiro ring, and to form a ring together with O and M to which these R^{A1} are bonded; and r is an integer of 3 to 6; R^{a} is an optionally substituted saturated monovalent organic group having 1 to 10 carbon atoms or an optionally substituted unsaturated monovalent organic group having 2 to 10 carbon atoms; "p" is an integer of 0 to 5; q₁ is an integer of 1 to 6; p+q₁ is an integer of 1 or more and 6 or less; q₂ is 0 or 1; and * represents a bonding site.

The present invention is described below in detail; however, the present invention is not limited to the examples described below.

### Composition for Forming a Metal Oxide Film

The composition for forming a metal oxide film of the present invention may be any composition as long as it comprises, a component (A) that is an organic-inorganic composite material, which is a reaction product of a metal source (I) containing one or more selected from a metal compound represented by the following general formula (I-1), a hydrolysate of the metal compound represented by the general formula (I-1), and a hydrolysis condensate of the metal compound represented by the general formula (I-1), and an organic source (II) containing a compound having a constituent unit represented by the following general formula (II-1) and a cardo structure; and (B) a solvent. The composition for forming a metal oxide film may include additives, such as a surfactant, a crosslinking agent, and the like, as required. Hereinbelow, each component of the composition of the present invention is described.

### Metal Source (I)

The composition for forming a metal oxide film of the present invention is a composition comprising an organic-inorganic composite material, which is a reaction product of the metal source (I) and the organic source (II); and (B) a solvent. The metal source (I) contains one or more selected from the metal compound represented by the formula (I-1), a hydrolysate of the metal compound represented by the formula (I-1), and a hydrolysis condensate of the metal compound represented by the formula (I-1), 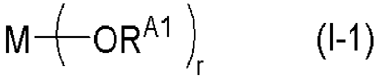 wherein M is a metal; and each R^{A1} may be identical to or different from one another, and represents a monovalent organic group having 1 to 30 carbon atoms with 0 or 1 hydroxy group; adjacent R^{A1} may be bonded to each other to form a spiro ring, and to form a ring together with O and M to which these R^{A1} are bonded; and r is an integer of 3 to 6.

The monovalent organic group may be any of linear, branched, or cyclic monovalent organic groups, and specific examples thereof include monovalent saturated hydrocarbon groups, such as a methyl group, ethyl group, n-propyl group, isopropyl group, cyclopropyl group, n-butyl group, isobutyl group, sec-butyl group, tert-butyl group, cyclobutyl group, n-pentyl group, isopentyl group, sec-pentyl group, tert-pentyl group, neopentyl group, cyclopentyl group, n-hexyl group, cyclohexyl group, n-heptyl group, cycloheptyl group, n-octyl group, cyclooctyl group, n-nonyl group, cyclononyl group, n-decyl group, cyclodecyl group, adamantyl group, and norbornyl group; monovalent unsaturated hydrocarbon groups, such as a cyclohexenyl group, cyclohexenylmethyl group, cyclohexenylethyl group, cycloheptenyl group, and cyclopentadienyl group; aryl groups, such as a phenyl group, tolyl group, xylyl group, methoxyphenyl group, and naphthyl group; aralkyl groups, such as a benzyl group, phenethyl group, and methoxybenzyl group; monovalent heterocyclic ring-containing groups, such as a tetrahydrofurfuryl group; and the like.

The organic group may have one hydroxy group. Such an organic group with a hydroxy group is particularly preferably one having a tertiary alcohol structure.

M in the above formula (I-1) is not particularly limited insofar as it is a trivalent to hexavalent metal capable of forming a metal oxide film, and examples thereof include metals selected from Group 3 to Group 14 elements of the periodic table, more specifically, metals selected from Group 4, Group 5, Group 6, and Group 14 elements of the periodic table. Among these, M in the above formula (I-1) preferably contains a metal selected from the group consisting of Zr, Ta, Hf, Ti, Sn, Nb, Mo, Ge, and W, and is preferably Zr, Hf, Ti, Sn, and W, particularly preferably Zr, Hf, and Ti.

By using such a metal source (I), it is possible to prepare a composition for forming a metal oxide film with excellent dry etching resistance.

When M is Zr, examples of the metal compound represented by the formula (I-1) include dibutoxybis(ethylacetoacetate) zirconium (IV), di-n-butoxybis(2,4-pentanedionate) zirconium(IV), tetra-n-butoxyzirconium(IV), tetra-n-propoxyzirconium(IV), tetraisopropoxyzirconium(IV), aminopropyltriethoxyzirconium(IV), 2-(3,4-epoxycyclohexyl) ethyltrimethoxyzirconium(IV), γ-glycidoxypropyltrimethoxyzirconium (IV), 3-isocyanopropyltrimethoxyzirconium(IV), triethoxymono(2,4-pentanedionate) zirconium(IV), tri-n-propoxymono(2,4-pentanedionate) zirconium(IV), triisopropoxymono(2,4-pentanedionate) zirconium(IV), tri(3-methacryloxypropyl) methoxyzirconium(IV), tri(3-acryloxypropyl) methoxyzirconium(IV), and the like.

When M is Ta, examples of the metal compound represented by the formula (I-1) include tetrabutoxytantalum(IV), pentabutoxytantalum(V), pentaethoxytantalum(V), and the like.

When M is Hf, examples of the metal compound represented by the formula (I-1) include hafnium methoxide, hafnium ethoxide, hafnium propoxide, hafnium butoxide, hafnium pentoxide, hafnium hexyloxide, hafnium cyclopentoxide, hafnium cyclohexyloxide, hafnium allyloxide, hafnium phenoxide, hafnium methoxyethoxide, hafnium ethoxyethoxide, hafnium dipropoxy bisethylacetoacetate, hafnium dibutoxy bisethylacetoacetate, hafnium dipropoxy bis-2,4-pentanedionate, hafnium dibutoxy bis-2,4-pentanedionate, and the like.

When M is Ti, examples of the metal compound represented by the formula (I-1) include titanium methoxide, titanium ethoxide, titanium propoxide, titanium isopropoxide, titanium butoxide, titanium pentoxide, titanium hexyloxide, titanium cyclopentoxide, titanium cyclohexyloxide, titanium allyloxide, titanium phenoxide, titanium methoxyethoxide, titanium ethoxyethoxide, titanium 2-ethyl-1,3-hexanediolate, titanium 2-ethylhexoxide, titanium tetrahydrofurfuryloxide, titanium bis(triethanolaminate) diisopropoxide, titanium dipropoxy bisethyl acetoacetate, titanium dibutoxy bisethyl acetoacetate, titanium dipropoxy bis-2,4-pentanedionate, titanium dibutoxy bis-2,4-pentanedionate, and the like.

When M is Sn, examples of the metal compound represented by the formula (I-1) include tin tetraalkoxides, such as tetramethyltin alkoxides (Sn(OCH₃)₄), tetraethyltin alkoxides, tetraisopropyltin alkoxides, tetrapropyltin alkoxides, tetraisobutyltin alkoxides, tetrabutyltin alkoxides, tetrapentyltin alkoxides, tetrahexytin alkoxides, tetraheptyltin alkoxides, tetraoctyltin alkoxides, tetranonyltin alkoxides, and tetradecyltin alkoxides.

When M is Nb, examples of the metal compound represented by the formula (I-1) include pentaalkoxides of niobium such as pentamethylniobiumalkoxide (Nb (OCH₃)₅), pentaethylniobiumalkoxide, pentaisopropylniobiumalkoxide, pentapropylniobiumalkoxide, pentaisobutylniobiumalkoxide, pentabutylniobiumalkoxide, pentapentylniobiumalkoxide, pentahexylniobiumalkoxide, pentaheptylniobiumalkoxide, pentaoctylniobiumalkoxide, pentanonylniobiumalkoxide, pentadecylniobiumalkoxide, and the like.

When M is Mo, examples of the metal compound represented by the formula (I-1) include pentaethoxymolybdenum(V), pentaisopropoxymolybdenum(V), molybdenum(VI) hexaethoxide, and the like.

When M is Ge, examples of the metal compound represented by the formula (I-1) include germanium methoxide, germanium ethoxide, germanium propoxide, germanium butoxide, germanium amyloxide, germanium hexyloxide, germanium cyclopentoxide, germanium cyclohexyloxide, germanium allyloxide, germanium phenoxide, germanium methoxyethoxide, germanium ethoxyethoxide, and the like.

When M is W, examples of the metal compound represented by the formula (I-1) include tetrabutoxytungsten(IV), pentabutoxytungsten(V), pentamethoxytungsten (V), hexabutoxytungsten(VI), hexaethoxytungsten(VI), dichlorobis(cyclopentadienyl)tungsten(IV), and the like.

### Organic Source (II)

The composition for forming a metal oxide film of the present invention is a composition comprising an organic-inorganic composite material, which is a reaction product of the metal source (I) and the organic source (II); and (B) a solvent. The organic source (II) contains a compound having a constituent unit represented by the following formula (II-1) and a cardo structure, 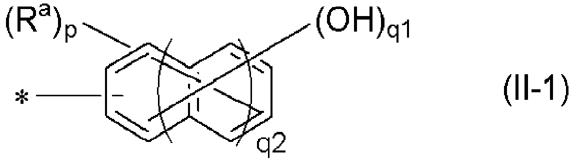 wherein R^{a} is an optionally substituted saturated monovalent organic group having 1 to 10 carbon atoms or an optionally substituted unsaturated monovalent organic group having 2 to 10 carbon atoms; "p" is an integer of 0 to 5; q₁ is an integer of 1 to 6; p+q₁ is an integer of 1 or more and 6 or less; q₂ is 0 or 1; and * represents a bonding site.

The constituent unit represented by the above general formula (II-1) of the organic source (II) enables a desirable reaction with the metal source (I), thus providing a material as a high-dimensional composite of an organic source and a metal source. Further, by having the aromatic ring, an organic-inorganic composite material with excellent heat resistance and dry etching resistance can be obtained.

In the above general formula (II-1), R^{a} is a saturated monovalent organic group having 1 to 10 carbon atoms or an unsaturated monovalent organic group having 2 to 10 carbon atoms, and examples include monovalent saturated hydrocarbon groups, such as a methyl group, ethyl group, n-propyl group, i-propyl group, n-butyl group, i-butyl group, sec-butyl group, tert-butyl group, n-pentyl group, iso-pentyl group, sec-pentyl group, and tert-pentyl group; monovalent unsaturated acyclic hydrocarbon groups, such as an ethenyl group, propenyl group, butenyl group, pentenyl group, ethynyl group, and propynyl group; monocyclic saturated cyclic hydrocarbon groups, such as a cyclobutyl group, cyclopentyl group, cyclohexyl group, cycloheptyl group, and cyclooctyl group; monovalent monocyclic unsaturated cyclic hydrocarbon groups, such as a cyclobutenyl group, cyclopentenyl group, and cyclohexenyl group; monovalent polycyclic cyclic hydrocarbon groups, such as a norbornyl group, adamantyl group; monovalent aromatic hydrocarbon groups, such as a phenyl group, methylphenyl group, naphthyl group, methylnaphthyl group, anthryl group, and methylanthryl group; and the like.

Some or all of the hydrogen atoms in the above saturated hydrocarbon groups, unsaturated acyclic hydrocarbon groups, monocyclic saturated cyclic hydrocarbon groups, monocyclic unsaturated cyclic hydrocarbon groups, polycyclic cyclic hydrocarbon groups, aromatic hydrocarbon groups, alkoxy groups, alkoxycarbonyl groups and the like may be substituted. Examples of the substituent include halogen atoms, such as a fluorine atom, chlorine atom, bromine atom, iodine atom, and the like; a hydroxyl group, cyano group, carboxy group, nitro group, amino group, alkoxy group, alkoxycarbonyl group, acyl group, alkoxycarbonyloxy group, aryl group; aliphatic heterocyclic groups, such as lactone group, and the like; aromatic heterocyclic groups, such as a furyl group, and pyridyl group; and the like.

In the above general formula (II-1), p is preferably 0 or 1, and q₁ is preferably 1 or 2.

In the present invention, the above organic source (II) needs to be a compound containing a cardo structure.

Since the above organic source (II) contains a cardo structure, it is possible to improve dry etching resistance and heat resistance of the composition for forming a metal oxide film. Further, by the action of the cardo structure introduced into the molecule, the interaction between the molecules is alleviated and the solubility in an organic solvent is imparted; therefore, the compatibility of the organic-inorganic composite material is improved and the film forming property at the time of forming a coating film is improved. In addition, despite the introduction of a plurality of condensed carbon rings having a high carbon density, it is possible to achieve both heat resistance and filling and planarizing properties, which are contradictory to each other.

The organic source (II) preferably has a constituent unit represented by the formula (II-2), in addition to the structure unit represented by the formula (II-1). 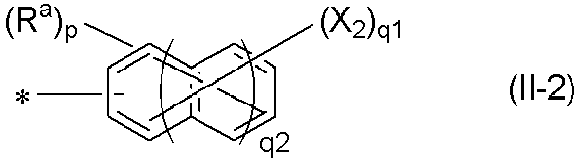 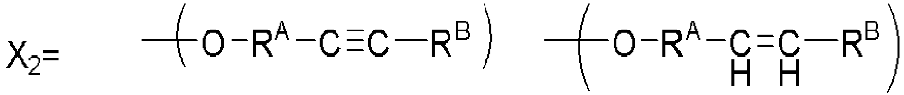 In the above general formula (II-2), R^{A} is an optionally substituted divalent organic group having 1 to 10 carbon atoms, R^{B} is a hydrogen atom or an optionally substituted monovalent organic group having 1 to 10 carbon atoms, and R^{a}, p, q₁, q₂, and * are as defined in the above general formula (II-1).

By having the constituent unit represented by the above general formula (II-2), it is possible to further improve the thermal flowability of the organic-inorganic composite material and provide a composition for forming a metal oxide film having excellent filling and planarizing properties.

In the above general formula (II-2), examples of the divalent organic group having 1 to 10 carbon atoms represented by R^{A} include alkanediyl groups, such as a methylene group, ethanediyl group, propanediyl group, butanediyl group, pentanediyl group, hexanediyl group, octanediyl group, and decanediyl groups; arenediyl groups, such as a benzenediyl group, methylbenzenediyl group, and naphthalenediyl group; and the like.

In the above general formula (II-2), examples of the monovalent organic group having 1 to 10 carbon atoms represented by R^{B} include alkyl groups, such as a methyl group, ethyl group, n-propyl group, i-propyl group, n-butyl group, i-butyl group, sec-butyl group, t-butyl group, n-pentyl group, n-hexyl group, n-octyl group, and n-decyl group; aryl groups, such as a phenyl group, tolyl group, xylyl group, mesityl group, and naphthyl group; and the like.

Some or all of the hydrogen atoms of the alkanediyl group, the arenediyl group, the alkyl group, the aryl group, and the like, may be substituted, and examples of the substituent include the same groups as those in the examples of the substituent that may be present in the organic group represented by R^{a}, and the like.

When the proportion of the above general formula (II-1) is "a" and the proportion of the above general formula (II-2) is "b", the organic source (II) as a whole preferably satisfies the relationships: a+b=1 and 0.2≤b≤0.8, more preferably 0.3≤b≤0.7. With the range thus specified above, the hydroxyl group in the formula (II-1) desirably reacts with the metal compound, thus inhibiting residual active metal monomers and oligomers. Further, the action of X₂ in the constituent unit represented by the formula (II-2) inhibits aggregation of reaction products due to steric repulsion, thereby increasing the stability.

When the contents of the above general formula (II-1) and the above general formula (II-2) are within the above ranges, various physical properties required when used to form a metal oxide film, such as filling and planarizing properties, dry etching resistance, substrate adhesiveness, and the like, can be adjusted within an appropriate range. To improve the dry etching resistance, a higher content of the above general formula (II-1) is preferable because the metal content in the organic-inorganic composite material needs to be increased. To improve the filling and planarizing properties, a higher content of the above general formula (II-2) with excellent thermal flowability is preferable.

In the above general formula (II-2), the constituent of X₂ is preferably that represented by the following general formula (X-1), 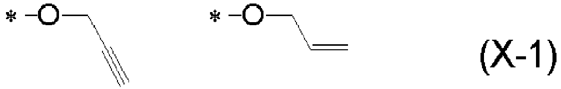 wherein * represents a bonding site.

Since the above general formula (II-2) has the constituent represented by (X-1) above, it is possible to obtain an organic-inorganic composite material having excellent thermal flowability and heat resistance, thereby further improving the filling and planarizing properties of the composition for forming a metal oxide film.

In the present invention, only one kind of the organic source (II) in which the proportions of the above general formulae (II-1) and (II-2) are controlled within the above-described range may be used, or two or more kinds thereof may be mixed at a desired mixing ratio to obtain an equivalent composition.

The above organic source (II) preferably comprises the compounds represented by the following general formulae (1) to (3); 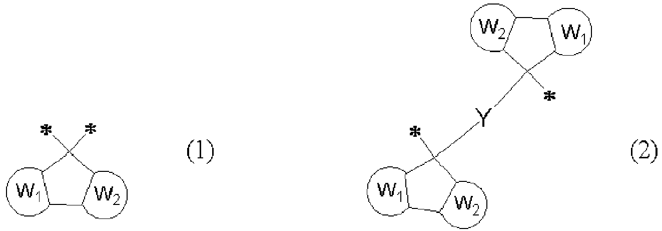 in the above general formulae (1) and (2), W₁ and W₂ each independently represent a benzene ring or a naphthalene ring, and the hydrogen atoms in the benzene ring and the naphthalene ring are optionally substituted with a hydrocarbon group having 1 to 6 carbon atoms; * is a bonding site with respect to the constituent unit represented by the above general formula (II-1) and the constituent unit represented by the above general formula (II-2); and Y is a group represented by the following general formula (4). 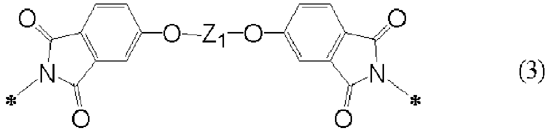 In the above general formula (3), Z₁ is a group represented by the following general formula (5) and * is a bonding site with respect to the constituent unit represented by the above general formula (II-1) and the constituent unit represented by the above general formula (II-2), 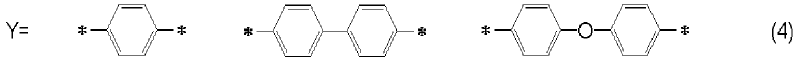 wherein * represents a bond, 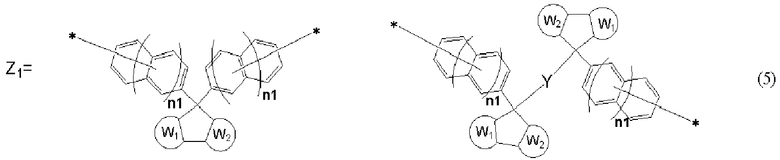 where W₁, W₂, and Y are as defined above, and n₁ is 0 or 1.

When the organic source (II) is a compound from those represented by the above general formulae (1) to (3), an organic-inorganic composite material with excellent heat resistance can be obtained. Further, because of its excellent thermal flowability compared with a high molecular weight compound, a composition for forming a metal oxide film with excellent filling and planarizing properties with respect to a pattern substrate can be provided.

In the above general formulae (1) and (2), W₁ and W₂ each independently represent a benzene ring or a naphthalene ring, and the hydrogen atoms in the benzene ring and the naphthalene ring are optionally substituted with a hydrocarbon group having 1 to 6 carbon atoms. From the viewpoint of flowability, W₁ and W₂ are preferably benzene rings.

In the above general formula (3), Z₁ is a group represented by the above general formula (5).

Since the compound having such a structure exhibits desirable reactivity with the metal source (I), an organic-inorganic composite material with high metal content can be obtained, thereby forming a metal oxide film with excellent dry etching resistance. Further, the presence of a rigid structure containing many aromatic rings makes it possible to provide a composition for forming a metal oxide film having further desirable heat resistance property and etching resistance. Furthermore, since the intermolecular interaction is alleviated by the action of the cardo structure introduced into the molecule, the organic-inorganic composite material obtained by the reaction with the metal source (I) has excellent solubility in organic solvents, thereby forming a metal oxide film with excellent film forming property. In addition, despite the introduction of a plurality of condensed carbon rings having a high carbon density, it is possible to achieve both heat resistance and filling and planarizing properties, which are contradictory to each other.

Specific examples of the compounds represented by the above general formulae (1), (2), and (3) include, but are not limited to, the following compounds.

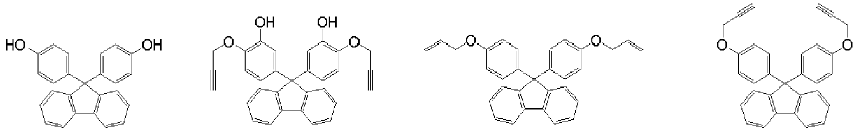

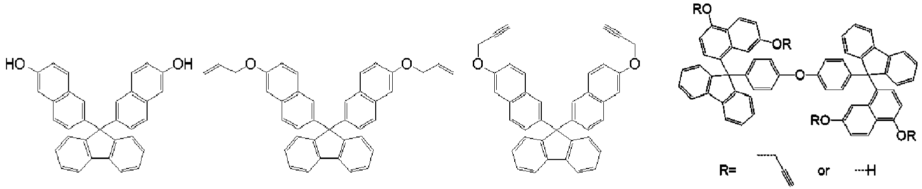

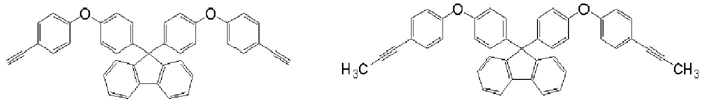

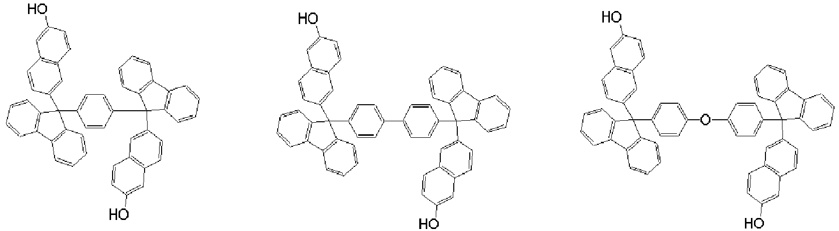

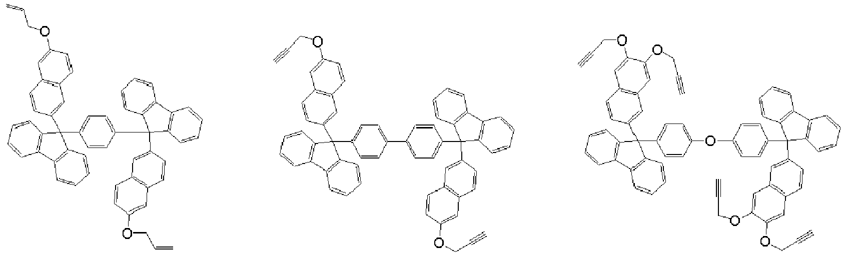

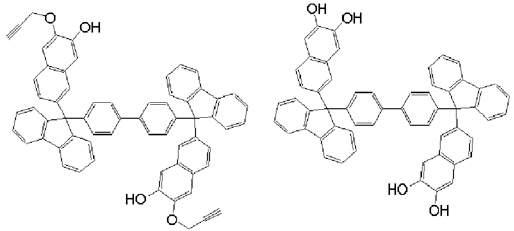

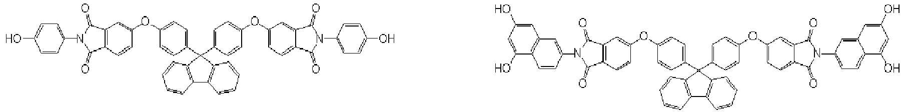

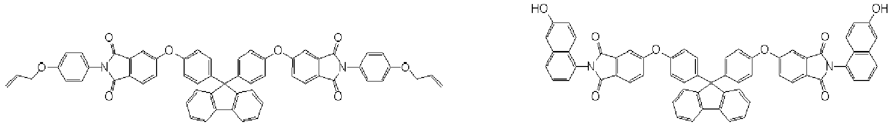

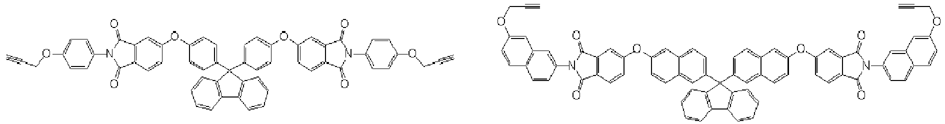

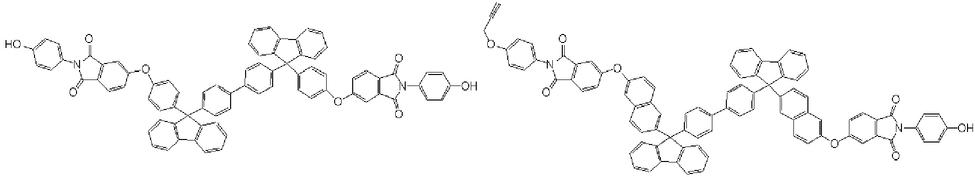

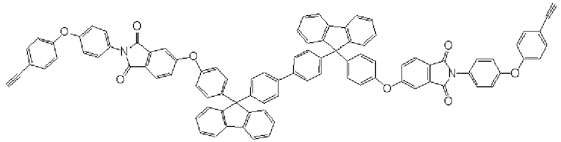

The above compounds include those having only the constituent unit represented by the above general formula (II-2); however, the constituent unit represented by the above general formula (II-1) is required in the reaction with a metal source. Therefore, when the proportion of the above general formula (II-1) is "a" and the proportion of the above general formula (II-2) is "b", the organic source (II) as a whole preferably satisfies the relationships: a+b=1 and 0.2≤b≤0.8, more preferably 0.3≤b≤0.7. In the present invention, only one kind of the organic source (II) in which the proportions of the above general formulae (II-1) and (II-2) are controlled within the above-described range may be used, or two or more kinds thereof may be mixed at a desired mixing ratio to obtain an equivalent composition.

The ratio Mw/Mn (i.e., dispersity) in each above compound contained in the organic source (II) is preferably in the range of 1.00≤Mw/Mn≤1.25, more preferably 1.00≤Mw/Mn≤1.10, the Mw/Mn being a ratio of the weight average molecular weight Mw to the number average molecular weight Mn on polystyrene basis according to gel permeation chromatography (GPC). By definition, Mw/Mn is 1.00 for a monomolecular compound; however, the measured value may exceed 1.00 depending on the separation property of GPC. In general, it is extremely difficult for polymers with repeating units to approach the condition Mw/Mn = 1.00 unless a special polymerization method is used; therefore, they have Mw distribution and Mw/Mn of more than 1. In the present invention, 1.00≤Mw/Mn≤1.10 is defined as an index of monomolecularity so as to distinguish monomolecular compounds from polymeric compounds.

With the composition having such a range of dispersity, the organic-inorganic composite material exhibits more excellent thermal flowability. Thus, when it is added to the composition for forming a metal oxide film, it is possible to not only desirably fill a fine structure formed on the substrate but also form a metal oxide film with the entire substrate planarized.

### Method for Synthesizing (A) Organic-Inorganic Composite Material

(A) The organic-inorganic composite material of the present invention may be produced by a condensation reaction of the metal source (I) (hereinafter may simply be referred to as "metal monomer") with an organic source (II) in the absence of a catalyst or in the presence of an acid or alkali catalyst. The metal source (I) contains one or more of the metal compound represented by the above formula (I-1), a hydrolysate of the metal compound represented by the above formula (I-1), and a hydrolysis condensate of the metal compound represented by the above formula (I-1). The organic source (II) contains a compound having the constituent unit represented by the above formula (II-1) and a cardo structure.

As the acid catalyst, one or more compounds selected from inorganic acids, aliphatic sulfonic acids, aromatic sulfonic acids, aliphatic carboxylic acids, and aromatic carboxylic acids can be used. Specific examples of the acid catalyst include hydrofluoric acid, hydrochloric acid, hydrobromic acid, sulfuric acid, nitric acid, perchloric acid, phosphoric acid, methanesulfonic acid, benzenesulfonic acid, toluenesulfonic acid, formic acid, acetic acid, propionic acid, oxalic acid, malonic acid, maleic acid, fumaric acid, benzoic acid, and the like. The amount of the acid catalyst used is preferably 10⁻⁶ to 10 moles, more preferably 10⁻⁵ to 7 moles, further preferably 10⁻⁴ to 5 moles, per mole of the metal monomer.

Examples of the alkali catalyst include methylamine, ethylamine, propylamine, butylamine, ethylenediamine, hexamethylenediamine, dimethylamine, diethylamine, ethylmethylamine, trimethylamine, triethylamine, tripropylamine, tributylamine, cyclohexylamine, dicyclohexylamine, monoethanolamine, diethanolamine, dimethyl monoethanolamine, monomethyl diethanolamine, triethanolamine, diazabicyclo octane, diazabicyclo cyclononene, diazabicyclo undecene, hexamethylene tetraamine, aniline, N,N-dimethylaniline, pyridine, N,N-dimethyl ethanolamine, N,N-diethyl ethanolamine, N-(β-aminoethyl) ethanolamine, N-methyl ethanolamine, N-methyl diethanolamine, N-ethylethanolamine, N-n-butylethanolamine, N-n-butyl diethanolamine, N-tert-butyl ethanolamine, N-tert-butyl diethanolamine, N,N-dimethyl aminopyridine, pyrrole, piperazine, pyrrolidine, piperidine, picoline, tetramethylammonium hydroxide, choline hydroxide, tetrapropylammonium hydroxide, tetrabutylammonium hydroxide, ammonia, lithium hydroxide, sodium hydroxide, potassium hydroxide, barium hydroxide, calcium hydroxide, and the like. The amount of the alkali catalyst used is preferably 10⁻⁶ to 10 moles, more preferably 10⁻⁵ to 7 moles, further preferably 10⁻⁴ to 5 moles, per mole of the metal monomer.

The amount of the organic compound when the organic-inorganic composite material is obtained by a condensation reaction of the metal source (I) and the organic source (II) is preferably 0.01 to 10 moles, more preferably 0.05 to 7 moles, further preferably 0.1 to 5 moles, per mole of the metal monomer. An addition amount of 10 moles or less is preferable because the stability of the organic-inorganic composite material will not be impaired and also a metal oxide film with excellent dry etching resistance can be provided. An addition amount of 0.01 mole or more is preferable because a metal oxide film with excellent flowability can be provided.

The amount of the organic solvent when the organic-inorganic composite material is obtained by a condensation reaction of the metal source (I) and the organic source (II) is preferably 0.01 to 500 moles, more preferably 0.05 to 300 moles, further preferably 0.1 to 200 moles, per mole of the metal monomer. The addition of 500 moles or less is preferable because the apparatus used for the reaction will not be excessively large and therefore is economical, and also the stability of the organic-inorganic composite material is not impaired.

Examples of operation method include a method of adding a catalyst and a metal monomer to a solvent in which the organic compound is dissolved to initiate the condensation reaction. At this time, an organic solvent may be added to the catalyst solution or the metal monomer may be diluted with the organic solvent, or both of them may be performed. The reaction temperature is preferably 0 to 200°C, more preferably 5 to 150°C. The reaction time is preferably 10 minutes to 24 hours, more preferably 0.5 to 12 hours. The method of maintaining the temperature at 5 to 150°C during the dropwise addition of the metal monomer, followed by aging at 20 to 150°C for 0.5 to 12 hours is preferred.

Preferable specific examples of organic solvents capable of dissolving the organic compound include the organic solvents described in paragraphs [0091] to [0092] of Japanese Laid-Open Patent Application Publication No. 2007-199653. Further specifically, propylene glycol monomethyl ether acetate (PGMEA), propylene glycol monomethyl ether, propylene glycol monoethyl ether, propylene glycol monopropyl ether, 2-heptanone, cyclopentanone, cyclohexanone, γ-butyrolactone, or a mixture of one or more kinds thereof is preferably used.

The blending amount of the organic solvent capable of dissolving the organic compound is preferably adjusted according to the set film thickness of the metal oxide film; however, the amount of the organic solvent is generally in the range of 100 to 50,000 parts by mass, preferably 500 to 10,000 parts by mass, per 100 parts by mass of the organic source (II) containing the compound having the constituent unit represented by the above formula (II-1) and a cardo structure.

Preferable examples of the organic solvent that can be added to the catalyst or that can dilute the metal monomer include methanol, ethanol, 1-propanol, 2-propanol, 1-butanol, 2 butanol, 2-methyl-1-propanol, acetone, acetonitrile, tetrahydrofuran, toluene, hexane, ethyl acetate, cyclohexanone, methyl pentyl ketone, butanediol monomethyl ether, propylene glycol monomethyl ether, ethylene glycol monomethyl ether, butanediol monoethyl ether, propylene glycol monoethyl ether, ethylene glycol monoethyl ether, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, tert-butyl acetate, tert-butyl propionate, propylene glycol mono-tert-butylether acetate, γ-butyrolactone, acetylacetone, methyl acetoacetate, ethyl acetoacetate, propyl acetoacetate, butyl acetoacetate, methylpivaloyl acetate, methylisobutyroyl acetate, methyl caproyl acetate, methyl lauroyl acetate, 1,2-ethanediol, 1,2-propanediol, 1,2-butanediol, 1,2-pentanediol, 2,3-butanediol, 2,3-pentanediol, glycerin, diethylene glycol, hexylene glycol, mixtures thereof, and the like.

The amount of the organic solvent that can be added to the catalyst or that can dilute the metal monomer is preferably 0.01 to 500 moles, more preferably 0.05 to 300 moles, further preferably 0.1 to 200 moles, per mole of the metal monomer. The addition of 500 moles or less is preferable because the apparatus used for the reaction will not be excessively large and therefore is economical, and also the stability of the organic-inorganic composite material is not impaired.

Then, if necessary, a neutralization reaction of the catalyst is performed. The amount of the acid or alkali that can be used for the neutralization is preferably 0.1 to 2 equivalents of the acid or alkali used as a catalyst, and any substance that produces a neutral state may be used.

It is preferable to then remove the alcohol byproducts produced by the condensation reaction from the reaction solution. The temperature for heating the reaction solution herein depends on the types of the organic solvent added and the byproducts produced by the reaction; however, the temperature is preferably in the range of 0 to 200°C, more preferably in the range of 10 to 150°C, and further preferably in the range of 15 to 150°C. The degree of pressure reduction herein depends on the types of the organic solvent and the byproducts to be removed, the exhaust unit, the condensing unit, and the heating temperature; however, the degree of pressure reduction is preferably less than the atmospheric pressure, more preferably 80 kPa or less in absolute pressure, and further preferably 50 kPa or less in absolute pressure. Although it is difficult to know the exact amount of the byproducts to be removed in this process, it is desirable to remove approximately 80% by mass or more of the generated byproducts.

If the obtained organic-inorganic composite material is concentrated to a certain concentration or more, further condensation reaction may be advanced and the organic-inorganic composite material may be changed to a state where it is not re-dissolvable in organic solvents; therefore, the obtained organic-inorganic composite material is preferably kept in a solution state having a moderate concentration. It is also economical and desirable to keep a solution state having a moderate concentration, because if the concentration is excessively low, the amount of the solvent becomes excessively large. The solid component concentration herein is preferably 0.1 to 40% by mass.

Preferable examples of the final solvent to be added to the reaction solution after the byproducts are removed include butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, ethylene glycol monobutyl ether, diethylene glycol monomethyl ether, diethylene glycol monoethyl ether, diethylene glycol monopropyl ether, diethylene glycol monobutyl ether, propylene glycol monobutyl ether, 1-butanol, 2-butanol, 2-methyl-1-propanol, 4-methyl-2-pentanol, acetone, tetrahydrofuran, toluene, hexane, ethyl acetate, cyclohexanone, methyl pentyl ketone, propylene glycol dimethyl ether, diethylene glycol dimethyl ether, dipentyl ether, propylene glycol monomethyl ether acetate, propylene glycol monoethyl ether acetate, ethyl pyruvate, butyl acetate, methyl 3-methoxypropionate, ethyl 3-ethoxypropionate, tert-butyl acetate, tert-butyl propionate, propylene glycol mono-tert-butyl ether acetate, γ-butyrolactone, methyl isobutyl ketone, cyclopentyl methyl ether, and the like.

By using such (A) an organic-inorganic composite material for the composition for forming a metal oxide film of the present invention, it is possible to form a metal oxide film ensuring both excellent coatability and high filling and planarizing properties compared with previously-known compositions for forming a metal oxide film.

### (B) Solvent

(B) The organic solvent that can be used for the composition for forming a metal oxide film of the present invention is not limited and may be any solvent capable of dissolving the component (A) above, i.e., an organic-inorganic composite material, which is a reaction product of the metal source (I) containing one or more selected from the metal compound represented by the formula (I-1), a hydrolysate of the metal compound represented by the formula (I-1), and a hydrolysis condensate of the metal compound represented by the formula (I-1), and the organic source (II) containing a compound having a constituent unit represented by the formula (II-1) and a cardo structure, and, when contained, (C) a flowability accelerator, a crosslinking agent, a surfactant, an acid generator, and other additives, etc., which are described later. Specifically, solvents having a boiling point of less than 180°C, such as the solvents described in paragraphs [0091] to [0092] of Japanese Patent Laid-Open Publication No. 2007-199653 may be used. Among them, propylene glycol monomethyl ether acetate, propylene glycol monomethyl ether, 2-heptanone, cyclopentanone, cyclohexanone, and a mixture of two or more of these solvents may be preferably used. The blending amount of the organic solvent is preferably 100 to 50,000 parts, more preferably 150 to 10,000 parts, further preferably 200 to 5,000 parts, per 100 parts of (A) the organic-inorganic composite material.

With such a composition for forming a metal oxide film, (A) the organic-inorganic composite material can be desirably dissolved, and the composition can be applied by spin coating, thereby forming a metal oxide film having both dry etching resistance and high filling and planarizing properties.

### (C) Flowability Accelerator

The composition for forming a metal oxide film of the present invention may comprise (C) a flowability accelerator having a weight reduction rate in a range from 30°C to 190°C of less than 30% and a weight reduction rate in a range from 30°C to 350°C of 98% or more.

Such a flowability accelerator having a weight reduction rate in the temperature region from 30°C to 190°C of less than 30% and a weight reduction rate in the temperature region from 30°C to 350°C of 98% or more is sufficient to maintain low viscosity due to suppressed evaporation during the heating, and also has excellent thermal flowability, and will contain a small amount of residual flowability accelerator in the metal oxide film after baking. In this specification, the weight reduction rate is based on the value determined by TG (thermogravimetric) measurement using a differential thermal balance.

The upper limit of the temperature range at which the weight reduction rate of (C) the flowability accelerator is less than 30% is preferably 210°C, and further preferably 230°C. By setting the above temperature range as the temperature range in which the weight reduction rate of the flowability accelerator is less than 30%, it is possible to further improve the filling and planarizing properties.

The temperature at which the weight reduction rate of (C) the flowability accelerator is 98% or more is more preferably 330°C, further preferably 310°C. By setting the above temperature range as the temperature range at which the weight reduction rate of the flowability accelerator is 98% or more, it is possible to further reduce the residual flowability accelerator in the metal oxide film after baking.

By adding the flowability accelerator described above, the thermal flowability of the composition for forming a metal oxide film during the period from the start of the heating to the curing by the crosslinking reaction is improved, thereby ensuring excellent filling and planarizing properties; on the other hand, the etching resistance and the optical characteristics are not impaired because the flowability accelerator is reduced by evaporation, or the like during the heating.

Further, examples of more preferable form of the flowability accelerator include one or more compounds selected from the following general formulae (i) to (iii) ; 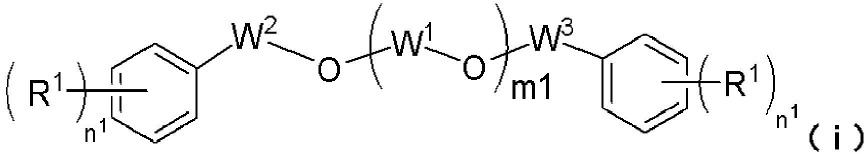 wherein R¹ independently represents a hydrogen atom, a hydroxyl group, or an optionally substituted organic group having 1 to 10 carbon atoms; W¹ is a phenylene group or a divalent group represented by the following general formula (i-1); each of W² and W³ is a single bond or any of the divalent groups represented by the following general formula (i-2); m¹ is an integer of 1 to 10; and n¹ is an integer of 0 to 5; 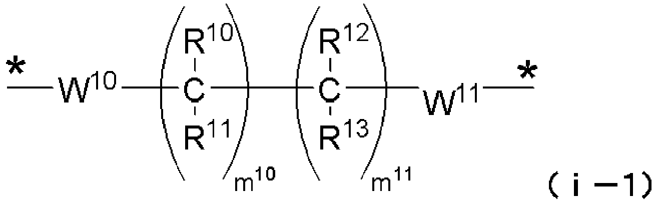 wherein * represents a bonding site; and each of R¹⁰, R¹¹, R¹², and R¹³ represents a hydrogen atom, a hydroxyl group, or an organic group having 1 to 10 carbon atoms; W¹⁰ and W¹¹ independently represents a single bond or a carbonyl group; and each of m¹⁰ and m¹¹ is an integer of 0 to 10, and m¹⁰+m¹¹≥1; and 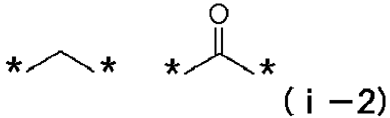 wherein * represents a bonding site.

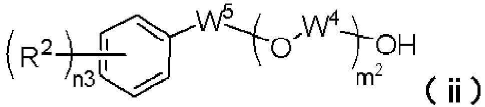

In the formula, R² independently represents a hydrogen atom, a hydroxyl group, or an optionally substituted organic group having 1 to 10 carbon atoms; W⁴ is a divalent group represented by the following general formula (ii-1); W³ is a single bond or any of the divalent groups represented by the following general formula (ii-2); m² is an integer of 2 to 10; and n³ is an integer of 0 to 5; 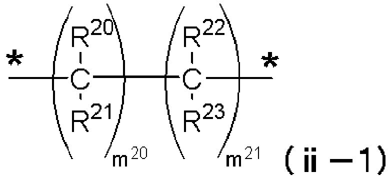 wherein * represents a bonding site; and each of R²⁰, R²¹, R²², and R²³ represents a hydrogen atom, a hydroxyl group, or an organic group having 1 to 10 carbon atoms; and each of m²⁰ and m²¹ is an integer of 0 to 10, and m²⁰+m²¹≥1, and 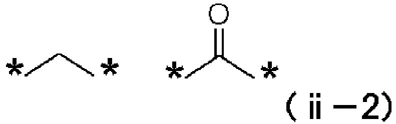 wherein * represents a bonding site.

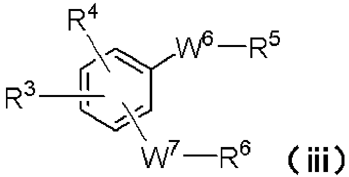

In the formula, each of R³ and R⁴ represents a hydrogen atom, a hydroxyl group, or an optionally substituted organic group having 1 to 10 carbon atoms, and R³ and R⁴ may be bonded to each other to form a cyclic structure; each of R⁵ and R⁶ is an organic group having 1 to 10 carbon atoms, and R⁵ is a group containing either an aromatic ring or a divalent group represented by the following general formula (iii-1); and each of W⁶ and W⁷ is a single bond or any of the divalent groups represented by the general formula (iii-2), and at least one of W⁶ and W⁷ is one of the divalent groups represented by the following general formula (iii-2); 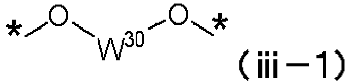 wherein * represents a bonding site; and W³⁰ is an organic group having 1 to 4 carbon atoms, and 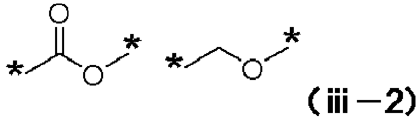 wherein * represents a bonding site.

In the above general formula (i), R¹ independently represents a hydrogen atom, a hydroxyl group, or an optionally substituted organic group having 1 to 10 carbon atoms.

In the present invention, "organic group" refers to a group containing at least one carbon atom, and may further contain hydrogen atom, and may also contain nitrogen, oxygen, sulfur, silicon, halogen atom, and the like.

R¹ may be a single kind or a mixture of multiple kinds. Specific examples of R¹ include a hydrogen atom, hydroxyl group, methyl group, ethyl group, vinyl group, 2,2,2-trifluoroethyl group, propyl group, isopropyl group, allyl group, butyl group, s-butyl group, t-butyl group, isobutyl group, pentyl group, cyclopentyl group, hexyl group, cyclohexyl group, cyclohexenyl group, decyl group, methoxy group, ethoxy group, propoxy group, isopropoxy group, butoxy group, s-butoxy group, t-butyl group, butoxy group, norbornyl group, adamantyl group, phenyl group, toluyl group, xylyl group, naphthyl group, benzyl group, 2-furanyl group, 2-tetrahydrofuranyl group, and the like. Among these, a hydrogen atom is preferable.

W¹ is a phenylene group or a divalent group represented by the above general formula (i-1). Each of W² and W³ is a single bond or any of the divalent groups represented by the above general formula (i-2). m¹ is an integer of 1 to 10; and n¹ independently represents an integer of 0 to 5.

Each of R¹⁰, R¹¹, R¹², and R¹³ represents a hydrogen atom, a hydroxyl group, or an organic group having 1 to 10 carbon atoms. Specific examples include a hydrogen atom, hydroxyl group, methyl group, ethyl group, vinyl group, 2,2,2-trifluoroethyl group, propyl group, isopropyl group, allyl group, butyl group, s-butyl group, t-butyl group, isobutyl group, pentyl group, cyclopentyl group, hexyl group, cyclohexyl group, cyclohexenyl group, decyl group, methoxy group, ethoxy group, propoxy group, isopropoxy group, butoxy group, s-butoxy group, t-butyl group, butoxy group, norbornyl group, adamantyl group, phenyl group, toluyl group, xylyl group, naphthyl group, benzyl group, 2-furanyl group, 2-tetrahydrofuranyl group, and the like. Among these, a hydrogen atom and a methyl group are more preferable, and a hydrogen atom is further preferable.

W¹⁰ and W¹¹ independently represent a single bond or a carbonyl group; each of m¹⁰ and m¹¹ is an integer of 0 to 10, and m¹⁰+m¹¹≥1.

R² may be a single kind or a mixture of multiple kinds. Specific examples of R² include hydrogen atom, hydroxyl group, methyl group, ethyl group, vinyl group, 2,2,2-trifluoroethyl group, propyl group, isopropyl group, allyl group, butyl group, s-butyl group, t-butyl group, isobutyl group, pentyl group, cyclopentyl group, hexyl group, cyclohexyl group, cyclohexenyl group, decyl group, methoxy group, ethoxy group, propoxy group, isopropoxy group, butoxy group, s-butoxy group, t-butyl group, butoxy group, norbornyl group, adamantyl group, phenyl group, toluyl group, xylyl group, naphthyl group, benzyl group, 2-furanyl group, 2-tetrahydrofuranyl group, and the like. Among these, a hydrogen atom is preferable.

W⁴ is a divalent group represented by the above general formula (ii-1). W⁵ is a single bond or any of the divalent groups represented by the above general formula (ii-2); m² is an integer of 2 to 10; n³ is an integer of 0 to 5.

Specific examples of R²⁰, R²¹, R²², and R²³ include a hydrogen atom, hydroxyl group, methyl group, ethyl group, vinyl group, 2,2,2-trifluoroethyl group, propyl group, isopropyl group, allyl group, butyl group, s-butyl group, t-butyl group, isobutyl group, pentyl group, cyclopentyl group, hexyl group, cyclohexyl group, cyclohexenyl group, decyl group, methoxy group, ethoxy group, propoxy group, isopropoxy group, butoxy group, s-butoxy group, t-butyl group, butoxy group, norbornyl group, adamantyl group, phenyl group, toluyl group, xylyl group, naphthyl group, benzyl group, 2-furanyl group, 2-tetrahydrofuranyl group, and the like. Among these, a hydrogen atom and a methyl group are more preferable, and a hydrogen atom is further more preferable.

Each of m²⁰ and m²¹ is an integer of 0 to 10, and m²⁰+m²¹≥1.

Each of R³ and R⁴ represents a hydrogen atom, a hydroxyl group, or an optionally substituted organic group having 1 to 10 carbon atoms, and R³ and R⁴ may be bonded to each other to form a cyclic structure. Specific examples include a hydrogen atom, hydroxyl group, methyl group, ethyl group, vinyl group, 2,2,2-trifluoroethyl group, propyl group, isopropyl group, allyl group, butyl group, s-butyl group, t-butyl group, isobutyl group, pentyl group, cyclopentyl group, hexyl group, cyclohexyl group, cyclohexenyl group, decyl group, methoxy group, ethoxy group, propoxy group, isopropoxy group, butoxy group, s-butoxy group, t-butyl group, butoxy group, norbornyl group, adamantyl group, phenyl group, toluyl group, xylyl group, naphthyl group, benzyl group, 2-furanyl group, 2-tetrahydrofuranyl group, and the like. Among these, a hydrogen atom is preferable.

R⁶ represents an organic group having 1 to 10 carbon atoms. R⁵ is an organic group having 1 to 10 carbon atoms, and contains either an aromatic ring or the divalent group represented by the above general formula (iii-1). Examples of the organic group having 1 to 10 carbon atoms include the groups listed above for R³ and R⁴.

Each of W⁶ and W⁷ is a single bond or any of the divalent groups represented by the above general formula (iii-2), and at least one of W⁶ and W⁷ is one of the divalent groups represented by the above general formula (iii-2).

W³⁰ is an organic group having 1 to 4 carbon atoms. Specific examples include a methylene group, ethylene group, propylene group, butylene group, trimethylene group, tetramethylene group, and the like. Among these, an ethylene group is more preferable.

Specific examples of the compound represented by the above general formula (i) further include, but are not limited to, the following compounds.

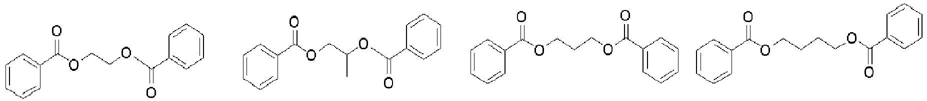

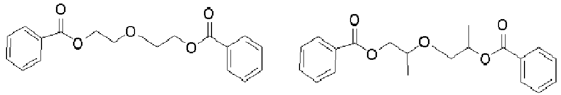

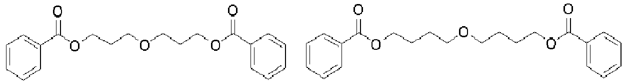

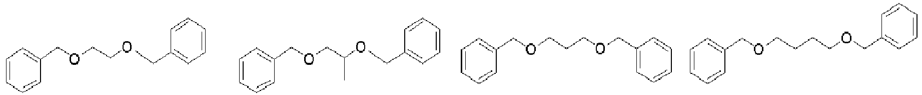

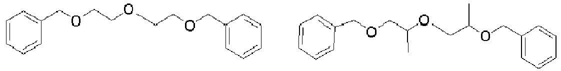

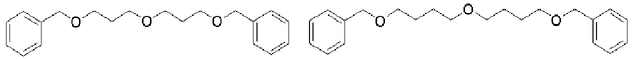

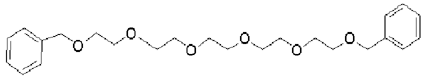

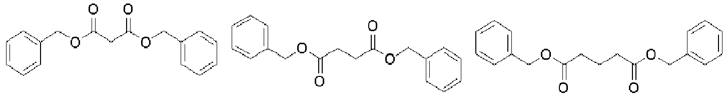

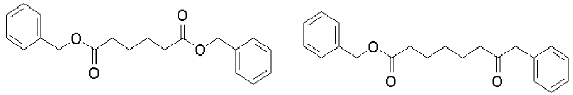

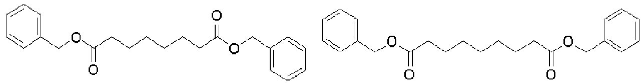

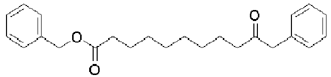

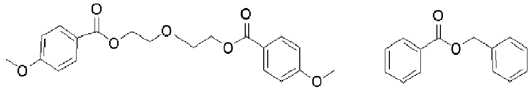

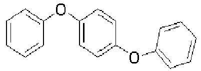

Specific examples of the compound represented by the above general formula (ii) further include, but are not limited to, the following compounds.

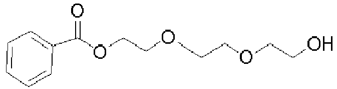

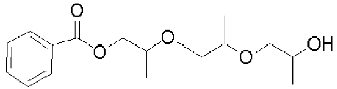

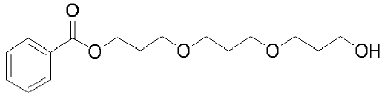

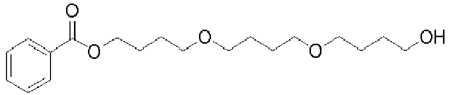

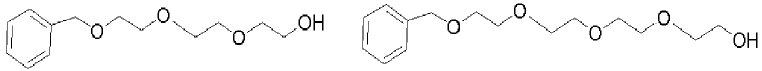

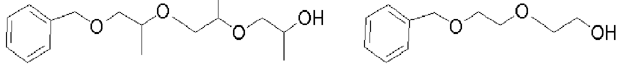

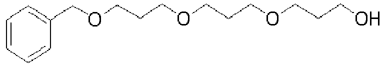

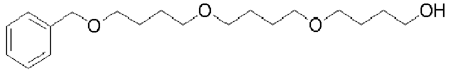

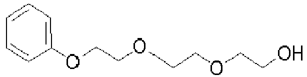

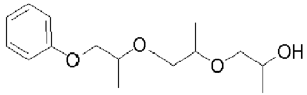

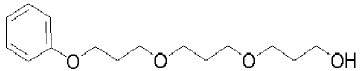

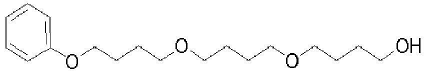

Specific examples of the compound represented by the above general formula (iii) further include, but are not limited to, the following compounds.

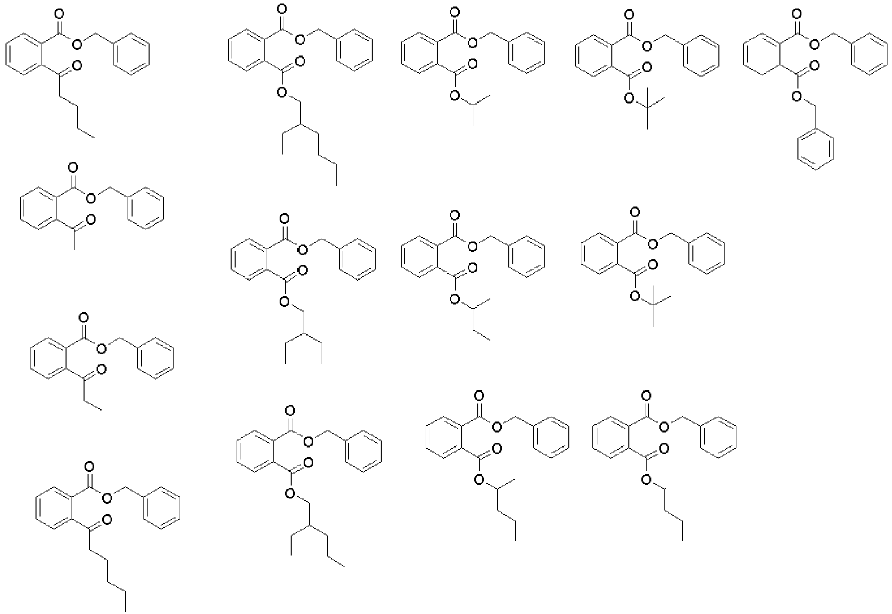

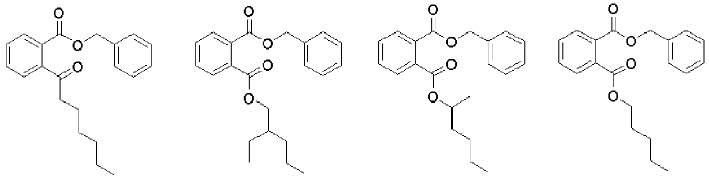

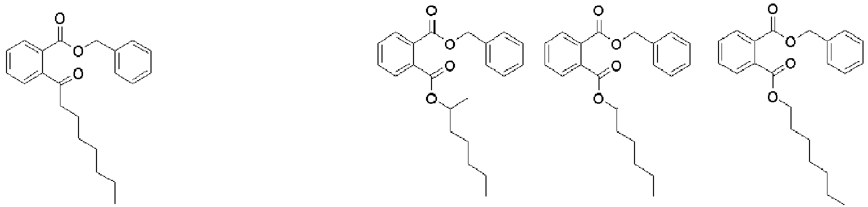

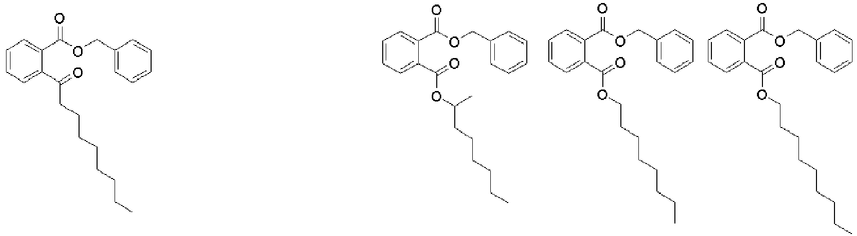

In comprehensive view of the improvement of stability of the organic-inorganic composite material in the composition for forming a metal oxide film, the film forming property, the performance of filling and planarizing the substrate, and the like, (C) the flowability accelerator to be used for the composition for forming a metal oxide film of the present invention is preferably an aromatic group-containing compound having a benzyl or benzoyl group, and the following aromatic group-containing compounds are particularly preferable.
(i) (poly) ethylene glycol dibenzoate
(ii) (poly) ethylene glycol dibenzyl ether
(iii) (poly) propylene glycol dibenzyl ether
(iv) (poly) butylene glycol dibenzyl ether
(v) linear aliphatic dicarboxylic acid dibenzyl ester
(vi) (poly) ethylene glycol monobenzyl ether
(vii) (poly) phenyl ether

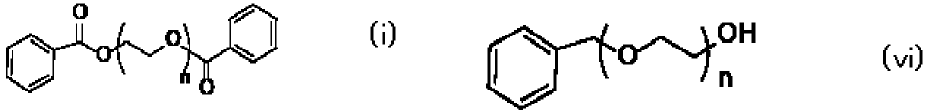

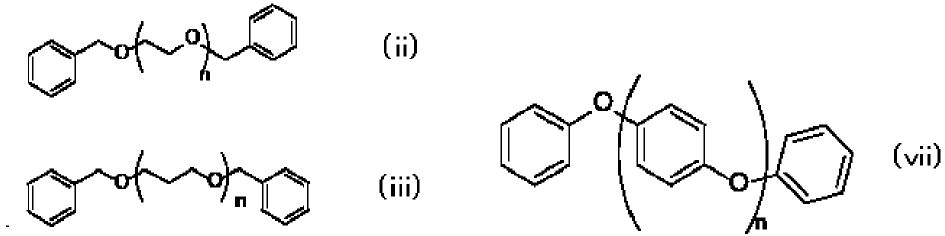

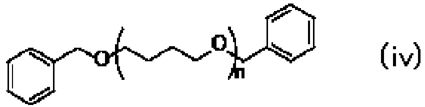

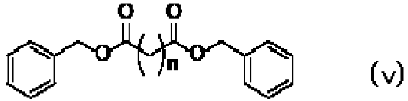

Note that "n" in the above formula is an integer with which the molecular weight falls to 500 or less, and applies only to this formula.

(C) The flowability accelerator used for the composition for forming a metal oxide film of the present invention has a structure having both a hydrophobic part formed of an aromatic ring and a hydrophilic part formed of the (C-1) structure; therefore the (C) flowability accelerator has excellent compatibility with the organic-inorganic composite material, and improves the flowability of the composition without impairing the film forming property or storage stability, 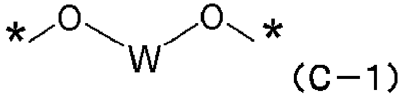 wherein * represents a bonding site; and W is an organic group having 1 to 4 carbon atoms.

The blending amount of (C) the flowability accelerator is preferably 0.1 to 50 parts by mass, more preferably 0.5 to 30 parts by mass, and further preferably 1 to 10 parts by mass, per 100 parts by mass of the organic-inorganic composite material. If the blending amount of the flowability accelerator is 0.1% by mass or more, the flowability of the composition for forming a metal oxide film is improved and sufficient stability effect can be obtained. When the content of the flowability accelerator with respect to the organic-inorganic composite material is 0.1 to 50 parts by mass, sufficient stabilization effect and sufficient effect of improving the thermal flowability of the metal oxide film can be obtained, thereby ensuring desirable film forming property and desirable dry etching resistance of the resulting coating film.

(C) The flowability accelerator may be one kind of the aromatic group-containing compound described above or may be a combination of two or more kinds thereof.

### (D) Metal Oxide Nanoparticle

The composition for forming a metal oxide film of the present invention may further comprise (D) a metal oxide nanoparticle having an average primary particle size of 100 nm or less.

There is no restriction on the type of the metal oxide nanoparticle, and any known metal oxide nanoparticles may be used. The metals of the metal oxide nanoparticles also include semimetals such as B, Si, Ge, As, Sb, Te, and the like.

The average primary particle size of the metal oxide nanoparticles is 100 nm or less, preferably 50 nm or less, and more preferably 20 nm or less, from the viewpoint of the characteristics to be imparted to the composition for forming a metal oxide film described below. The lower limit of the average primary particle size may be, for example, but is not particularly limited to, 1 nm. The average primary particle size of the metal oxide nanoparticles is determined by measuring the diameters of arbitrary 100 particles by observation using a transmission electron microscope (TEM) and finding the arithmetic mean of the 100 diameters. If the particles are not spherical, the longest edge thereof is measured to determine the diameter.

The metal oxide nanoparticles are preferably oxide particles containing atoms of Be, Mg, Ca, Sr, Ba, Sc, Y, La, Ce, Gd, Tb, Dy, Yb, Lu, Ti, Zr, Hf, Nb, Ta, Mo, W, Zn, B, Al, In, Ga, Si, Ge, Sn, Pb, Sb, Bi, Te, and the like, and may also be a complex oxide of any combination of metals. Specific examples thereof include titanium oxide, titanium complex oxide, zinc oxide, zirconium oxide, hafnium oxide, tin oxide, indium/tin oxide, antimony/tin oxide, and tungsten oxide. They may be crystalline. The crystalline system is not limited. For example, titanium dioxide may be any of rutile type, anatase type and brookite type. The surfaces of these metal oxide nanoparticles may be treated with an organic material to impart dispersion stability.

The metal oxide nanoparticle (D) is preferably one or more selected from the group consisting of zirconium oxide nanoparticles, hafnium oxide nanoparticles, titanium oxide nanoparticles, tin oxide nanoparticles, and tungsten oxide nanoparticles.

Commercially available metal oxide nanoparticles may also be used, and examples thereof include ZrO₂ nanoparticles (5 nm core, 915505, Sigma-Aldrich Corp.).

These metal oxide nanoparticles may be used singly or two or more kinds thereof may be combined.

The content of the metal oxide particles in the composition for forming a metal oxide film is preferably in the range of 0 to 50 parts by mass, more preferably in the range of 5 to 30 parts by mass, per 100 parts by mass of the component (A). The content may be 0 part by mass (i.e., no metal oxide particles are contained).

By using such a metal oxide nanoparticle, the metal content in the composition can be easily increased, and the dry etching resistance of the composition for forming a metal oxide film can be further improved. In addition, it is also possible to adjust the refraction index and the light transmissive property of the resulting metal oxide film by incorporating the metal oxide nanoparticles in the composition for forming a metal oxide film at an arbitrary ratio.

### Other Components

### Crosslinking Agent

To increase the curability and further inhibit intermixing with the upper layer film, a crosslinking agent may be added to the composition for forming a metal oxide film of the present invention. The crosslinking agent is not particularly limited, and various known crosslinking agents can be widely used. Examples thereof include methylolated- or alkoxymethylated- polynuclear phenol-based crosslinking agent (polynuclear phenol-based crosslinking agent), a melamine-based crosslinking agent, a glycoluril-based crosslinking agent, a benzoguanamine-based crosslinking agent, a urea-based crosslinking agent, a β-hydroxyalkylamide-based crosslinking agent, an isocyanurate-based crosslinking agent, an aziridine-based crosslinking agent, an oxazoline-based crosslinking agent, an epoxy-based crosslinking agent, and the like. When the crosslinking agent is added, the addition amount thereof is preferably 1 to 100 parts, more preferably 5 to 50 parts, relative to (A) the organic-inorganic composite material.

Specific examples of the melamine-based crosslinking agent include hexamethoxymethylated melamine, hexabutoxymethylated melamine, alkoxy- and/or hydroxy-substituted derivatives thereof, and partial self-condensates thereof.

Specific examples of the glycoluril-based crosslinking agent include tetramethoxymethylated glycoluril, tetrabutoxymethylated glycoluril, alkoxy- and/or hydroxy-substituted derivatives thereof, and partial self-condensates thereof.

Specific examples of the benzoguanamine-based crosslinking agent include tetramethoxymethylated benzoguanamine, tetrabutoxymethylated benzoguanamine, alkoxy- and/or hydroxy-substituted derivatives thereof, and partial self-condensates thereof.

Specific examples of the urea-based crosslinking agent include dimethoxymethylated dimethoxyethyleneurea, alkoxy- and/or hydroxy-substituted derivatives thereof, and partial self-condensates thereof.

Specific examples of the β-hydroxyalkylamide-based crosslinking agent include N,N,N',N'-tetra(2-hydroxyethyl)adipic acid amide. Specific examples of the isocyanurate-based crosslinking agent include triglycidyl isocyanurate and triallyl isocyanurate.

Specific examples of the aziridine-based crosslinking agent include 4,4'-bis(ethyleneiminocarbonylamino)diphenylmethane and 2,2-bishydroxymethylbutanol-tris[3-(1-aziridinyl)propionate].

Specific examples of the oxazoline-based crosslinking agent include 2,2'-isopropylidene bis(4-benzyl-2-oxazoline), 2,2'-isopropylidene bis(4-phenyl-2-oxazoline), 2,2'-methylene bis-4,5-diphenyl-2-oxazoline, 2,2'-methylene bis-4-phenyl-2-oxazoline, 2,2'-methylene bis-4-tert-butyl-2-oxazoline, 2,2'-bis(2-oxazoline), 1,3-phenylene bis(2-oxazoline), 1,4-phenylene bis(2-oxazoline), and a 2-isopropenyloxazoline copolymer.

Specific examples of the epoxy-based crosslinking agent include diglycidyl ether, ethylene glycol diglycidyl ether, 1,4-butanediol diglycidyl ether, 1,4-cyclohexane dimethanol diglycidyl ether, poly(glycidyl methacrylate), trimethylolethane triglycidyl ether, trimethylolpropane triglycidyl ether, and pentaerythritol tetraglycidyl ether.

Specific examples of the polynuclear phenol-based crosslinking agent include a compound represented by the following general formula (XL-1); R₃ below applies only to the following general formula (XL-1), 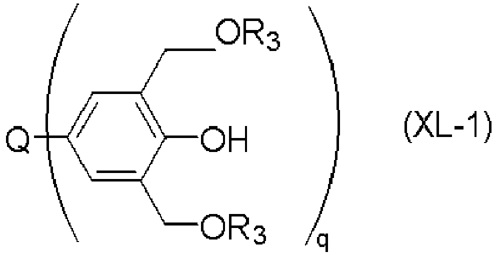 wherein Q is a single bond or a q-valent hydrocarbon group having 1 to 20 carbon atoms; R₃ is a hydrogen atom or an alkyl group having 1 to 20 carbon atoms; and q is an integer of 1 to 5.

Q is a single bond or a q-valent hydrocarbon group having 1 to 20 carbon atoms; and q is an integer of 1 to 5, more preferably 2 or 3. Specific examples of Q include groups obtained by removing q hydrogen atoms from methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, and eicosane. R₃ is a hydrogen atom or an alkyl group having 1 to 20 carbon atoms. Specific examples of the alkyl group having 1 to 20 carbon atoms include a methyl group, ethyl group, propyl group, isopropyl group, butyl group, isobutyl group, pentyl group, isopentyl group, hexyl group, octyl group, ethylhexyl group, decyl group, and eicosanyl group. Among these, a hydrogen atom or a methyl group is preferable.

Specific examples of the compound represented by the above general formula (XL-1) include the following compounds. Among these, triphenolmethane, triphenolethane, 1,1,1,-tris (4-hydroxyphenyl)ethane, and a hexamethoxymethylated derivative of tris (4-hydroxyphenyl)-1-ethyl-4-isopropylbenzene are preferable from the viewpoint of improving the curability and film thickness uniformity of the organic film. R₃ is as defined above.

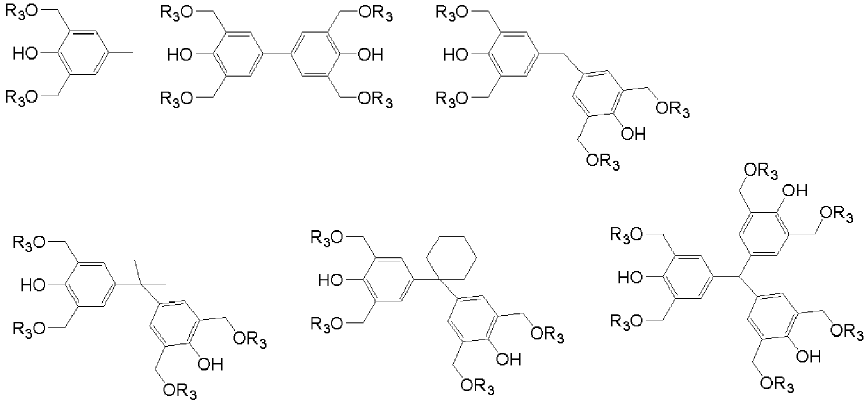

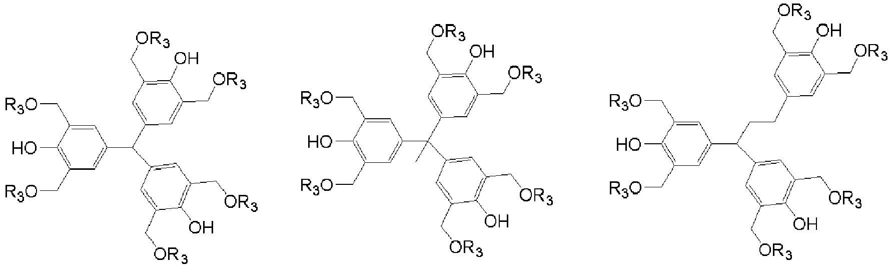

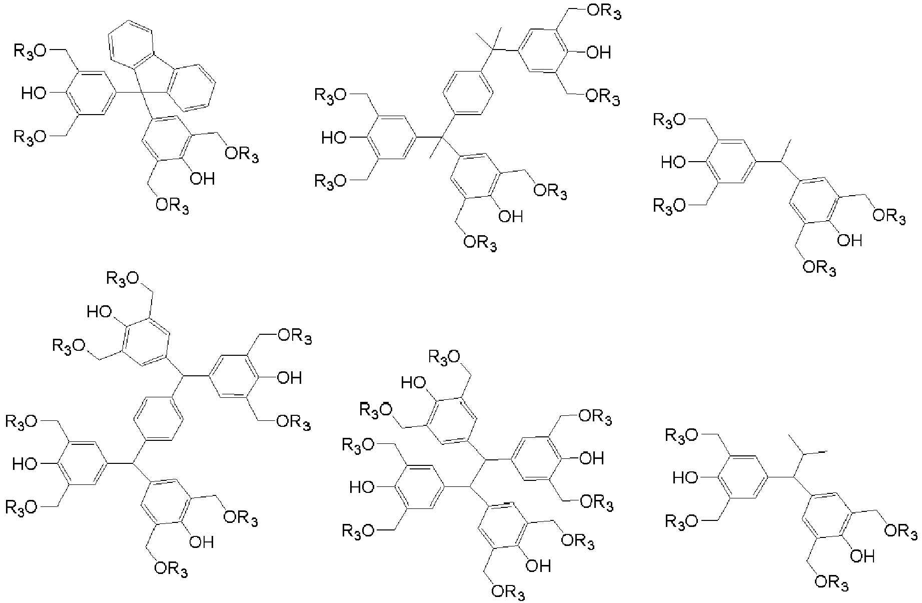

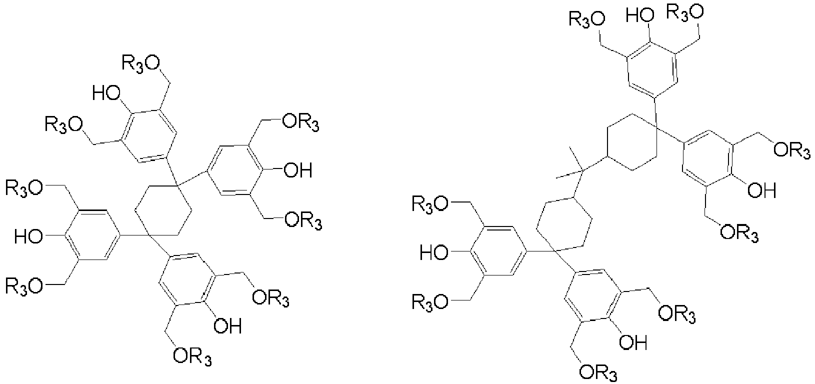

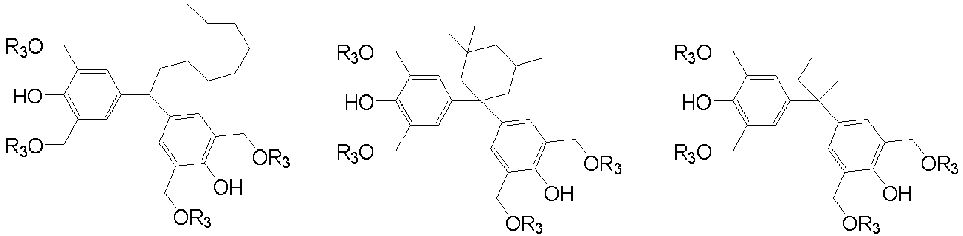

### Surfactant

A surfactant may be added to the composition for forming a metal oxide film of the present invention in order to improve coatability in spin coating. Specific examples of the surfactant include those disclosed in paragraphs [0142] to [0147] of the Japanese Laid-Open Patent Application Publication No. 2009-269953. When the surfactant is added, the addition amount is preferably 0.01 to 10 parts, more preferably 0.05 to 5 parts, per 100 parts by mass of (A) the organic-inorganic composite material.

### Acid Generator

An acid generator may be added to the composition for forming a metal oxide film of the present invention in order to further promote the curing reaction. The acid generator can be classified into those that generate an acid by thermal decomposition and those that generate an acid by optical irradiation; however, any acid generators can be added. Specific examples of the acid generator include, but not limited to, the materials disclosed in paragraphs [0061] to [0085] of Japanese Patent Laid-Open Publication No. 2007-199653.

These acid generators may be used singly or in a combination of two or more kinds. When the acid generator is added, the addition amount is preferably 0.05 to 50 parts, more preferably 0.1 to 10 parts, per 100 parts by mass of (A) the organic-inorganic composite material.

### Plasticizer

A plasticizer may be added to the composition for forming a metal oxide film of the present invention in order to further improve the planarizing and filling properties. The plasticizer is not particularly limited, and various known plasticizers can be widely used. Examples of the plasticizer include low molecular weight compounds such as phthalate esters, adipate esters, phosphate esters, trimellitate esters, and citrate esters; polymers such as polyether-based polymers, polyester-based polymers, and polyacetal-based polymers disclosed in Japanese Patent Laid-Open Publication No. 2013-253227, and the like. When the plasticizer is added, the addition amount is preferably 1 to 100 parts, more preferably 5 to 30 parts, per 100 parts by mass of (A) the organic-inorganic composite material. Note that the plasticizer is different from the component (C).

In addition, for the composition for forming a metal oxide film of the present invention, as an additive for imparting filling and planarizing properties like a plasticizer, for example, a liquid additive having a polyethylene glycol or polypropylene glycol structure, or a thermo-decomposable polymer having a weight reduction rate in a range of 30°C to 250°C of 40% by mass or more and a weight average molecular weight of 300 to 200,000 is preferably used. The thermo-decomposable polymer preferably contains a repeating unit having an acetal structure represented by the following general formulae (DP1) and (DP1a). R₆ below applies only to the following general formula (DP1) .

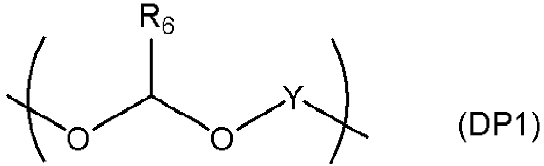

In the formula, R₆ represents a hydrogen atom or a saturated or unsaturated monovalent organic group having 1 to 30 carbon atoms which may be substituted; and Y represents a saturated or unsaturated divalent organic group having 2 to 30 carbon atoms. 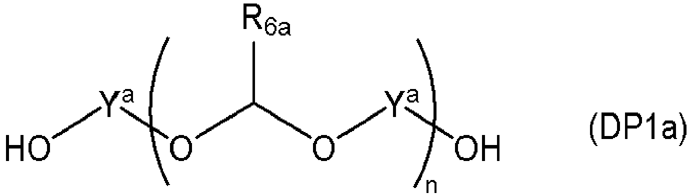 In the formula, R₆ₐ is an alkyl group having 1 to 4 carbon atoms; Y^{a} is a saturated or unsaturated divalent hydrocarbon group having 4 to 10 carbon atoms and optionally containing an ether bond; and n represents an average repeating unit number of 3 to 500.

### Dispersant

A common dispersant may be added to the composition for forming a metal oxide film of the present invention. The type of the dispersant to be used in the present invention is not particularly limited, and previously-known dispersants may be used. Examples of the dispersant include low-molecular dispersants such as alkylamines, alkanethiols, alkanediols, and phosphate esters, high-molecular dispersants having various functional groups, silane coupling agents, and the like. Examples of the high-molecular dispersant include styrene-based resins (styrene-(meth)acrylic acid copolymers, styrene-maleic anhydride copolymers, and the like), acrylic resins ((meth) acrylic acid-based resins such as methyl (meth)acrylate-(meth)acrylic acid copolymers, poly (meth)acrylic acid, and the like), water-soluble urethane resins, water-soluble acrylic urethane resins, water-soluble epoxy resins, water-soluble polyester-based resins, cellulose derivatives (nitrocellulose, cellulose ethers including alkylcelluloses such as ethylcellulose, alkyl-hydroxyalkylcelluloses such as ethylhydroxyethylcellulose, hydroxyalkylcelluloses such as hydroxyethylcellulose and hydroxypropylcellulose, and carboxyalkylcelluloses such as carboxymethylcellulose, and the like), polyvinyl alcohol, polyalkylene glycols (liquid polyethylene glycol, polypropylene glycol, and the like), natural polymers (polysaccharides such as gelatin, dextrin, gum arabic, casein, and the like), polyethylenesulfonic acid or salts thereof, polystyrenesulfonic acid or salts thereof, formalin condensates of naphthalenesulfonic acid, nitrogen atom-containing polymer compounds (amino group-containing polymer compounds such as polyalkyleneimine (polyethyleneimine and the like), polyvinylpyrrolidone, polyallylamine, and polyetherpolyamine (polyoxyethylenepolyamine, and the like)), and the like. The blending amount of the dispersant is preferably 0.1 to 50 parts by mass, more preferably 0.5 to 30 parts by mass, and further preferably 1 to 10 parts by mass, per 100 parts by mass of (A) the organic-inorganic composite material.

The stability of (A) the organic-inorganic composite material can be further improved by adding the dispersant described above.

The compositions for forming a metal oxide film of the present invention may be used singly or in a combination of two or more kinds. The composition for forming a metal oxide film described above can be used as a material for a metal oxide film or a planarizing material for the manufacture of a semiconductor device.

As described above, since the composition for forming a metal oxide film of the present invention contains a reaction product of a metal compound and a specific compound, it is possible to suppress coating failure due to incompatibility between the metal source and the organic source and suppress void generation defects in the filling film caused by thermal shrinkage of the metal compound during the heating, thus exhibiting excellent coatability and filling and planarizing properties compared with the previously-known composition for forming a metal oxide film obtained by mixing a metal compound and a resin.

### Patterning Process

Further, the present invention provides, as a patterning process by way of a two-layer resist process using such a composition for forming a metal oxide film, a patterning process for forming a pattern in a substrate to be processed, the process comprising the steps of:
(I-1) forming a metal oxide film by applying the composition for forming a metal oxide film described above onto a substrate to be processed, followed by heating;
(I-2) forming a resist upper layer film on the metal oxide film by using a photoresist material;
(I-3) subjecting the resist upper layer film to pattern exposure and then development with a developer to form a pattern in the resist upper layer film;
(I-4) transferring the pattern to the metal oxide film by dry etching while using the resist upper layer film having the formed pattern as a mask; and
(I-5) processing the substrate to be processed while using the metal oxide film having the formed pattern as a mask to form the pattern in the substrate to be processed.

The resist upper layer film in the two-layer resist process described above exhibits etching resistance by chlorine-based gas; therefore, the dry etching of the metal oxide film that is performed while using the resist upper layer film as a mask in the two-layer resist process is preferably performed using an etching gas mainly containing a chlorine-based gas.

Further, the present invention provides, as a patterning process by way of a three-layer resist process using such a composition for forming a metal oxide film, a patterning process for forming a pattern in a substrate to be processed, the process comprising the steps of:
(II-1) applying the composition for forming a metal oxide film onto a substrate to be processed, followed by heating to form a metal oxide film;
(II-2) forming a resist middle layer film on the metal oxide film by using a resist middle layer film material;
(II-3) forming a resist upper layer film on the resist middle layer film by using a photoresist material;
(II-4) subjecting the resist upper layer film to pattern exposure and then development with a developer to form a pattern in the resist upper layer film;
(II-5) transferring the pattern to the resist middle layer film by dry etching while using the resist upper layer film having the formed pattern as a mask;
(II-6) transferring the pattern to the metal oxide film by dry etching while using the resist middle layer film having the transferred pattern as a mask; and
(II-7) processing the substrate to be processed while using the metal oxide film having the formed pattern as a mask to form the pattern in the substrate to be processed.

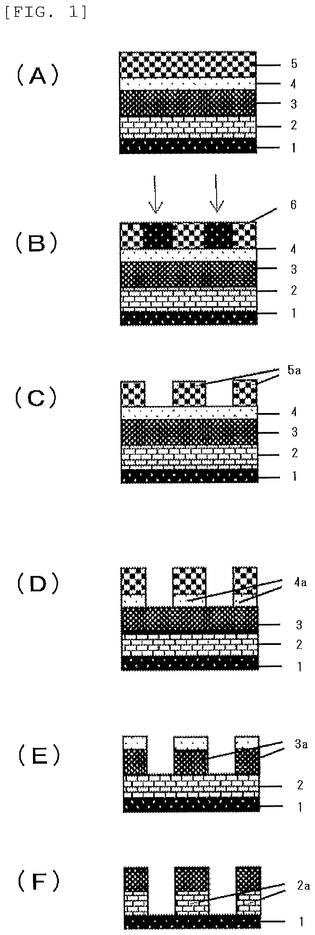

An example of the three-layer resist process is specifically explained below by referring to FIG. 1. In the case of the three-layer resist process, as shown in FIG. 1(A), a metal oxide film (metal-containing resist underlayer film) 3 is formed on a layer to be processed 2 stacked on a substrate to be processed 1 using a metal oxide film forming material of the present invention; thereafter, a silicon atom-containing resist middle layer film 4 is formed, and a resist upper layer film 5 is further formed thereon.

Next, as shown in FIG. 1(B), exposure is conducted for required portion (exposure portion) 6 of the resist upper layer film 5, followed by PEB and development, to form a resist upper layer film pattern 5a (FIG. 1(C)). The obtained resist upper layer film pattern 5a is then used as a mask to etch the silicon atom-containing resist middle layer film 4 using a CF-based gas to form a silicon atom-containing resist middle layer film pattern 4a (FIG. 1(D)). After removing the resist upper layer film pattern 5a, oxygen plasma etching of the metal oxide film 3 is performed while using the obtained silicon atom-containing resist middle layer film pattern 4a as a mask to form a metal oxide film pattern (metal-containing resist underlayer film pattern) 3a (FIG. 1(E)). Further, after removing the silicon atom-containing resist middle layer film pattern 4a, the layer to be processed 2 is etched while using the metal oxide film pattern 3a as a mask to form a pattern 2a to be formed on the layer to be processed (FIG. 1(F)).

The silicon-containing resist middle layer film in the three-layer resist process described above exhibits etching resistance to a chlorine-based gas or an oxygen-based gas; therefore, the dry etching of the metal oxide film that is performed while using the silicon-containing resist middle layer film as a mask in the three-layer resist process is preferably performed using an etching gas mainly containing a chlorine-based gas or an oxygen-based gas.

As the silicon-containing resist middle layer film in the three-layer resist process, a polysiloxane-based middle layer film is also preferably used. This makes the silicon-containing resist middle layer film to possess an effect as an antireflective film, thereby suppressing reflection. When a material containing many aromatic groups providing a high etching selectivity with respect to the substrate is used as the organic film especially for 193-nm exposure, the k-value increases and thus the substrate reflection increases; however, the reflection can be suppressed by imparting absorption so that the silicon-containing resist middle layer film has an appropriate k-value. In this manner, the substrate reflection can be reduced to 0.5% or less. Preferably used as the silicon-containing resist middle layer film with an antireflective effect is a polysiloxane having a pendant anthracene for exposure at 248 nm or 157 nm, or a pendant phenyl group or a pendant light-absorbing group having a silicon-silicon bond for 193 nm exposure, which is cross-linked by an acid or a heat.

In addition, the present invention provides a patterning process by way of a four-layer resist process using such a composition for forming a metal oxide film, comprising the steps of: forming a metal oxide film on a substrate to be processed using the composition for forming a metal oxide film described above; forming a silicon-containing resist middle layer film on the metal oxide film using a silicon-containing resist middle layer film material; forming an organic antireflective film (BARC) or an adhesive film on the silicon-containing resist middle layer film; forming a resist upper layer film using a photoresist material on the BARC, followed by pattern exposure of the resist upper layer film and development using a developer, thereby forming a pattern in the resist upper layer film; transferring the pattern to the BARC or the adhesive film and the silicon-containing resist middle layer film by dry etching while using the resist upper layer film having the formed pattern as a mask; transferring the pattern to the metal oxide film by dry etching using the silicon-containing resist middle layer film having the transferred pattern as a mask; and processing the substrate to be processed using the metal oxide film having the formed pattern as a mask, thereby forming a pattern in the substrate to be processed.

Further, an inorganic hard mask may be formed instead of the silicon-containing resist middle layer film; in this case, a semiconductor device circuit pattern can be formed on a substrate, at least, by forming a metal oxide film on a body to be processed using the composition for forming a metal oxide film of the present invention, forming an inorganic hard mask selected from a silicon oxide film, a silicon nitride film, and a silicon oxynitride film on the metal oxide film, forming a resist upper layer film on the inorganic hard mask using the photoresist composition to form a circuit pattern in the resist upper layer film, etching the inorganic hard mask while using the resist upper layer film having the formed pattern as a mask, etching the metal oxide film using the inorganic hard mask having the formed pattern as a mask, and etching the body to be processed using the metal oxide film having the formed pattern as a mask to form a pattern in the body to be processed.

Further, the present invention provides a patterning process for forming a pattern in a substrate to be processed, the process comprising the steps of:
(III-1) applying the composition for forming a metal oxide film onto a substrate to be processed, followed by heating to form a metal oxide film;
(III-2) forming an inorganic hard mask middle layer film selected from a silicon oxide film, a silicon nitride film, and a silicon oxynitride film on the metal oxide film;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the metal oxide film by dry etching while using the inorganic hard mask middle layer film having the transferred pattern as a mask; and
(III-8) processing the substrate to be processed while using the metal oxide film having the formed pattern as a mask to form the pattern in the substrate to be processed.

In this case, the inorganic hard mask described above is preferably formed by a CVD method or an ALD method.

When the inorganic hard mask described above is formed by a CVD method or an ALD method, a fine pattern can be formed on a body to be processed with a higher degree of accuracy.

As described above, when the inorganic hard mask is formed on the metal oxide film, a silicon oxide film, a silicon nitride film, and a silicon oxynitride film (SiON film) can be formed by a CVD method, an ALD method, or the like. The method for forming the silicon nitride film is disclosed, for example, in Japanese Laid-Open Patent Application Publication No. 2002-334869 and International Publication No. WO2004/066377. The thickness of the inorganic hard mask is preferably 5 to 200 nm, more preferably 10 to 100 nm. The SiON film, which has a high function as an antireflective film, is most preferably used as the inorganic hard mask. Since the substrate temperature increases to 300 to 500°C when the SiON film is formed, the metal oxide film needs to withstand a temperature of 300 to 500°C. The composition for forming a metal oxide film used in the present invention has high heat resistance and can withstand a temperature of 300 to 500°C. Thus, the inorganic hard mask formed by the CVD method or the ALD method and the metal oxide film formed by spin coating can be combined.

A photoresist film may be formed on the inorganic hard mask as the resist upper layer film as described above; alternatively, an organic antireflective film (BARC) or an adhesive film may be formed on the inorganic hard mask by spin coating, and a photoresist film may be formed thereon. In particular, when a SiON film is used as the inorganic hard mask, the reflection can be suppressed by the two antireflective films, i.e., the SiON film and the BARC film, even in liquid immersion exposure at a high NA exceeding 1.0. Another merit of forming BARC resides in that it has an effect to reduce a footing profile of a photoresist pattern immediately above the SiON film.

The resist upper layer film in the multilayer resist process described above may be either a positive type or negative type, and it is possible to be formed by using a composition similar to the typically used photoresist composition. The prebaking, which is conducted after spin coating of the photoresist composition, is preferably performed at 60 to 180°C for 10 to 300 seconds. Thereafter, exposure is conducted according to a usual manner, followed by post-exposure baking (PEB) and development, thereby obtaining a resist pattern. Although the thickness of the resist upper layer film is not particularly limited, the thickness is preferably 30 to 500 nm, particularly preferably 50 to 400 nm.

Further, examples of light for exposure include high energy beams at wavelengths of 300 nm or less, specifically excimer lasers at 248 nm, 193 nm, and 157 nm, soft X-rays at 3 to 20 nm, an electron beam, X-rays, and the like.

By using the method described above as the method for forming a circuit pattern in the resist upper layer film described above, it is possible to form fine patterns on the body to be processed with a higher degree of accuracy.

As the method for forming a pattern in the resist upper layer film, a patterning process using a photolithography with a wavelength of 5 nm or more and 300 nm or less, a direct drawing using an electron beam, nanoimprinting, or a combination thereof is preferably used.

The development method in the patterning process is preferably alkaline development or development using an organic solvent. Specifically, it is preferable that, in the patterning process described above, exposure and development be performed to form a circuit pattern in the resist upper layer film, and that the development be alkaline development or development using an organic solvent.

By using alkaline development or development using an organic solvent as the development method, it is possible to form fine patterns on the body to be processed with a higher degree of accuracy.

Next, etching is performed by using the obtained resist pattern as a mask. The etching of a silicon-containing resist middle layer film or an inorganic hard mask in the three-layer resist process is performed while using the upper layer resist pattern as a mask using a fluorocarbon-based gas. In this manner, a silicon-containing resist middle layer film pattern or an inorganic hard mask pattern is formed.

Next, the metal oxide film is etched while using the obtained silicon-containing resist middle layer film pattern or inorganic hard mask pattern as a mask. The etching of the metal oxide film is preferably performed using a chlorine-based gas or an oxygen-based gas.

The subsequent etching of a body to be processed may also be performed according to a usual manner; for example, in the case of a body to be processed made of SiO₂, SiN or silica-based low dielectric constant insulating film, the etching is performed mainly based on a fluorocarbon-based gas. When the substrate is processed by way of etching with a fluorocarbon-based gas, the silicon-containing resist middle layer film pattern in the three-layer resist process is stripped simultaneously with the substrate processing.

The metal oxide film obtained by the composition for forming a metal oxide film of the present invention is characterized by its excellent etching resistance at the time of etching of the body to be processed.

Examples of the body to be processed (substrate to be processed) include, but are not particularly limited to, substrates made of Si, α-Si, p-Si, SiO₂, SiN, SiON, W, TiN, Al, and the like, those in which the layers to be processed are formed on the substrate, and the like. Examples of the layers to be processed include various low-k films such as those made of Si, SiO₂, SiON, SiN, p-Si, α-Si, W, W-Si, Al, Cu, Al-Si, and the like, and stopper films therefor, which can each be typically formed into a thickness of 50 to 10,000 nm, particularly 100 to 5,000 nm. When the layer to be processed is formed, the substrate and the layer to be processed are made of different materials.

The body to be processed is preferably a semiconductor device substrate or those obtained by coating the semiconductor device substrate with any of a metal film, a metal carbide film, a metal oxide film, a metal nitride film, a metal oxycarbide film, and a metal oxynitride film. Specific examples thereof include, but are not limited to, substrates made of Si, α-Si, p-Si, SiO₂, SiN, SiON, W, TiN, or Al, and those on which a metal film described above or the like is formed as the layer to be processed.

Examples of the layers to be processed include various low-k films such as those made of Si, SiO₂, SiON, SiN, p-Si, α-Si, W, W-Si, Al, Cu, Al-Si, and the like, and stopper films therefor, which can each be typically formed into a thickness of 50 to 10,000 nm, particularly 100 to 5,000 nm. When the layer to be processed is formed, the substrate and the layer to be processed are made of different materials.

The metal that constitutes the body to be processed is preferably silicon, titanium, tungsten, hafnium, zirconium, chromium, germanium, copper, silver, gold, aluminum, indium, gallium, arsenic, palladium, iron, tantalum, iridium, cobalt, manganese, molybdenum, ruthenium, or an alloy of these.

These can be used as the metal described above. As described above, by performing the patterning using the composition for forming a metal oxide film of the present invention, it is possible to transfer and form the pattern of the upper layer photoresist to the body to be processed with a high degree of accuracy.

In the patterning process of the present invention, a substrate to be processed having a step or a structure with a height of 30 nm or more is preferably used. As described above, the composition for forming a metal oxide film of the present invention has excellent filling and planarizing properties. Thus, even when the substrate to be processed has a step (irregularities) or a structure with a height of 30 nm or more, a flat cured film can be formed. The height of the structure or the step of the substrate to be processed is preferably 30 nm or more, more preferably 50 nm or more, and still more preferably 100 nm or more. In the method of processing a stepped substrate having a pattern with the above-described height, by performing filling and planarization by forming a film from the composition for forming a metal oxide film of the present invention, it is possible to unify the film thickness of the resist middle layer film and the resist upper layer film that are subsequently formed, and thus it is easy to ensure the exposure depth margin (depth of focus: DOF) at the time of photolithography, which is very preferable.

Further, the present invention provides, as a tone-reversal patterning process using such a composition for forming a metal oxide film, a patterning process for forming a pattern in a substrate to be processed, the process comprising the steps of:
(IV-1) forming a resist underlayer film on a substrate to be processed;
(IV-2) forming a resist middle layer film, or a combination of an inorganic hard mask middle layer film selected from a silicon oxide film, a silicon nitride film, and a silicon oxynitride film and an organic thin film on the resist underlayer film;
(IV-3) forming a resist upper layer film on the resist middle layer film, or the combination of the inorganic hard mask middle layer film and the organic thin film by using a photoresist material;
(IV-4) subjecting the resist upper layer film to pattern exposure and then development with a developer to form a pattern in the resist upper layer film;
(IV-5) transferring a pattern to the resist middle layer film or the organic thin film and the inorganic hard mask middle layer film by dry etching while using the resist upper layer film having the formed pattern as a mask;
(IV-6) transferring a pattern to the resist underlayer film by dry etching while using the resist middle layer film or the inorganic hard mask middle layer film having the transferred pattern as a mask;
(IV-7) applying the composition for forming a metal oxide film onto the resist underlayer film having the formed pattern, followed by heating to cover the resist underlayer film with a metal oxide film, thereby filling a space between the resist underlayer film patterns with the metal oxide film;
(IV-8) etching back the metal oxide film covering the resist underlayer film having the formed pattern by a chemical stripper or dry etching to uncover an upper surface of the resist underlayer film having the formed pattern;
(IV-9) removing the resist middle layer film or the hard mask middle layer film remaining on the upper surface of the resist underlayer film by dry etching;
(IV-10) removing the resist underlayer film having the formed pattern with its surface uncovered by dry etching to form a reverse pattern of an original pattern in the metal oxide film; and
(IV-11) processing the substrate to be processed while using the metal oxide film having the formed reverse pattern as a mask to form a reversal pattern (tone-reversal pattern) in the substrate to be processed.

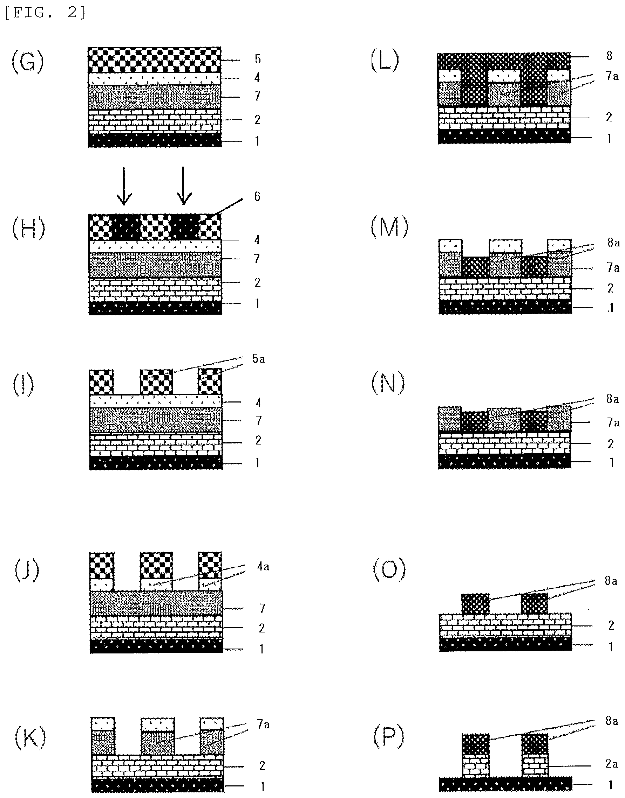

An example of formation of a tone-reversal pattern is specifically explained below by referring to FIG. 2. As shown in FIG. 2(G), a resist underlayer film 7 formed from a coating-type organic underlayer film material is formed on a layer to be processed 2 stacked on a substrate to be processed 1; thereafter, a silicon atom-containing resist middle layer film 4 is formed, and a resist upper layer film 5 is further formed thereon.

Next, as shown in FIG. 2(H), exposure is conducted for required portion (exposure portion) 6 of the resist upper layer film 5, followed by PEB and development, to form a resist upper layer film pattern 5a (FIG. 2(I)). The obtained resist upper layer film pattern 5a is then used as a mask to etch the silicon atom-containing resist middle layer film 4 using a CF-based gas to form a silicon atom-containing resist middle layer film pattern 4a (FIG. 2(J)). After removing the resist upper layer film pattern 5a, oxygen plasma etching of the resist underlayer film 7 formed from a coating-type organic underlayer film material is performed while using the obtained silicon atom-containing resist middle layer film pattern 4a as a mask to form a resist underlayer film pattern 7a formed of a coating-type organic underlayer film material (FIG. 2(K)).

After applying the composition for forming a metal oxide film of the present invention onto the resist underlayer film pattern 7a formed of a coating-type organic underlayer film material, followed by heating to cover the resist underlayer film pattern 7a with a metal oxide film 8, thereby filling a space between the resist underlayer film patterns 7a formed of a coating-type organic underlayer film material with the metal oxide film (FIG. 2(L)). Then, the metal oxide film 8 covering the resist underlayer film pattern 7a formed of a coating-type organic underlayer film material is etched back by a chemical stripper or dry etching, thereby uncovering an upper surface of the resist underlayer film pattern 7a formed of a coating-type organic underlayer film material (FIG. 2(M)). Further, the silicon atom-containing resist middle layer film pattern 4a remaining on the upper surface of the resist underlayer film pattern 7a formed of a coating-type organic underlayer film material is removed by dry etching (FIG. 2(N)). Subsequently, the resist underlayer film pattern 7a formed of a coating-type organic underlayer film material is removed by dry etching to form a reverse pattern of the original pattern in the metal oxide film (form a metal oxide film pattern 8a as a reverse pattern of the resist underlayer film pattern) (FIG. 2(O)); after this step, the substrate to be processed is processed while using the metal oxide film pattern 8a having a reverse pattern of the resist underlayer film pattern as a mask to form a tone-reversal pattern in the substrate to be processed (FIG. 2(P)).

As described above, when the resist underlayer film is formed on the substrate to be processed, the resist underlayer film can be formed by a method using a coating-type organic underlayer film material, a CVD method, an ALD method, or the like. Examples of the coating-type organic underlayer film material include resins and compositions disclosed in Japanese Patent Laid-Open Publication No. JP2012-1687, Japanese Patent Laid-Open Publication No. JP2012-77295, Japanese Patent Laid-Open Publication No. JP2004-264710, Japanese Patent Laid-Open Publication No. JP2005-043471, Japanese Patent Laid-Open Publication No. JP2005-250434, Japanese Patent Laid-Open Publication No. JP2007-293294, Japanese Patent Laid-Open Publication No. JP2008-65303, Japanese Patent Laid-Open Publication No. JP2004-205685, Japanese Patent Laid-Open Publication No. JP2007-171895, Japanese Patent Laid-Open Publication No. JP2009-14816, Japanese Patent Laid-Open Publication No. JP2007-199653, Japanese Patent Laid-Open Publication No. JP2008-274250, Japanese Patent Laid-Open Publication No. JP2010-122656, Japanese Patent Laid-Open Publication No. JP2012-214720, Japanese Patent Laid-Open Publication No. JP2014-29435, International Publication No. WO2012/077640, International Publication No. WO2010/147155, International Publication No. WO2010/147155, International Publication No. WO2012/176767, Japanese Patent Laid-Open Publication No. JP2005-128509, Japanese Patent Laid-Open Publication No. JP2006-259249, Japanese Patent Laid-Open Publication No. JP2006-259482, Japanese Patent Laid-Open Publication No. JP2006-293298, Japanese Patent Laid-Open Publication No. JP2007-316282, Japanese Patent Laid-Open Publication No. JP2012-145897, Japanese Patent Laid-Open Publication No. JP2017-119671, Japanese Patent Laid-Open Publication No. JP2019-44022, and the like.

In the tone-reversal patterning process, after the obtained resist underlayer film pattern is coated with the composition for forming a metal oxide film, it is preferable to remove the metal oxide film by dry etching using a chlorine-based gas or an oxygen-based gas so as to uncover the upper surface of the resist underlayer film pattern. Thereafter, the resist middle layer film or the hard mask middle layer film remaining on the resist underlayer film is removed by dry etching using a fluorocarbon-based gas, and the resist underlayer film pattern having an uncovered surface is removed by dry etching using an oxygen-based gas to form a metal oxide film pattern.

In the tone-reversal patterning process described above, the resist underlayer film pattern preferably has a step or a structure with a height of 30 nm or more. As described above, the composition for forming a metal oxide film of the present invention has excellent filling and planarizing properties. Thus, even when the film to be processed has a step (irregularities) or a structure with a height of 30 nm or more, a flat cured film can be formed. The height of the structure or the step of the resist underlayer film pattern is preferably 30 nm or more, more preferably 50 nm or more, and still more preferably 100 nm or more. In the method of reversing the resist underlayer film pattern having a pattern with the above-described height, by performing filling and planarization by forming a film from the composition for forming a metal oxide film of the present invention, inversion/transfer of the pattern can be performed with a high degree of accuracy, which is very preferable. Reversing the resist underlayer film pattern using the composition for forming a metal oxide film provides an advantage that a desired resist pattern can be formed on a film to be processed with a high degree of accuracy due to the excellence in resistance in dry etching using a fluorocarbon-based gas relative to the resist underlayer film using a previously-known coating-type organic underlayer film material.

### Metal Oxide Film Forming Method

The present invention provides a method for forming a metal oxide film serving as a resist underlayer film of a multilayer resist film used in lithography or as a filling film to act as a planarizing film (organic planarizing film) used for the manufacture of semiconductor, using the composition for forming a metal oxide film described above.

More specifically, the present invention provides a method for forming a metal oxide film to act as a planarizing film used in a semiconductor device production process, the method comprising applying the composition for forming a metal oxide film described above onto a substrate to be processed, followed by heating at a temperature of 100°C or more and 600°C or less for 10 to 600 seconds to form a cured film.

Further, the present invention also provides a method for forming a metal oxide film to act as a planarizing film used in a semiconductor device production process, the method comprising applying the composition for forming a metal oxide film onto a substrate to be processed, followed by heating under an atmosphere having an oxygen concentration of 0.1 volume % or more and 21 volume % or less to form a cured film.

Further, the present invention also provides a method for forming a metal oxide film to act as a planarizing film used in a semiconductor device production process, the method comprising applying the composition for forming a metal oxide film onto a substrate to be processed, followed by heating in an atmosphere having an oxygen concentration of less than 0.1 volume % to form a cured film.

In the method for forming a metal oxide film using the composition for forming a metal oxide film of the present invention, the substrate to be processed is coated with the composition for forming a metal oxide film described above by spin coating or the like. Using the spin coating or the like ensures a desirable filling property. After spin coating, baking (heat treatment) is performed so as to evaporate the solvent, and promote a crosslinking reaction to prevent mixing with the resist upper layer film and the resist middle layer film. The baking is preferably performed at a temperature of 100°C or more and 600°C or less for 10 to 600 seconds, more preferably at a temperature of 200°C or more and 500°C or less for 10 to 300 seconds. In consideration of influences on device damage, wafer deformation, and the like, the upper limit of the heating temperature in the wafer process of lithography is preferably 600°C or less, and more preferably 500°C or less.

In the metal oxide film forming method using the composition for forming a metal oxide film of the present invention, a substrate to be processed may also be coated with the composition for forming a metal oxide film of the present invention by spin coating or the like in the same manner as described above, and then the composition for forming a metal oxide film may be baked and cured under an atmosphere with an oxygen concentration of 0.1 volume % or more and 21 volume % or less to form a metal oxide film.

By baking the composition for forming a metal oxide film of the present invention in such an oxygen atmosphere, a sufficiently cured film can be obtained. The atmosphere during baking may be air; however, to prevent oxidation of the metal oxide film, it is preferable to enclose an inert gas, such as N₂, Ar, or He, therein to reduce the amount of oxygen. Control of oxygen concentration is necessary to prevent oxidation; the oxygen concentration is preferably 1000 ppm or less, more preferably 100 ppm or less (volumetric basis). By thus preventing oxidation of the metal oxide film during the baking, the absorption does not increase and the etching resistance does not decrease, which is preferable.

### EXAMPLES

The present invention is more specifically described below with reference to Production Examples, Comparative Production Examples, Synthesis Examples, Comparative Synthesis Examples, Examples, and Comparative Examples. However, the present invention is not limited to these Examples. To determine molecular weight and dispersity, weight average molecular weight (Mw) and number average molecular weight (Mn) on polystyrene basis were measured by gel permeation chromatography (GPC) using tetrahydrofuran as an eluent, and dispersity (Mw/Mn) was calculated from these values. The weight reduction rate in the range from 30°C to 350°C was determined by TG (thermogravimetric) measurement using a differential thermal balance under a temperature increase of 10°C/min in an air-like atmosphere (with 20 volume % of oxygen and 80 volume % of nitrogen).

### Synthesis Example of Organic Source (II)

The starting material group G: (G1) to (G10) and the modifying agents H: (H1) to (H3) shown below were used in the synthesis example of the organic source (II) .

The starting material group G: (G1) to (G10) are shown below.

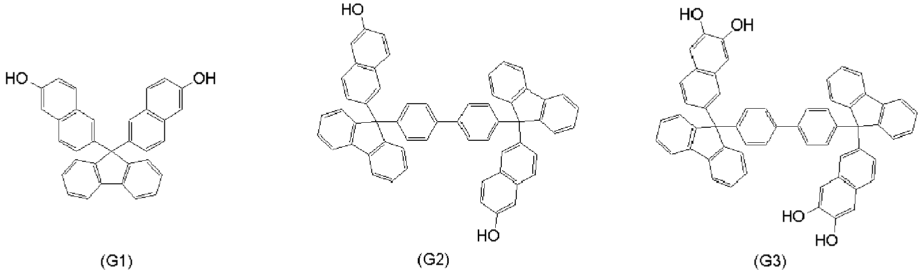

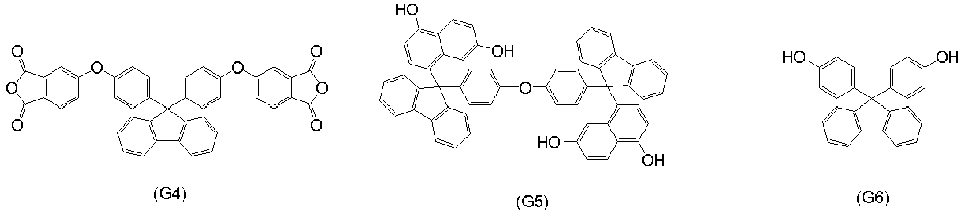

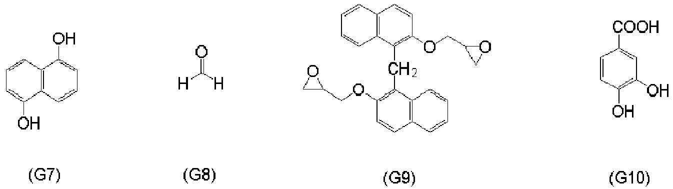

The modifying agent group H: (H1) to (H3) are shown below.

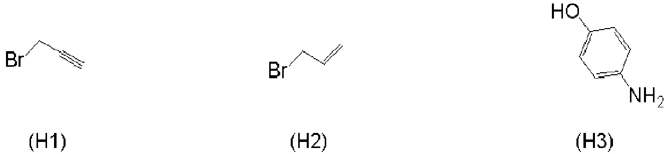

### Synthesis Example 1: Synthesis of Organic Source (B-4)

100 g of N-methylpyrrolidone was added to 30.00 g of tetracarboxylic acid anhydride (G4), and a homogeneous solution was obtained at an internal temperature of 40°C in an atmosphere of nitrogen; thereafter, 10.20 g of the amine compound (H3) was added, followed by a reaction at an internal temperature of 40°C for 3 hours, thereby obtaining an amide acid solution. 200 g of o-xylene was added to the obtained amide acid solution, and the mixture was reacted at an internal temperature of 150°C for 9 hours while removing the produced low-boiling substance and water from the system, thereby performing dehydrating imidation. The mixture was cooled to room temperature after completion of the reaction and a crystal was precipitated by 1,000 g of methanol. The precipitated crystal was separated by filtration, washed twice with 500 g of methanol, and collected. The collected crystal was vacuum-dried at 70°C, thereby obtaining an organic source (B-4).

The weight average molecular weight (Mw) and the dispersity (Mw/Mn) were determined by GPC, and the following results were obtained.
(B-4): Mw = 901, Mw/Mn = 1.01

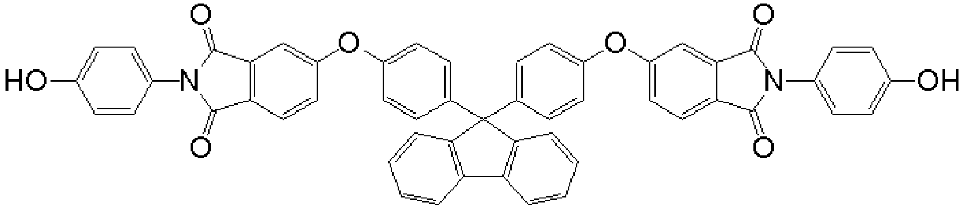

### Synthesis Example 2: Synthesis of Organic Source (B-5)

In an atmosphere of nitrogen, 46.9 g of the compound (G2), 10.1 g of potassium carbonate, and 150 g of DMF were added, and a homogeneous dispersion liquid was prepared at an internal temperature of 50°C. 9.0 g of the modifying agent (H1) was slowly added, followed by a reaction at an internal temperature of 50°C for 24 hours. 300 ml of methylisobutylketone and 300 g of pure water were added to the reaction liquid to dissolve the precipitated salts; thereafter, the separated water layer was removed. Further, the organic layer was washed with 100 g of a 3% aqueous nitric acid solution and 100 g of pure water six times, and then the organic layer was dried up under reduced pressure to hardness, thereby obtaining an organic source (B-5).

The weight average molecular weight (Mw) and the dispersity (Mw/Mn) were determined by GPC, and the following results were obtained.
(B-5): Mw = 903, Mw/Mn = 1.08

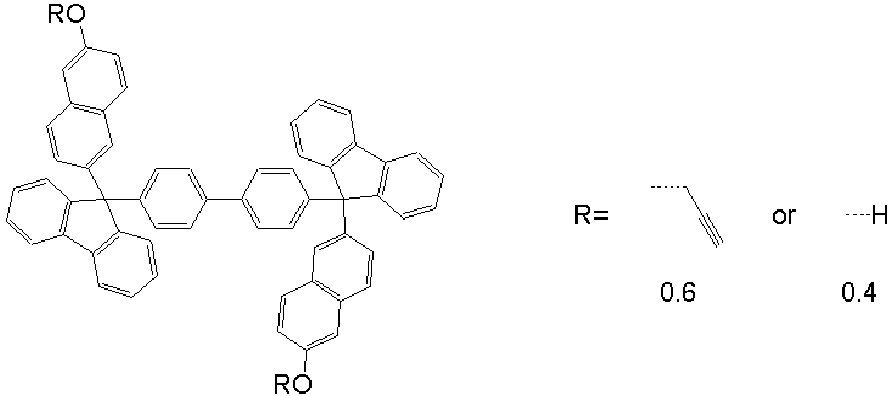

### Synthesis Example 3: Synthesis of Organic Source (B-6)

In an atmosphere of nitrogen, 45.7 g of the compound (G5) in the starting material group, 9.3 g of potassium carbonate, and 150 g of DMF were added, and a homogeneous dispersion liquid was prepared at an internal temperature of 50°C. 13.4 g of the modifying agent (H1) was slowly added, followed by a reaction at an internal temperature of 50°C for 24 hours. 300 ml of methylisobutylketone and 300 g of pure water were added to the reaction liquid to dissolve the precipitated salts; thereafter, the separated water layer was removed. Further, the organic layer was washed with 100 g of a 3% aqueous nitric acid solution and 100 g of pure water six times, and then the organic layer was dried up under reduced pressure to hardness, thereby obtaining an organic source (B-6).

The weight average molecular weight (Mw) and the dispersity (Mw/Mn) were determined by GPC, and the following results were obtained.
(B-6): Mw = 1050, Mw/Mn = 1.02

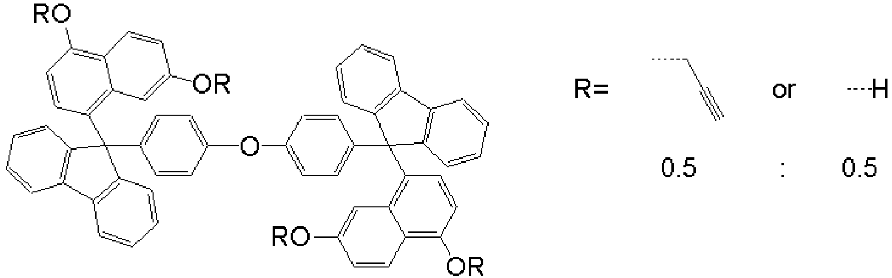

### Synthesis Example 4: Synthesis of Organic Source (B-7)

In an atmosphere of nitrogen, 44.7 g of the compound (G1), 16.5 g of potassium carbonate, and 150 g of DMF were added, and a homogeneous dispersion liquid was prepared at an internal temperature of 50°C. 16.5 g of the modifying agent (H2) was slowly added, followed by a reaction at an internal temperature of 50°C for 24 hours. 300 ml of methylisobutylketone and 300 g of pure water were added to the reaction liquid to dissolve the precipitated salts; thereafter, the separated water layer was removed. Further, the organic layer was washed with 100 g of a 3% aqueous nitric acid solution and 100 g of pure water six times, and then the organic layer was dried up under reduced pressure to hardness, thereby obtaining an organic source (B-7).

The weight average molecular weight (Mw) and the dispersity (Mw/Mn) were determined by GPC, and the following results were obtained.
(B-7): Mw = 540, Mw/Mn = 1.03

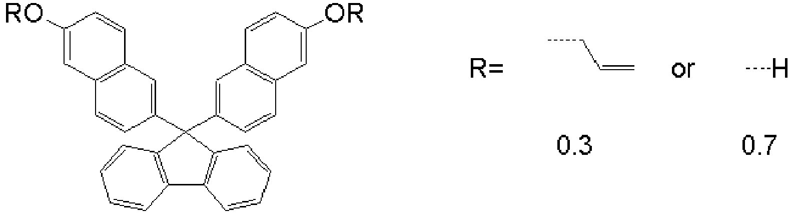

### Comparative Synthesis Example 1: Synthesis of Comparative Organic Source (R-1)

In an atmosphere of nitrogen, 45.5 g of the compound (G2), 9.8 g of potassium carbonate, and 150 g of DMF were added, and a homogeneous dispersion liquid was prepared at an internal temperature of 50°C. 17.6 g of the modifying agent (H1) was slowly added, followed by a reaction at an internal temperature of 50°C for 24 hours. 300 ml of methylisobutylketone and 300 g of pure water were added to the reaction liquid to dissolve the precipitated salts; thereafter, the separated water layer was removed. Further, the organic layer was washed with 100 g of a 3% aqueous nitric acid solution and 100 g of pure water six times, and then the organic layer was dried up under reduced pressure to hardness, thereby obtaining a comparative organic source (R-1).

The weight average molecular weight (Mw) and the dispersity (Mw/Mn) were determined by GPC, and the following results were obtained.
(R-1): Mw = 965, Mw/Mn = 1.08

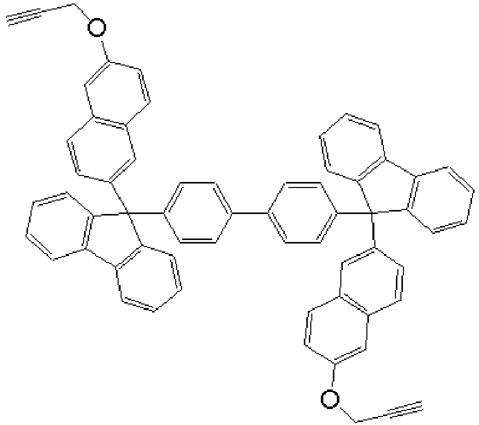

### Comparative Synthesis Example 2: Synthesis of Comparative Organic Source (R-2)

200 g of the compound (G6) in the starting material group, 75 g of 37% aqueous formalin (G8) solution, and 5 g of oxalic acid were added to a 300 ml flask, followed by stirring at 100°C for 24 hours. After the reaction, the mixture was dissolved in 500 ml of methylisobutylketone, and then washed thoroughly by water to remove a catalyst and metallic impurities. The solvent was removed under reduced pressure, and then water and unreacted monomers were removed by reducing the pressure to 2 mmHg, at 150°C, thereby obtaining a comparative organic source (R-2).

The weight average molecular weight (Mw) and the dispersity (Mw/Mn) were determined by GPC, and the following results were obtained.
(R-2): Mw = 6,500, Mw/Mn = 5.20

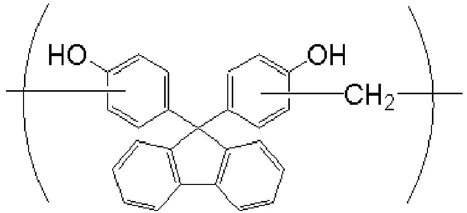

### Comparative Synthesis Example 3: Synthesis of Comparative Organic Source (R-3)

In an atmosphere of nitrogen, 160.2 g of the resin starting material (G7), 56.8 g of the resin starting material (G8), and 300 g of PGME (propylene glycol monomethyl ether) were added, followed by homogenization at an internal temperature of 100°C. Thereafter, a mixture obtained by mixing and homogenizing 8.0 g of paratoluenesulfonic acid monohydrate and 8.0 g of PGME in advance was slowly added dropwise, followed by a reaction at an internal temperature of 80°C for 8 hours. After completion of the reaction, the mixture was cooled to room temperature, 2,000 ml of MIBK was added thereto, followed by washing six times with 500 ml of pure water, and the organic layer was dried up under reduced pressure to hardness. 300 g of THF was added to the residue to yield a homogeneous solution, and a crystal was precipitated by 2,000 g of hexane. The precipitated crystal was separated by filtration, washed twice with 500 g of hexane, and collected. The collected crystal was vacuum-dried at 70°C, thereby obtaining a resin comparative organic source (R-3).

The weight average molecular weight (Mw) and the dispersity (Mw/Mn) were determined by GPC, and the following results were obtained.
(R-3): Mw = 3,300, Mw/Mn = 2.54

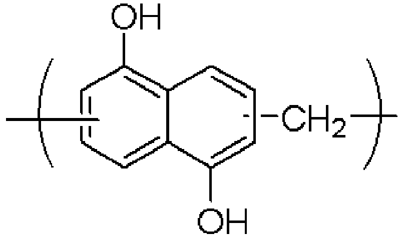

### Comparative Synthesis Example 4: Synthesis of Comparative Organic Source (R-4)

In an atmosphere of nitrogen, 57.2 g of the epoxy compound (G9), 42.8 g of the carboxylic acid compound (G10), and 300 g of 2-methoxy-1-propanol were mixed at a liquid temperature of 100°C to yield a homogeneous solution, and then 10.0 g of benzyltriethylammonium chloride was added thereto, followed by stirring at a liquid temperature of 120°C for 12 hours. After cooling to room temperature, 1,000 g of methylisobutylketone was added and the organic layer was washed with 200 g of pure water five times. The organic layer was dried up under reduced pressure to hardness to obtain a comparative organic source (R-4).

The weight average molecular weight (Mw) and the dispersity (Mw/Mn) were determined by GPC, and the following results were obtained.
(R-4): Mw = 780, Mw/Mn = 1.04

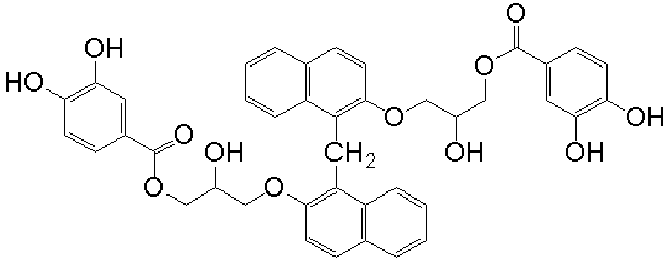

Tables 1 and 2 show the structure, the weight average molecular weight (Mw) and the dispersity (Mw/Mn) of the obtained organic source (II). The compound (G1) in the starting material group G used as the starting material in the above Synthesis Example was used for the organic source (B-1), the compound (G2) in the starting material group G was used for the organic source (B-2), and the compound (G3) in the starting material group G was used for the organic source (B-3).

**Table 1**

| **Synthesis Example** | **Organic Source** | **Mw** | **Mw/Mn** |
|---|---|---|---|
| **1** | 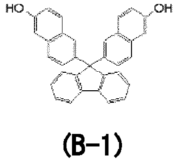 | **480** | **1.02** |
| **2** | 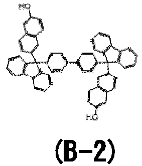 | **801** | **1.07** |
| **3** | 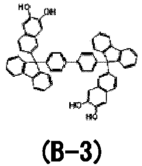 | **1033** | **1.09** |
| **4** | 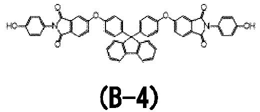 | **901** | **1.01** |
| **5** | 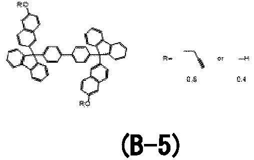 | **903** | **1.08** |
| **6** | 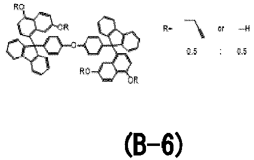 | **1050** | **1.02** |
| **7** | 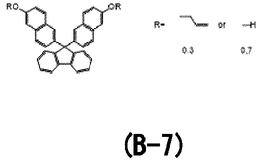 | **540** | **1.03** |

**Table 2**

| **Synthesis Example** | **Comparative Organic Source** | **Mw** | **Mw/Mn** |
|---|---|---|---|
| **8** | 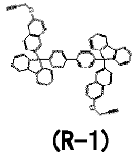 | **965** | **1.08** |
| **9** | 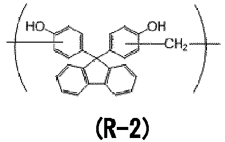 | **6500** | **5.20** |
| **10** | 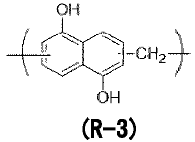 | **3300** | **2.54** |
| **11** | 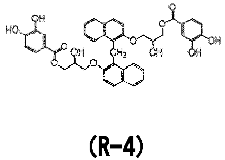 | **780** | **1.04** |

### Production of Organic-Inorganic Composite Material

### Production Example 1: Production of organic-inorganic composite material (M-1)

In a reaction container, 1.4 g of the organic source (B-1) was dissolved in 23 g of PGMEA, and 3.2 g of acetic acid was slowly added dropwise to this solution, followed by stirring at 25°C for 30 minutes. Then, a solution obtained by diluting 6 g of titanium(IV)tetrabutoxide, which is the metal source, with 24 g of 1-butanol was slowly added dropwise, followed by stirring at 25°C for 30 minutes. The condensation reaction was completed, followed by concentration and removal at 30°C under reduced pressure. The resulting reaction liquid was then filtered through a 0.45 um PTFE filter to obtain a PGMEA solution of an organic-inorganic composite material (M-1). The concentration of the components other than the solvent in the solution was 5.2% by mass.

### Production Examples 2 to 11, Comparative Production

### Examples 1 to 4: Productions of Organic-Inorganic Composite Materials (M-2 to M-11) and Comparative Organic-Inorganic Composite Materials (Comparative Examples M-1 to M-4)

The organic-inorganic composite materials (M-2 to M-11) and the comparative organic-inorganic composite materials (Comparative Examples M-1 to M-4) shown in Table 3 were obtained under the same reaction condition as that in Production Example 1, except that the organic source and the metal source were used in the amounts shown in Table 3.

The following metal compounds were used as the inorganic source in Table 3. Note that (OBu) is an n-butoxy group.
Ti(OBu)₄: Tetrabutyl Orthotitanate (Tokyo Chemical Industry Co., Ltd., B0742)
Zr(OBu)_{4:} Zirconium(IV)Tetrabutoxide (80 wt% 1-butanol solution) (Tokyo Chemical Industry Co., Ltd., Z0016)
Hf(OBu)₄: Hafnium(IV)n-butoxide (Sigma-Aldrich Corp, 667943)

**Table 3**

| Organic-Inorganic Composite Material | Organic Source | Inorganic Source | Acetic Acid | Organic Solvent | Concentration of Organic-Inorganic Composite Material in Solvent |
|---|---|---|---|---|---|
| | part by mass | part by mass | part by mass | part by mass | % by mass |
| M-1 | B-1 (1.4) | Ti(0Bu)4(6.0) | 3.2 | PGMEA (23) | 5.2 |
| M-2 | B-2 (2.4) | Ti(0Bu)4(6.0) | 3.2 | PGMEA (40) | 5.4 |
| M-3 | B-3 (3.0) | Ti(0Bu)4(6.0) | 3.2 | PGMEA (50) | 5.2 |
| M-4 | B-4 (2.7) | Ti(0Bu)4(6.0) | 3.2 | PGMEA (45) | 5.3 |
| M-5 | B-5 (2.7) | Ti(0Bu)4(6.0) | 3.2 | PGMEA (45) | 5.3 |
| M-6 | B-6 (3.1) | Ti(0Bu)4(6.0) | 3.2 | PGMEA (50) | 5.2 |
| M-7 | B-7 (1.4) | Zr(0Bu)4(6.0) | 2.8 | PGMEA (25) | 5.1 |
| M-8 | B-2 (1.7) | Hf(0Bu)4(6.0) | 2.3 | PGMEA (30) | 5.1 |
| M-9 | B-1 (1.4) | Ti(0Bu)4(8.0) | 4.2 | PGMEA (25) | 5.1 |
| M-10 | B-1 (1.4) | Ti(0Bu)4(4.0) | 2.1 | PGMEA (23) | 5.3 |
| M-11 | B-1 (0.8) | Zr(0Bu)4(6.0) | 2.8 | PGMEA (27) | 5.4 |
| | R-1 (0.8) | | | | |
| Comparative Example M-1 | R-1 (2.8) | Ti(0Bu)4(6.0) | 3.2 | PGMEA (45) | 5.4 |
| Comparative Example M-2 | R-2 (16.9) | Zr(0Bu)4(6.0) | 2.8 | PGMEA (280) | 5.2 |
| Comparative Example M-3 | R-3 (8.6) | Zr(0Bu)4(6.0) | 2.8 | PGMEA (150) | 5.1 |
| Comparative Example M-4 | R-4 (2.0) | Zr(0Bu)4(6.0) | 2.8 | PGMEA (35) | 5.1 |

### Synthesis of Comparative Metal Compound (Comparative

### Example MA-1)

The comparative metal compound (Comparative Example MA-1) was synthesized in the following manner by referring to "Synthesis Example A-II" in Patent Document 5.

A mixture of 2.7 g of pure water and 50 g of isopropyl alcohol was added dropwise to a mixture of 32.7 g of zirconium tetraisopropoxide, 50 g of isopropyl alcohol, and 50 g of acetylacetone. After completion of the dropwise addition, the mixture was stirred for 2 hours for hydrolysis condensation, followed by reflux for another 2 hours. 200 g of PGMEA was added thereto, followed by concentration under reduced pressure to obtain 250 g of PGMEA solution of zirconium-containing compound (Comparative Example MA-1).

### Synthesis of Comparative Metal Compound (Comparative

### Example MA-2)

The comparative metal compound (Comparative Example MA-2) was synthesized in the following manner by referring to "Metal Complex Synthesis Example 3" in Patent Document 4.

16.7 g of zirconium(IV)tetrabutoxide (80% in n-butanol) was dissolved in 20.6 g of PGMEA/PGME (70/30 v/v) and the mixture was poured into a reaction container under N₂. While stirring the mixture, the temperature was increased to 50°C, and 6.5 g of trimethylsilanol was added dropwise. After completion of the dropwise addition, the mixture was stirred at 60°C for 2 hours. Then, 8.6 g of 1,2-cyclohexanedicarboxylic acid anhydride and 8.6 g of PGMEA/PGME (70/30 v/v) were mixed with the above reaction mixture, and the reaction was continued at 60°C for about 1 hour. After cooling to room temperature, a PGMEA/PGME solution of a zirconium-containing compound (Comparative Example MA-2) was obtained.

### Comparative Metal Compound (Comparative Example MA-3)

Tetrabutyl orthotitanate was used for the comparative metal compound (Comparative Example MA-3).

### Metal Oxide Nanoparticle (m1)

ZrO₂ nanoparticles (5 nm core, 915505, Sigma-Aldrich Corp) were used as the metal oxide nanoparticles (m1) used for the composition for forming a metal oxide film.

### Flowability Accelerator

C-1: Compound represented by the following formula (C-1)
C-2: Compound represented by the following formula (C-2)
C-3: Compound represented by the following formula (C-3)

**Table 4**

| **Flowability Accelerator** | **Mw (Calculated Value)** | **Weight Reduction Rate (%) from 30° C to 190° C** | **Weight Reduction Rate (%) from 30° C to 350° C** |
|---|---|---|---|
| 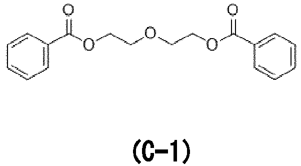 | **314** | **1** | **100** |
| 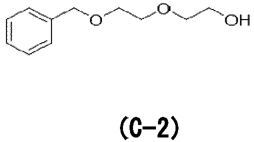 | **196** | **26** | **99** |
| 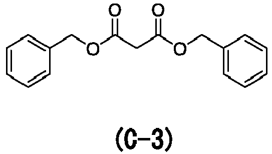 | **284** | **3** | **99** |

### Crosslinking Agent

The crosslinking agent (XL-1) used in the composition for forming a metal oxide film is shown below.

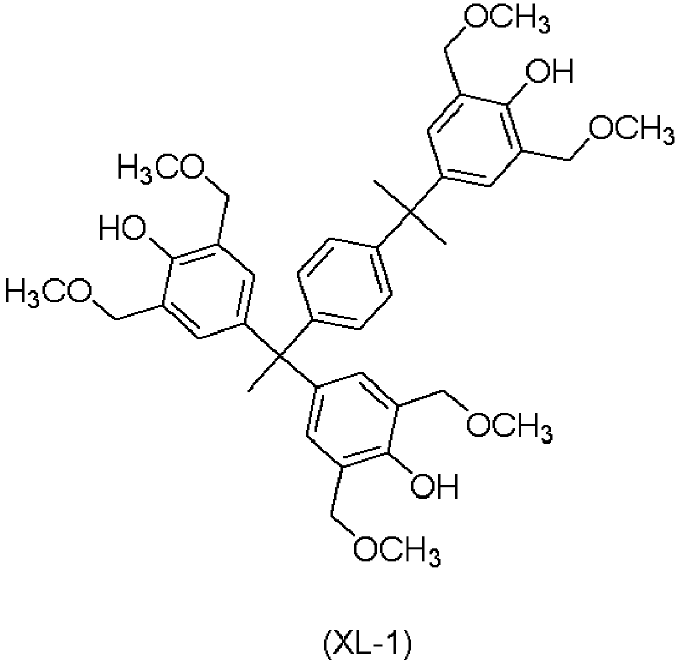

### Acid Generator

The compound represented by the following formula (F-1) was used as the acid generator (TAG).

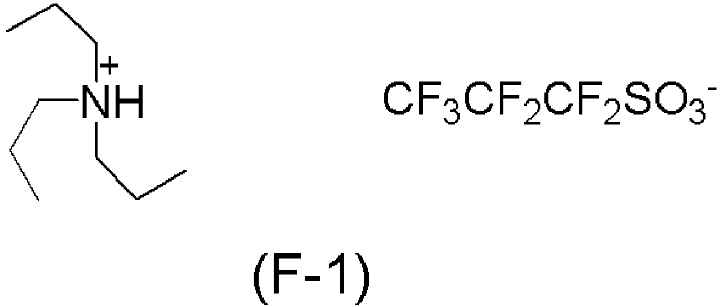

### Composition for Forming Metal Oxide Film UL-1

The above organic-inorganic composite material (M-1) and propylene glycol monomethyl ether acetate (PGMEA) containing 0.5% by mass of surfactant FC-4430 (Sumitomo 3M Limited) were mixed according to the formulation shown in Table 5, followed by filtration through a 0.02 um membrane filter to prepare a composition for forming a metal oxide film (UL-1).

### Compositions for Forming Metal Oxide Film UL-2 to 14 and Comparative Examples UL-1 to 9

Each chemical liquid was prepared in the same manner as that for UL-1, except that the type and the content of each component were as shown in Table 5. In Table 5, "-" indicates that the component was not used.

**Table 5**

| **Composition for Forming Metal Oxide Film** | **Organic-Inorganic Composite Material** | **Additive** | **Solvent** |
|---|---|---|---|
| | **(part by mass)** | **(part by mass)** | **(part by mass)** |
| **UL-1** | **M-1 (100)** | **-** | **PGMEA (1900)** |
| **UL-2** | **M-2 (100)** | **-** | **PGMEA (1900)** |
| **UL-3** | **M-3 (100)** | **-** | **PGMEA (1900)** |
| **UL-4** | **M-4 (100)** | **XL-1 (10)** | **PGMEA (1900)** |
| | | **F-1 (2)** | |
| **UL-5** | **M-5 (100)** | **-** | **PGMEA (1900)** |
| **UL-6** | **M-6 (100)** | **-** | **PGMEA (1900)** |
| **UL-7** | **M-7 (100)** | **-** | **PGMEA (1900)** |
| **UL-8** | **M-8 (100)** | **-** | **PGMEA (1900)** |
| **UL-9** | **M-9 (100)** | **-** | **PGMEA (1900)** |
| **UL-10** | **M-10 (100)** | **-** | **PGMEA (1900)** |
| **UL-11** | **M-11 (100)** | **m1 (10)** | **PGMEA (1900)** |
| **UL-12** | **M-2 (100)** | **C-1 (10)** | **PGMEA (1900)** |
| **UL-13** | **M-7 (100)** | **C-2 (10)** | **PGMEA (1900)** |
| **UL-14** | **M-8 (100)** | **C-3 (10)** | **PGMEA (1900)** |
| **Comparative Example UL-1** | **Comparative Example M-1 (100)** | **-** | **PGMEA (1900)** |
| **Comparative Example UL-2** | **Comparative Example M-2 (100)** | **-** | **PGMEA (1900)** |
| **Comparative Example UL-3** | **Comparative Example M-3 (100)** | **-** | **PGMEA (1900)** |
| **Comparative Example UL-4** | **Comparative Example M-4 (100)** | **-** | **PGMEA (1900)** |
| **Comparative Example UL-5** | **Comparative Example MA-1 (100)** | **-** | **PGMEA (1900)** |
| **Comparative Example UL-6** | **Comparative Example** | **-** | **PGMEA (1900)** |
| | **MA-1 (50)** | | |
| | **R-1 (50)** | | |
| **Comparative Example UL-7** | **Comparative Example** | **-** | **PGMEA/PGME (1330/570)** |
| | **MA-2 (50)** | | |
| | **R-1 (50)** | | |
| **Comparative Example UL-8** | **Comparative Example** | **-** | **PGMEA (1900)** |
| | **MA-3 (50)** | | |
| | **R-1 (50)** | | |
| **Comparative Example UL-9** | **B-1 (100)** | **-** | **PGMEA (1900)** |

### Examples 1-1 to 1-14 and Comparative Examples 1-1 to 1-8 Evaluation of Film Forming Property

Each of the above compositions for forming a metal oxide film (UL-1 to 14 and Comparative Examples UL-1 to 8) was applied onto a SiO₂ wafer substrate, followed by heating at 350°C for 60 seconds in the atmosphere using a hotplate to form a metal oxide film having a thickness of 100 nm. The obtained metal oxide film was observed using an optical microscope to confirm film forming property. The case of confirming a mirror-like film without any defects in film forming property was evaluated as "desirable", and the case of observing cracks, wrinkles, pinholes, striations, or other defects in the metal oxide film was evaluated as "poor". Table 6 shows the results.

**Table 6**

| **Example** | **Composition for Forming Metal Oxide Film** | **Film Forming Property** |
|---|---|---|
| Example 1-1 | UL-1 | Desirable |
| Example 1-2 | UL-2 | Desirable |
| Example 1-3 | UL-3 | Desirable |
| Example 1-4 | UL-4 | Desirable |
| Example 1-5 | UL-5 | Desirable |
| Example 1-8 | UL-6 | Desirable |
| Example 1-7 | UL-7 | Desirable |
| Example 1-8 | UL-8 | Desirable |
| Example 1-9 | UL-9 | Desirable |
| Example 1-10 | UL-10 | Desirable |
| Example 1-11 | UL-11 | Desirable |
| Example 1-12 | UL-12 | Desirable |
| Example 1-13 | UL-13 | Desirable |
| Example 1-14 | UL-14 | Desirable |
| Comparative Example 1-1 | Comparative Example UL-1 | Poor |
| Comparative Example 1-2 | Comparative Example UL-2 | Desirable |
| Comparative Example 1-3 | Comparative Example UL-3 | Desirable |
| Comparative Example 1-4 | Comparative Example UL-4 | Desirable |
| Comparative Example 1-5 | Comparative Example UL-5 | Desirable |
| Comparative Example 1-6 | Comparative Example UL-8 | Poor |
| Comparative Example 1-7 | Comparative Example UL-7 | Poor |
| Comparative Example 1-8 | Comparative Example UL-8 | Poor |

As shown in Table 6, the results showing good film forming properties of the compositions for forming a metal oxide film (UL-1 to 14) of the present invention were obtained. Among them, the composition (UL-11) obtained by mixing metal oxide nanoparticles (m1) with the organic-inorganic composite material had good film forming property. In the state of the organic-inorganic composite material, the reactivity of the metal compound is controlled; therefore, it is considered that the metal oxide nanoparticles are desirably dispersed in the composition without causing film forming defects derived from the aggregation of each component.

In contrast, in Comparative Example UL-1 obtained by using a product (Comparative Example M-1) resulting from a reaction with the organic source (R-1) without hydroxyl groups, a film forming defect having a wrinkled pattern was observed on the entire film surface. It is inferred that insufficient condensation reaction between the organic source and the metal source caused easy aggregation of each component during the application, resulting in coating failure. Further, wrinkle patterns were also observed on the entire surface of the film formed by the compositions (Comparative Examples UL-6 to UL-8) obtained by simply mixing a metal compound and an organic compound, unlike the organic-inorganic composite material of the present invention. It is inferred that film forming defects derived from the aggregation similar to that of Comparative Example UL-1 occurred because the metal compound and the organic compound were independently present in the composition without reacting with each other.

### Examples 2-1 to 2-14 and Comparative Examples 2-1 to 2-5 Evaluation of Resistance in Etching with CF₄ Gas

Each of the compositions for forming a metal oxide film (UL-1 to 14 and Comparative Examples UL-2 to 5) in which film forming property was evaluated as desirable in the evaluation of film forming property shown above, and Comparative Example UL-9 formed only of an organic compound was applied onto a silicon substrate and the substrate was baked in the atmosphere at 350°C for 60 seconds to form an 100 nm coating film, and the film thickness "a" was measured. Next, etching with CF₄ gas was performed for 1 minute under the following conditions using an etching apparatus Telius manufactured by Tokyo Electron Ltd., and the film thickness "b" was measured. The film thickness etched by CF₄ gas in one minute (thickness "b" - thickness "a") was calculated as the etching resistance with respect to CF₄ gas, and the case where the thickness difference (film loss) between the thickness "b" and the thickness "a" was less than 60 nm was evaluated as "A" (significantly desirable), the case where the thickness difference was 60 nm or more and less than 70 nm was evaluated as "B" (desirable), and the case where the thickness difference was 70 nm or more was evaluated as "C" (poor).

### Conditions of Dry Etching with CF₄ Gas

Chamber pressure: 100 mTorr
RF-power (upper portion): 500W
RF-power (lower portion): 400W
CF₄ gas flow rate: 300 sccm
Time: 60 sec

**Table 7**

| **Example** | **Composition for Forming Metal Oxide Film** | **CF₄ Etching Resistance Film Loss** |
|---|---|---|
| **Example 2-1** | **UL-1** | **A** |
| **Example 2-2** | **UL-2** | **A** |
| **Example 2-3** | **UL-3** | **A** |
| **Example 2-4** | **UL-4** | **A** |
| **Example 2-5** | **UL-5** | **A** |
| **Example 2-8** | **UL-6** | **A** |
| **Example 2-7** | **UL-7** | **A** |
| **Example 2-8** | **UL-8** | **A** |
| **Example 2-9** | **UL-9** | **A** |
| **Example 2-10** | **UL-10** | **A** |
| **Example 2-11** | **UL-11** | **A** |
| **Example 2-12** | **UL-12** | **A** |
| **Example 2-13** | **UL-13** | **A** |
| **Example 2-14** | **UL-14** | **A** |
| **Comparative Example 2-1** | **Comparative Example UL-2** | **A** |
| **Comparative Example 2-2** | **Comparative Example UL-3** | **C** |
| **Comparative Example 2-3** | **Comparative Example UL-4** | **C** |
| **Comparative Example 2-4** | **Comparative Example UL-5** | **A** |
| **Comparative Example 2-5** | **Comparative Example UL-9** | **C** |

It was revealed that since the compositions for forming a metal oxide film (UL-1 to 14) of the present invention are reaction products of a metal compound and an organic compound having a cardo structure with excellent dry etching resistance with respect to CF₄ gas, they exhibited excellent dry etching resistance compared with Comparative Example 2-5 not containing an inorganic source. In contrast, deterioration of dry etching resistance was observed in Comparative Examples 2-2 to 2-3. It is inferred that this is due to the weak dry etching resistance with respect to CF₄ gas of the compound used as the organic source of the organic-inorganic composite material.

### Examples 3-1 to 3-14 and Comparative Examples 3-1 to 3-8 Evaluation of Filling Property

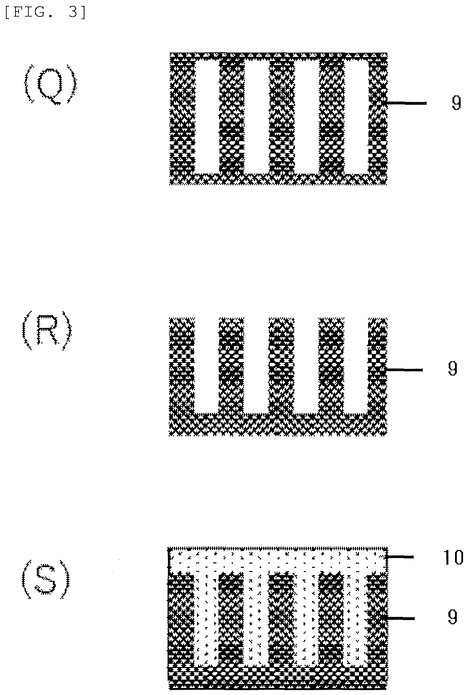

Each of the compositions for forming a metal oxide film described above (UL-1 to 14 and Comparative Examples UL-1 to 8) was applied onto a SiO₂ wafer substrate having a dense line-and-space pattern (line width = 40 nm, line depth = 120 nm, distance between the centers of two adjacent lines = 80 nm), followed by heating at 350°C for 60 seconds in the atmosphere using a hotplate to form a metal oxide film having a thickness of 100 nm. Similarly, heating was performed at 350°C for 60 seconds in the atmosphere, followed by baking at 500°C for 60 seconds under a nitrogen stream in which the oxygen concentration was controlled to 0.1 volume % or more and 0.2 volume % or less, thereby forming an organic film. The substrate used was a base substrate 9 (SiO₂ wafer substrate) having a dense line-and-space pattern shown in FIG. 3(Q) (downward view) and FIG. 3(R) (cross-sectional view). The cross-sectional shape of each of the obtained wafer substrates was observed using an electron microscope (S-4700: manufactured by Hitachi, Ltd.), and the presence/absence of voids (gaps) inside the metal oxide film filling between the lines was confirmed. Table 8 shows the results. In this evaluation, when a composition for forming a metal oxide film having a poor filling property was used, voids were generated inside the metal oxide film filling between the lines. In this evaluation, when a composition for forming a metal oxide film having a desirable filling property was used, as shown in FIG. 3(S), a metal oxide film 10 in which there were no voids inside the metal oxide film filling between the lines of the base substrate 9 having the dense line-and-space pattern was formed.

**Table 8**

| Example | Composition for Forming Metal Oxide Film | Presence/Absence of Voids in Filling (350°C) | Presence/Absence of Voids in Filling (500°C) |
|---|---|---|---|
| Example 3-1 | UL-1 | No | No |
| Example 3-2 | UL-2 | No | No |
| Example 3-3 | UL-3 | No | No |
| Example 3-4 | UL-4 | No | No |
| Example 3-5 | UL-5 | No | No |
| Example 3-6 | UL-6 | No | No |
| Example 3-7 | UL-7 | No | No |
| Example 3-8 | UL-8 | No | No |
| Example 3-9 | UL-9 | No | No |
| Example 3-10 | UL-10 | No | No |
| Example 3-11 | UL-11 | No | No |
| Example 3-12 | UL-12 | No | No |
| Example 3-13 | UL-13 | No | No |
| Example 3-14 | UL-14 | No | No |
| Comparative Example 3-1 | Comparative Example UL-1 | Yes | Yes |
| Comparative Example 3-2 | Comparative Example UL-2 | Yes | Yes |
| Comparative Example 3-3 | Comparative Example UL-3 | Yes | Yes |
| Comparative Example 3-4 | Comparative Example UL-4 | No | Yes |
| Comparative Example 3-5 | Comparative Example UL-5 | Yes | Yes |
| Comparative Example 3-6 | Comparative Example UL-6 | Yes | Yes |
| Comparative Example 3-7 | Comparative Example UL-7 | Yes | Yes |
| Comparative Example 3-8 | Comparative Example UL-8 | Yes | Yes |

As shown in Table 8, it was confirmed that Examples 3-1 to 3-14 using the compositions for forming a metal oxide film (UL-1 to 14) of the present invention were capable of filling the dense line-and-space pattern without generating voids, and had an excellent filling property in baking both at 350°C and 500°C. In contrast, voids were observed in Comparative Example 3-5 formed only of a metal compound (Comparative Example MA-1). It is inferred that voids were generated due to volume shrinkage associated with ligand elimination in the metal compound. It is inferred that, in Comparative Example 3-1, voids were also generated due to volume shrinkage associated with ligand elimination of unreacted metal compounds and metal compounds forming oligomers. It is also inferred that, since the organic source and the metal source are independently present in mixed compositions of an organic source and a metal source, such as Comparative Examples 3-6 to 3-8, volume shrinkage associated with ligand elimination of the metal compound occurred during baking to generate voids.

In Comparative Example 3-4, no voids were observed in the baking at 350°C; however, the presence of voids was confirmed in the baking at 500°C. It is inferred that since the heat resistance of the organic compound (R-4) used in the synthesis of the organic-inorganic composite material was low, the voids derived from thermal decomposition were generated in the baking at 500°C. In Comparative Examples 3-2 to 3-3, voids were observed after the baking at 350°C. It is inferred that, since the organic source used for the synthesis of the organic-inorganic composite materials (Comparative Examples UL-2 and UL-3) was a polymer, these voids were caused by insufficient flowability.

In order to suppress the volume shrinkage associated with ligand elimination of metal compounds, which affects the generation of voids, it is preferable to use a reaction product resulting from a condensation reaction of an organic source and a metal source as in the present invention, and it is also preferable to select a compound with a cardo structure having excellent heat resistance and flowability as the organic source.

### Examples 4-1 to 4-14 and Comparative Examples 4-1 to 4-9 Evaluation of Planarizing Property

Each of the compositions for forming a metal oxide film (UL-1 to 14 and Comparative Examples UL-1 to 8) and Comparative Example UL-9 formed only of an organic compound was applied onto a SiO₂ wafer substrate having a dense line-and-space pattern (line width = 40 nm, line depth = 120 nm, distance between the centers of two adjacent lines = 80 nm), followed by heating at 350°C for 60 seconds in the atmosphere using a hotplate to form a metal oxide film having a thickness of 100 nm. The substrate used was a base substrate 11 (SiO₂ wafer substrate) having a dense line-and-space pattern shown in FIG. 3(T) (cross-sectional view). The cross-sectional shape of each of the obtained wafer substrates was observed using a scanning electron microscope (SEM), and the step (Delta 12 in FIG. 3(U)) between the line pattern dense portion and the non-line pattern forming portion of the filling film was observed using an electron microscope (S-4700: manufactured by Hitachi, Ltd.). Table 9 shows the results. In this evaluation, the smaller the step, the superior the planarizing property.

**Table 9**

| Example | Composition for Forming Metal Oxide Film | Step (nm) 350°C |
|---|---|---|
| Example 4-1 | UL-1 | 60 |
| Example 4-2 | UL-2 | 60 |
| Example 4-3 | UL-3 | 60 |
| Example 4-4 | UL-4 | 65 |
| Example 4-5 | UL-5 | 55 |
| Example 4-6 | UL-6 | 60 |
| Example 4-7 | UL-7 | 55 |
| Example 4-8 | UL-8 | 60 |
| Example 4-9 | UL-9 | 60 |
| Example 4-10 | UL-10 | 50 |
| Example 4-11 | UL-11 | 55 |
| Example 4-12 | UL-12 | 55 |
| Example 4-13 | UL-13 | 50 |
| Example 4-14 | UL-14 | 55 |
| Comparative Example 4-1 | Comparative Example UL-1 | 80 |
| Comparative Example 4-2 | Comparative Example UL-2 | 80 |
| Comparative Example 4-3 | Comparative Example UL-3 | 90 |
| Comparative Example 4-4 | Comparative Example UL-4 | 50 |
| Comparative Example 4-5 | Comparative Example UL-5 | 105 |
| Comparative Example 4-6 | Comparative Example UL-6 | 90 |
| Comparative Example 4-7 | Comparative Example UL-7 | 100 |
| Comparative Example 4-8 | Comparative Example UL-8 | 110 |
| Comparative Example 4-9 | Comparative Example UL-9 | 60 |

It was confirmed that Examples 4-1 to 4-14 using the compositions for forming a metal oxide film (UL-1 to 14) of the present invention had a smaller step difference between the line pattern dense portion and the non-line pattern forming portion of the filling film, compared with that in Comparative Examples 4-2 and 4-3 using an organic-inorganic composite material (Comparative Examples UL-2 and UL-3) obtained by using a polymer as the organic source, and that these Examples thus had a superior planarizing property. Further, the results showed the planarizing property comparable to that resulting from the material formed only of an organic compound (Comparative Example UL-9).

In comparison of Examples 4-1 and 4-7, and Examples 4-2 and 4-5 in which the compound as the organic source has the same skeleton structure, the result showed that Examples 4-7 and 4-5 in which the organic source of the organic-inorganic composite material contains the constituent unit represented by the general formula (II-2) in addition to the structure unit represented by the general formula (II-1) had superior planarizing property. This is presumably because the incorporation of the general formula (II-2) having excellent flowability in the organic-inorganic composite material results in improvement in planarizing property. It is also inferred that the thermal flowability and the flowability during the coating were improved also in Examples 4-12 to 4-14 in which the flowability accelerators (C-1 to C-3) were added, and thus these Examples exhibited superior planarizing property compared with those in Examples 4-2, 4-7, and 4-8 in which the flowability accelerators were not added.

In contrast, it was confirmed that Comparative Example UL-1 and Comparative Examples UL-5 to 8 in which generation of voids was observed in the evaluation of filling property after baking at 350°C had insufficient planarizing property.

### Examples 5-1 to 5-14 and Comparative Examples 5-1 to 5-5 Evaluation of Pattern Transfer Property

Each of the compositions for forming a metal oxide film (UL-1 to 14, Comparative Examples UL-2 to 5) in which film forming property was evaluated as desirable in the evaluation of film forming property shown above and Comparative Example UL-9 formed only of an organic compound was applied onto a silicon wafer substrate on which a SiO₂ film having a trench pattern (trench width: 10 um, trench depth: 0.10 um) was formed, followed by baking at 350°C for 60 seconds in the atmosphere to form an organic film having a thickness of 100 nm. A silicon atom-containing resist middle layer film material (SOG-1) was applied thereto, followed by baking at 220°C for 60 seconds to form a resist middle layer film having a thickness of 35 nm. Then, a monolayer resist for ArF as a resist upper layer film material was applied thereto, followed by baking at 105°C for 60 seconds to form a photoresist film having a thickness of 100 nm. A liquid immersion top coat composition (TC-1) was applied to the photoresist film, followed by baking at 90°C for 60 seconds to form a protection film having a thickness of 50 nm.

A silicon atom-containing resist middle layer film material (SOG-1) was prepared by dissolving a polymer denoted by the ArF silicon-containing middle layer film polymer (SiP1) and a crosslinking catalyst (CAT1) in an organic solvent containing 0.1% by mass of FC-4430 (manufactured by Sumitomo 3M Limited) at the proportions shown in Table 10 and filtering the resulting solution through a filter made of a fluororesin having a pore size of 0.1 um.

**Table 10**

| | Polymer | Thermal Crosslinking Catalyst | Organic Solvent |
|---|---|---|---|
| | (part by mass) | (part by mass) | (part by mass) |
| S0G-1 | SiP1 (100) | CAT1 (1) | Propylene Glycol Monoethyl Ether (4000) |

The structural formulae of the ArF silicon-containing middle layer film polymer (SiP1) and the crosslinking catalyst (CAT1) used herein are shown below.

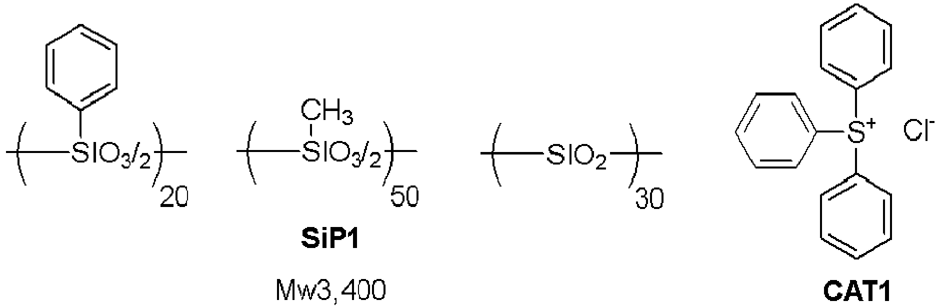

The resist upper layer film material (monolayer resist for ArF) was prepared by dissolving a polymer (RP1), an acid generator (PAG1), and a basic compound (Amine1) in a solvent containing 0.1% by mass of a surfactant FC-4430 (manufactured by Sumitomo 3M Limited) at the proportions shown in Table 11, and filtering the solution through a filter made of a fluororesin having a pore size of 0.1 um.

**Table 11**

| | Polymer (part by mass) | Acid Generator (part by mass) | Basic Compound (part by mass) | Solvent (part by mass) |
|---|---|---|---|---|
| Monolayer Resist for ArF | RP1 (100) | PAG1 (6.6) | Aminel (0.8) | PGMEA (2500) |

The polymer (RP1), the acid generator (PAG1), and the basic compound (Amine1) used for the resist upper layer film material (monolayer resist for ArF) are shown below.

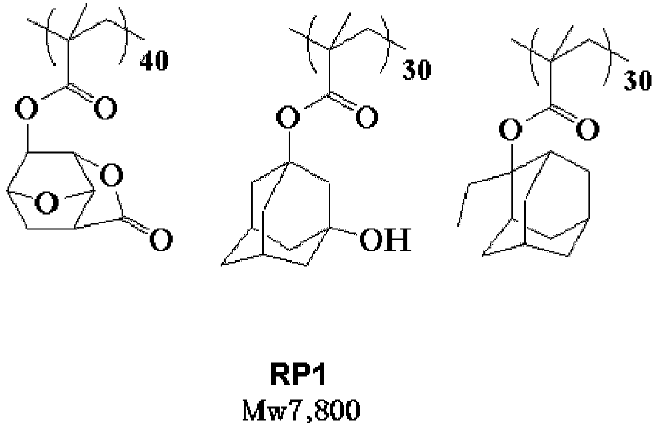

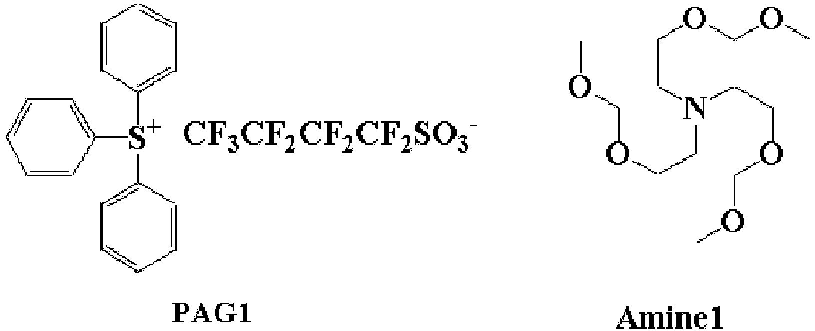

The liquid immersion top coat composition (TC-1) was prepared by dissolving a top coat polymer (PP1) in an organic solvent at the proportion shown in Table 12, and filtering the solution through a filter made of a fluororesin having a pore size of 0.1 um.

**Table 12**

| | Polymer (part by mass) | Organic Solvent (part by mass) |
|---|---|---|
| TC-1 | PP1 (100) | Diisoamyl Ether (2700) |
| | | 2-Methyl-1-butanol (270) |

The polymer (PP1) used for the liquid immersion top coat composition (TC-1) is shown below.

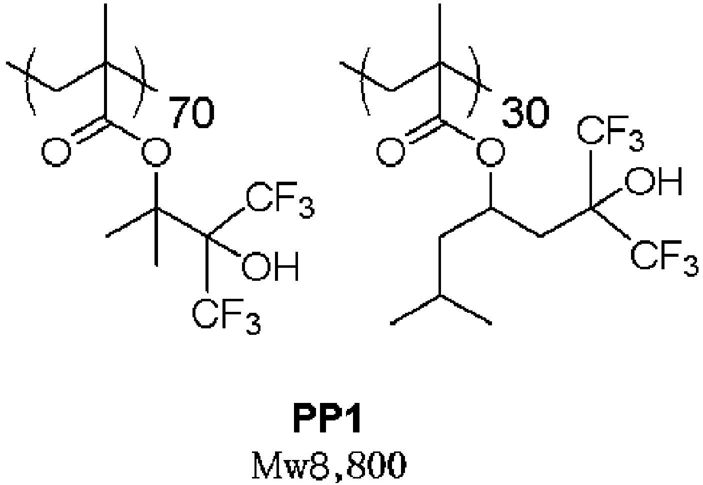

Then, the substrate was exposed to light with an ArF liquid immersion exposure apparatus (NSR-S610C manufactured by Nikon Corporation, NA: 1.30, σ: 0.98/0.65, 35° s-polarized dipole illumination, 6% halftone phase shift mask), baked at 100°C for 60 seconds (PEB), and developed with a 2.38 % by mass of tetramethylammonium hydroxide (TMAH) aqueous solution for 30 seconds, thereby obtaining a 55 nm 1:1 positive line-and-space pattern (a resist pattern).

Then, the organic antireflective film and the silicon atom-containing resist middle layer film material (SOG-1) were etched by dry etching while using the resist pattern as a mask and an etching apparatus Telius manufactured by Tokyo Electron Ltd. to form a hard mask pattern. Then, a metal oxide film was etched while using the obtained SOG-1 pattern as a mask to form a metal oxide film pattern, and the SiO₂ film was etched while using the obtained metal oxide film pattern as a mask. The etching conditions were as follows.

### Conditions in transferring a resist pattern to a silicon atom-containing resist middle layer film material (SOG-1)

Chamber pressure: 50 mTorr
RF-power (upper portion): 500W
RF-power (lower portion): 300W
CF₄ gas flow rate: 150 sccm
CHF₃ gas flow rate: 50 sccm
Time: 20 sec

### Conditions in transferring a silicon atom-containing resist middle layer film material (SOG-1) pattern to a metal oxide film

Chamber pressure: 15 mTorr
RF-power (upper portion): 300W
RF-power (lower portion): 50W
O₂ gas flow rate: 30 sccm
N₂ gas flow rate: 270 sccm
Time: 90 sec

### Conditions in transferring metal oxide film pattern to SiO₂ film

Chamber pressure: 10 mTorr
RF-power (upper portion): 100W
RF-power (lower portion): 800W
CF₄ gas flow rate: 25 sccm
CHF₃ gas flow rate: 15 sccm
O₂ gas flow rate: 5 sccm
Time: 100 sec

Table 13 shows the results obtained by observation of the pattern cross section with an electron microscope (S-4700) manufactured by Hitachi, Ltd.

**Table 13**

| Example | Composition for Forming Metal Oxide Film | Pattern Transfer Property |
|---|---|---|
| Example 5-1 | UL-1 | Vertical Shape |
| Example 5-2 | UL-2 | Vertical Shape |
| Example 5-3 | UL-3 | Vertical Shape |
| Example 5-4 | UL-4 | Vertical Shape |
| Example 5-5 | UL-5 | Vertical Shape |
| Example 5-6 | UL-6 | Vertical Shape |
| Example 5-7 | UL-7 | Vertical Shape |
| Example 5-8 | UL-8 | Vertical Shape |
| Example 5-9 | UL-9 | Vertical Shape |
| Example 5-10 | UL-10 | Vertical Shape |
| Example 5-11 | UL-11 | Vertical Shape |
| Example 5-12 | UL-12 | Vertical Shape |
| Example 5-13 | UL-13 | Vertical Shape |
| Example 5-14 | UL-14 | Vertical Shape |
| Comparative Example 5-1 | Comparative Example UL-2 | Pattern Collapse Observed |
| Comparative Example 5-2 | Comparative Example UL-3 | Pattern Collapse Observed |
| Comparative Example 5-3 | Comparative Example UL-4 | Pattern Distortion Observed |
| Comparative Example 5-4 | Comparative Example UL-5 | Pattern Collapse Observed |
| Comparative Example 5-5 | Comparative Example UL-9 | Pattern Distortion Observed |

As shown in Table 13, in all of Examples 5-1 to 5-14 using the compositions for forming a metal oxide film of the present invention (UL-1 to 14), the resist upper layer film pattern was desirably transferred to the substrate in the end and a vertical form of a line-and-space pattern was formed. It was thus confirmed that the composition for forming a metal oxide film of the present invention can be suitably used for fine processing using the multilayer resist method.

In contrast, in Comparative Examples 5-1, 5-2, and 5-4 in which voids were confirmed in the evaluation of filling property, pattern collapse occurred at the time of pattern processing, and a desirable pattern could not be obtained in the end. In addition, in Comparative Examples 5-3 and 5-5 in which the performance was found insufficient in the evaluation of dry etching resistance, distortion of the pattern shape occurred at the time of pattern processing, and a desirable pattern could not be obtained in the end.

### Examples 6-1 to 6-14 and Comparative Examples 6-1 to 6-5 Evaluation of Reverse SOC Pattern Shape

The coating-type organic underlayer film material (SOC-1) was applied as a resist underlayer film onto a silicon wafer substrate on which a SiO₂ film having a thickness of 300 nm was formed, and the substrate was then baked at 350°C for 60 seconds in the atmosphere to form a resist underlayer film having a thickness of 80 nm. A silicon atom-containing resist middle layer film material (SOG-1) was applied thereto, followed by baking at 220°C for 60 seconds to form a resist middle layer film having a thickness of 35 nm. Then, a monolayer resist for ArF as a resist upper layer film material was applied thereto, followed by baking at 105°C for 60 seconds to form a photoresist film having a thickness of 100 nm. A liquid immersion top coat composition (TC-1) was applied to the photoresist film, followed by baking at 90°C for 60 seconds to form a protection film having a thickness of 50 nm.

The resist upper layer film material (monolayer resist for ArF) and the liquid immersion top coat composition (TC-1) on the photoresist film were made of the same material as that used in the evaluation of pattern transfer property (Example 5).

The silicon atom-containing resist middle layer film material (SOC-1) as a coating-type organic underlayer film material (SOC-1) was prepared by dissolving the polymer denoted by the organic underlayer film polymer (SOP1) in an organic solvent containing 0.1% by mass of FC-4430 (manufactured by Sumitomo 3M Limited) at the proportion shown in Table 14 and filtering the resulting solution through a filter made of a fluororesin having a pore size of 0.2 um.

**Table 14**

| | Polymer (part by mass) | Organic Solvent (part by mass) |
|---|---|---|
| SOC-1 | SOP1 (5) | Propylene Glycol Monoethyl Ether (95) |

The structural formula of the organic underlayer film polymer (SOP1) used herein is shown in Table 15.

**Table 15**

| Compound or Polymer | Mw | Mw /Mn |
|---|---|---|
| 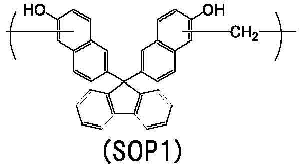 | 3700 | 2.82 |

A silicon atom-containing resist middle layer film material (SOG-1) was prepared by dissolving a polymer denoted by the ArF silicon-containing middle layer film polymer (SiP1) and a crosslinking catalyst (CAT1) in an organic solvent containing 0.1% by mass of FC-4430 (manufactured by Sumitomo 3M Limited) at the proportions shown in Table 16 and filtering the resulting solution through a filter made of a fluororesin having a pore size of 0.1 um.

**Table 16**

| | Polymer | Thermal Crosslinking Catalyst | Organic Solvent |
|---|---|---|---|
| | (part by mass) | (part by mass) | (part by mass) |
| SOG-1 | SiP1 (100) | CAT1 (1) | Propylene Glycol Monoethyl Ether (4000) |

The structural formulae of the ArF silicon-containing middle layer film polymer (SiP1) and the crosslinking catalyst (CAT1) used herein are shown below.

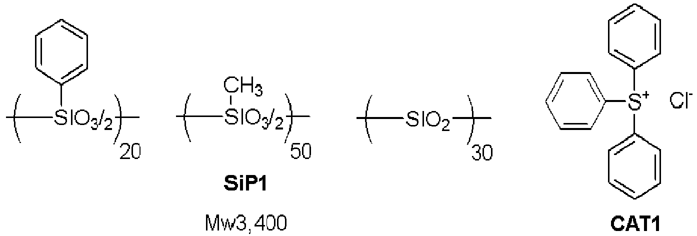

Then, the substrate was exposed to light with an ArF liquid immersion exposure apparatus (NSR-S610C manufactured by Nikon Corporation, NA: 1.30, σ: 0.98/0.65, 35° s-polarized dipole illumination, 6% halftone phase shift mask), baked at 100°C for 60 seconds (PEB), and developed with a 2.38 % by mass of tetramethylammonium hydroxide (TMAH) aqueous solution for 30 seconds, thereby obtaining a 55 nm 1:1 positive line-and-space pattern.

Then, the silicon atom-containing resist middle layer film material (SOG-1) was etched by dry etching while using the resist pattern as a mask using an etching apparatus Telius manufactured by Tokyo Electron Ltd. to form a hard mask pattern. Then, an organic underlayer film (SOC-1) was etched while using the obtained hard mask pattern as a mask to form a SOC-1 film pattern. The etching conditions were as follows.

### Conditions in transferring a resist pattern to a silicon atom-containing resist middle layer film material (SOG-1)

Chamber pressure: 50 mTorr
RF-power (upper portion): 500W
RF-power (lower portion): 300W
CF₄ gas flow rate: 150 sccm
CHF₃ gas flow rate: 50 sccm
Time: 20 sec

### Conditions in transferring a silicon atom-containing resist middle layer film material (SOG-1) pattern to an organic underlayer film (SOC-1)

Chamber pressure: 10 mTorr
RF-power (upper portion): 1000W
RF-power (lower portion): 300W
CO₂ gas flow rate: 150 sccm
CO gas flow rate: 50 sccm
N₂ gas flow rate: 50 sccm
H₂ gas flow rate: 150 sccm
Time: 60 sec

Subsequently, each of the compositions for forming a metal oxide film (UL-1 to 14 and Comparative Examples UL-2 to 5) in which film forming property was evaluated as desirable in the evaluation of film forming property shown above, and Comparative Example UL-9 formed only of an organic compound was applied onto the obtained SOC-1 film pattern, followed by baking in the atmosphere at 350°C for 60 seconds to form a metal oxide film having a thickness of 100 nm. Thereafter, the metal oxide film covering the SOC-1 film pattern was etched to uncover the upper surface of the SOC-1 film pattern. The SOG-1 film remaining on the surface of the SOC-1 film pattern with the uncovered upper surface was removed by etching, then the uncovered SOC-1 was removed by etching, the above pattern was inverted onto a metal oxide film, and the SiO₂ film was etched while using the obtained metal oxide film pattern as a mask. The etching conditions were as follows. As a Comparative Example, etching of the SiO₂ film was performed using the SOC-1 film pattern as a mask without using the composition for forming a metal oxide film (Comparative Example 6-6). The etching conditions were as follows.

### Conditions in etch-back of metal oxide film (exposure of SOC-1 film pattern)

Chamber pressure: 15 mTorr
RF-power (upper portion): 300W
RF-power (lower portion): 50W
O₂ gas flow rate: 30 sccm
N₂ gas flow rate: 270 sccm
Time: 60 sec

### Removal of SOG-1 film remaining on SOC-1 film pattern

Chamber pressure: 50 mTorr
RF-power (upper portion): 500W
RF-power (lower portion): 300W
CF₄ gas flow rate: 150 sccm
CHF₃ gas flow rate: 50 sccm
Time: 15 sec

### Removal of SOC-1 film pattern

Chamber pressure: 10 mTorr
RF-power (upper portion): 1,000W
RF-power (lower portion): 300W
CO₂ gas flow rate: 150 sccm
CO gas flow rate: 50 sccm
N₂ gas flow rate: 50 sccm
H₂ gas flow rate: 150 sccm
Time: 60 sec

### Conditions in transferring metal oxide film pattern to SiO₂ film

Chamber pressure: 10 mTorr
RF-power (upper portion): 100W
RF-power (lower portion): 800W
CF₄ gas flow rate: 25 sccm
CHF₃ gas flow rate: 15 sccm
O₂ gas flow rate: 5 sccm
Time: 200 sec

Comparative Example 6-6: Conditions in transferring SOC-1 film pattern to SiO₂ film
Chamber pressure: 10 mTorr
RF-power (upper portion): 100W
RF-power (lower portion): 800W
CF₄ gas flow rate: 25 sccm
CHF₃ gas flow rate: 15 sccm
O₂ gas flow rate: 5 sccm
Time: 200 sec

Table 17 shows the results obtained by observation of the pattern cross section with an electron microscope (S-4700) manufactured by Hitachi, Ltd.

**Table 17**

| Example | Composition for Forming Metal Oxide Film | Reverse Pattern |
|---|---|---|
| Example 6-1 | UL-1 | Vertical Shape |
| Example 6-2 | UL-2 | Vertical Shape |
| Example 6-3 | UL-3 | Vertical Shape |
| Example 6-4 | UL-4 | Vertical Shape |
| Example 6-5 | UL-5 | Vertical Shape |
| Example 6-6 | UL-6 | Vertical Shape |
| Example 6-7 | UL-7 | Vertical Shape |
| Example 6-8 | UL-8 | Vertical Shape |
| Example 6-9 | UL-9 | Vertical Shape |
| Example 6-10 | UL-10 | Vertical Shape |
| Example 6-11 | UL-11 | Vertical Shape |
| Example 6-12 | UL-12 | Vertical Shape |
| Example 6-13 | UL-13 | Vertical Shape |
| Example 6-14 | UL-14 | Vertical Shape |
| Comparative Example 6-1 | Comparative Example UL-2 | Pattern Collapse Observed |
| Comparative Example 6-2 | Comparative Example UL-3 | Pattern Collapse Observed |
| Comparative Example 6-3 | Comparative Example UL-4 | No Pattern |
| Comparative Example 6-4 | Comparative Example UL-5 | Pattern Collapse Observed |
| Comparative Example 6-5 | Comparative Example UL-9 | No Pattern |
| Comparative Example 6-6 | none | Pattern Distortion Observed |

As shown in Table 17, Examples 6-1 to 6-14 using the compositions for forming a metal oxide film of the present invention (UDL-1 to 14) are all capable of accurately inverting the SOC-1 film pattern, and the reverse pattern is desirably transferred to the substrate in the end without pattern collapse. It was thus confirmed that the composition for forming a metal oxide film of the present invention can be suitably used for fine processing using the tone-reversal etching method of the multilayer resist process method. On the other hand, in Comparative Example 6-6 in which the SOC-1 film pattern was transferred to the SiO₂ film as it was, the etching resistance of the SOC-1 film was insufficient, and therefore, the distortion of the pattern shape was confirmed. Further, in Comparative Example 6-5, since the etching resistance of Comparative Example UL-9 formed only of an organic compound was insufficient, a selectivity ratio relative to the SOC-1 film pattern was not ensured, and a desirable reverse pattern could not be obtained. Similarly, also in Comparative Example 6-3 in which the evaluation of the filling property and the evaluation of the planarizing property were fine but the performance was found insufficient in the evaluation of dry etching resistance, it is inferred that distortion of the pattern shape occurred at the time of pattern inversion processing, and a desirable reverse pattern could not be obtained in the end. Further, in Comparative Examples 6-1, 6-2, and 6-4 in which insufficient performance was confirmed in the evaluation of filling property and the evaluation of planarizing property, it is inferred that pattern collapse occurred at the time of pattern processing, and a desirable reverse pattern could not be obtained in the end.

It was thus revealed that, since the composition for forming a metal oxide film of the present invention is a reaction product obtained from a condensation reaction of an organic compound and a metal compound, it is possible to suppress coating failure due to incompatibility between the metal source and the organic source and suppress void generation defects in the filling film caused by thermal shrinkage of the metal compound during the heating, thus exhibiting excellent coatability and filling and planarizing properties compared with the previously-known composition for forming a metal oxide film obtained by mixing a metal compound and a resin. Further, with its excellent dry etching resistance, the composition is significantly useful as a resist underlayer film material used in the multilayer resist method and as an inverting agent used in the tone-reversal etching method. Furthermore, it was also revealed that the patterning process of the present invention using this composition is capable of forming fine patterns with a high degree of accuracy even when a body to be processed is a substrate having a step.

The present invention encompasses the following embodiments.
[1]. A composition for forming a metal oxide film, comprising (A) an organic-inorganic composite material and (B) a solvent,
   (A) the organic-inorganic composite material being a reaction product of a metal source (I) and an organic source (II),
      the metal source (I) comprising one or more compounds selected from a metal compound represented by the following general formula (I-1), a hydrolysate of the metal compound represented by the general formula (I-1), and a hydrolysis condensate of the metal compound represented by the general formula (I-1), and
      the organic source (II) comprising a compound having a constituent unit represented by the following general formula (II-1) and a cardo structure, 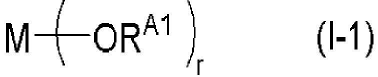 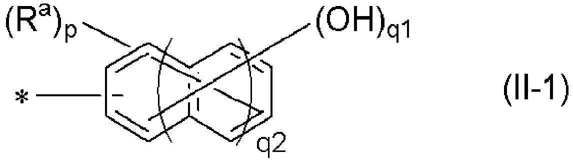 wherein M is a metal; each R^{A1} may be identical to or different from one another and represents a monovalent organic group having 1 to 30 carbon atoms with 0 or 1 hydroxy group; adjacent R^{A1} may be bonded to each other to form a spiro ring, and to form a ring together with O and M to which these R^{A1} are bonded; r is an integer of 3 to 6; R^{a} is an optionally substituted saturated monovalent organic group having 1 to 10 carbon atoms or an optionally substituted unsaturated monovalent organic group having 2 to 10 carbon atoms; "p" is an integer of 0 to 5; q₁ is an integer of 1 to 6; p+q₁ is an integer of 1 or more and 6 or less; q₂ is 0 or 1; and * represents a bonding site.
[2]. The composition for forming a metal oxide film according to [1], wherein the organic source (II) has a constituent unit represented by the following general formula (II-2), in addition to the constituent unit represented by the general formula (II-1) and a cardo structure, 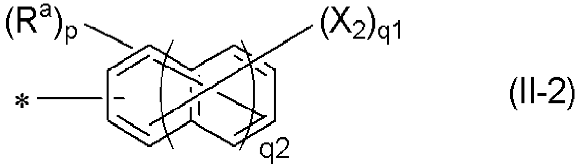 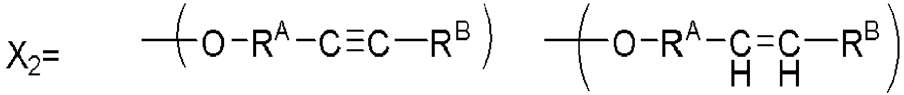 in the above general formula (II-2), R^{A} is an optionally substituted divalent organic group having 1 to 10 carbon atoms; R^{B} is a hydrogen atom or an optionally substituted monovalent organic group having 1 to 10 carbon atoms; and R^{a,} p, q₁, q₂, and * are as defined in the general formula (II-1) .
[3]. The composition for forming a metal oxide film according to [2], wherein the organic source (II) as a whole satisfies relationships: a+b=1 and 0.2≤b≤0.8, wherein "a" represents the proportion of the constituent unit represented by the general formula (II-1), and "b" represents the proportion of the constituent unit represented by the general formula (II-2).
[4]. The composition for forming a metal oxide film according to [2] or [3], wherein, in the general formula (II-2), X₂ is a compound represented by the following general formula (X-1), 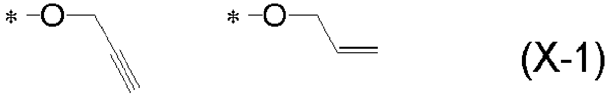 wherein * represents a bonding site.
[5]. The composition for forming a metal oxide film according to any one of [1] to [4], wherein the organic source (II) comprises compounds represented by the following general formulae (1) to (3), 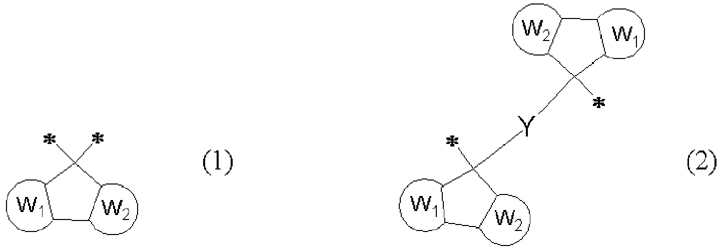 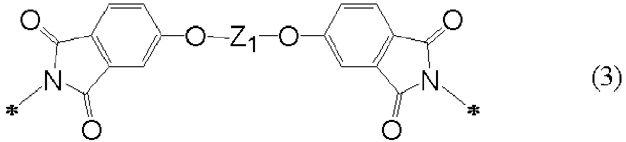 wherein W₁ and W₂ each independently represent a benzene ring or a naphthalene ring, and hydrogen atoms in the benzene ring and the naphthalene ring are optionally substituted with a hydrocarbon group having 1 to 6 carbon atoms; Y is a group represented by the following general formula (4); Z₁ is a group represented by the following general formula (5); and * is a site bonded with the constituent unit represented by the general formula (II-1), 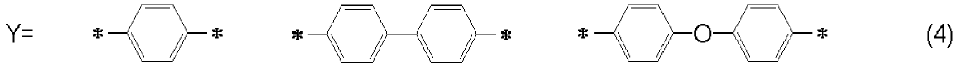 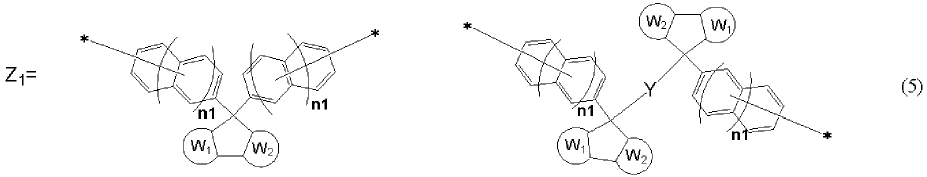 where W₁, W₂, and Y are as defined above, and n₁ is 0 or 1; and in the general formulae (4) and (5), * represents a bonding site.
[6]. The composition for forming a metal oxide film according to any one of [1] to [5], wherein a ratio Mw/Mn (dispersity) in the compound contained in the organic source (II) is in a range of 1.00≤Mw/Mn≤1.25, the Mw/Mn being a ratio of the weight average molecular weight Mw to the number average molecular weight Mn on polystyrene basis according to gel permeation chromatography.
[7]. The composition for forming a metal oxide film according to any one of [1] to [6], wherein M in the general formula (I-1) comprises a metal selected from the group consisting of Zr, Ta, Hf, Ti, Sn, Nb, Mo, Ge, and W.
[8]. The composition for forming a metal oxide film according to any one of [1] to [7], wherein the composition further comprises (C) a flowability accelerator having a weight reduction rate in a range from 30°C to 190°C of less than 30% and a weight reduction rate in a range from 30°C to 350°C of 98% or more.
[9]. The composition for forming a metal oxide film according to [8], wherein (C) the flowability accelerator comprises one or more compounds selected from the following general formulae (i) to (iii), 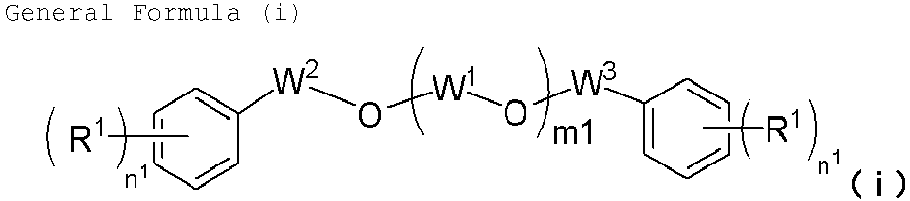 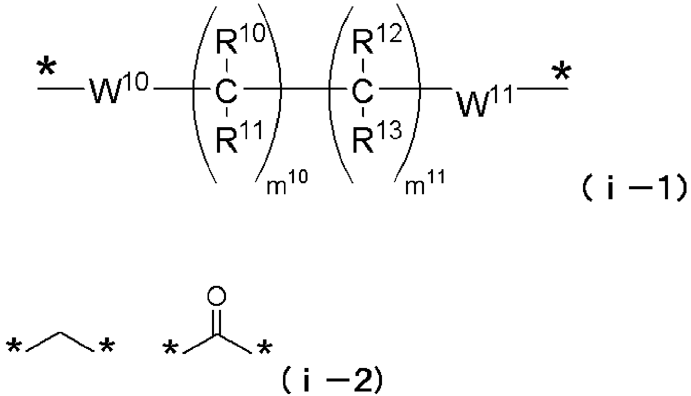 wherein R¹ independently represents a hydrogen atom, a hydroxyl group, or an optionally substituted organic group having 1 to 10 carbon atoms; W¹ is a phenylene group or a divalent group represented by the general formula (i-1); each of W² and W³ is a single bond or any of the divalent groups represented by the general formula (i-2); m¹ is an integer of 1 to 10; n¹ is an integer of 0 to 5; * represents a bonding site; each of R¹⁰, R¹¹, R¹², and R¹³ represents a hydrogen atom, a hydroxyl group, or an organic group having 1 to 10 carbon atoms; W¹⁰ and W¹¹ independently represent a single bond or a carbonyl group; each of m¹⁰ and m¹¹ is an integer of 0 to 10, and m¹⁰+m¹¹≥1, 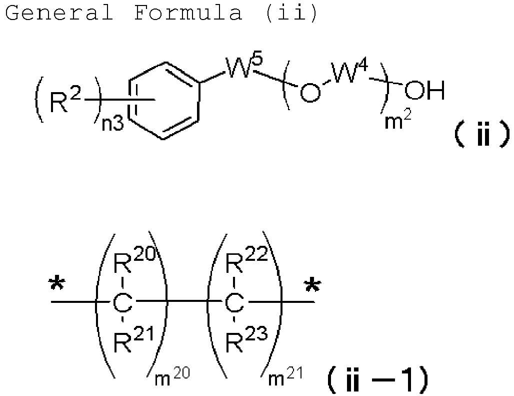 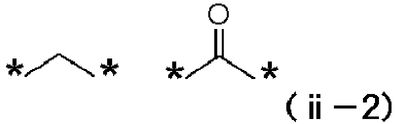 wherein R² independently represents a hydrogen atom, a hydroxyl group, or an optionally substituted organic group having 1 to 10 carbon atoms; W⁴ is a divalent group represented by the general formula (ii-1); W⁵ is a single bond or any of the divalent groups represented by the general formula (ii-2); m² is an integer of 2 to 10; n³ is an integer of 0 to 5; * represents a bonding site; and each of R²⁰, R²¹, R²², and R²³ represents a hydrogen atom, a hydroxyl group, or an organic group having 1 to 10 carbon atoms; each of m²⁰ and m²¹ is an integer of 0 to 10, and m²⁰+m²¹≥1, 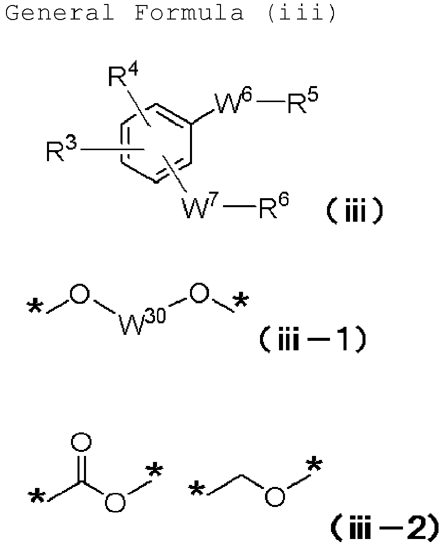 wherein each of R³ and R⁴ represents a hydrogen atom, a hydroxyl group, or an optionally substituted organic group having 1 to 10 carbon atoms, and R³ and R⁴ may be bonded to each other to form a cyclic structure; each of R⁵ and R⁶ is an organic group having 1 to 10 carbon atoms, and R⁵ is a group containing either an aromatic ring or a divalent group represented by the general formula (iii-1); each of W⁶ and W⁷ is a single bond or any of the divalent groups represented by the general formula (iii-2), and at least one of W⁶ and W⁷ is one of the divalent groups represented by the general formula (iii-2); W³⁰ is an organic group having 1 to 4 carbon atoms; and * represents a bonding site.
[10]. The composition for forming a metal oxide film according to any one of [1] to [9], wherein the composition for forming a metal oxide film further comprises (D) a metal oxide nanoparticle having an average primary particle size of 100 nm or less.
[11]. The composition for forming a metal oxide film according to [10], wherein (D) the metal oxide nanoparticle is one or more selected from the group consisting of zirconium oxide nanoparticle, hafnium oxide nanoparticle, titanium oxide nanoparticle, tin oxide nanoparticle, and tungsten oxide nanoparticle.
[12]. The composition for forming a metal oxide film according to any one of [1] to [11], wherein the composition further comprises one or more of a crosslinking agent, a surfactant, an acid generator, and a plasticizer.
[13]. A patterning process for forming a pattern in a substrate to be processed, comprising the steps of:
   (I-1) applying the composition for forming a metal oxide film according to any one of [1] to [12] onto a substrate to be processed, followed by heating to form a metal oxide film;
   (I-2) forming a resist upper layer film on the metal oxide film by using a photoresist material;
   (I-3) subjecting the resist upper layer film to pattern exposure and then development with a developer to form a pattern in the resist upper layer film;
   (I-4) transferring the pattern to the metal oxide film by dry etching while using the resist upper layer film having the formed pattern as a mask; and
   (I-5) processing the substrate to be processed while using the metal oxide film having the formed pattern as a mask to form the pattern in the substrate to be processed.
[14]. A patterning process for forming a pattern in a substrate to be processed, comprising the steps of:
   (II-1) applying the composition for forming a metal oxide film according to any one of [1] to [12] onto a substrate to be processed, followed by heating to form a metal oxide film;
   (II-2) forming a resist middle layer film on the metal oxide film;
   (II-3) forming a resist upper layer film on the resist middle layer film by using a photoresist material;
   (II-4) subjecting the resist upper layer film to pattern exposure and then development with a developer to form a pattern in the resist upper layer film;
   (II-5) transferring the pattern to the resist middle layer film by dry etching while using the resist upper layer film having the formed pattern as a mask;
   (II-6) transferring the pattern to the metal oxide film by dry etching while using the resist middle layer film having the transferred pattern as a mask; and
   (II-7) processing the substrate to be processed while using the metal oxide film having the formed pattern as a mask to form the pattern in the substrate to be processed.
[15]. A patterning process for forming a pattern in a substrate to be processed, comprising the steps of:
   (III-1) applying the composition for forming a metal oxide film according to any one of [1] to [12] onto a substrate to be processed, followed by heating to form a metal oxide film;
   (III-2) forming an inorganic hard mask middle layer film selected from a silicon oxide film, a silicon nitride film, and a silicon oxynitride film on the metal oxide film;
   (III-3) forming an organic thin film on the inorganic hard mask middle layer film;
   (III-4) forming a resist upper layer film on the organic thin film by using a photoresist material;
   (III-5) subjecting the resist upper layer film to pattern exposure and then development with a developer to form a pattern in the resist upper layer film; (III-6) transferring the pattern to the organic thin film and the inorganic hard mask middle layer film by dry etching while using the resist upper layer film having the formed pattern as a mask;
   (III-7) transferring the pattern to the metal oxide film by dry etching while using the inorganic hard mask middle layer film having the transferred pattern as a mask; and
   (III-8) processing the substrate to be processed while using the metal oxide film having the formed pattern as a mask to form the pattern in the substrate to be processed.
[16]. A patterning process for forming a pattern in a substrate to be processed, comprising the steps of:
   (IV-1) forming a resist underlayer film on a substrate to be processed;
   (IV-2) forming a resist middle layer film, or a combination of an inorganic hard mask middle layer film selected from a silicon oxide film, a silicon nitride film, and a silicon oxynitride film and an organic thin film on the resist underlayer film;
   (IV-3) forming a resist upper layer film on the resist middle layer film, or the combination of the inorganic hard mask middle layer film and the organic thin film by using a photoresist material;
   (IV-4) subjecting the resist upper layer film to pattern exposure and then development with a developer to form a pattern in the resist upper layer film;
   (IV-5) transferring a pattern to the resist middle layer film or the organic thin film and the inorganic hard mask middle layer film by dry etching while using the resist upper layer film having the formed pattern as a mask;
   (IV-6) transferring a pattern to the resist underlayer film by dry etching while using the resist middle layer film or the inorganic hard mask middle layer film having the transferred pattern as a mask;
   (IV-7) applying the composition for forming a metal oxide film according to any one of [1] to [12] onto the resist underlayer film having the formed pattern, followed by heating to cover the resist underlayer film with a metal oxide film, thereby filling a space between the resist underlayer film patterns with the metal oxide film;
   (IV-8) etching back the metal oxide film covering the resist underlayer film having the formed pattern by a chemical stripper or dry etching to uncover an upper surface of the resist underlayer film having the formed pattern;
   (IV-9) removing the resist middle layer film or the hard mask middle layer film remaining on the upper surface of the resist underlayer film by dry etching;
   (IV-10) removing the resist underlayer film having the formed pattern with its surface uncovered by dry etching to form a reverse pattern of an original pattern in the metal oxide film; and
   (IV-11) processing the substrate to be processed while using the metal oxide film having the formed reversal pattern as a mask to form a reversal pattern in the substrate to be processed.
[17]. The patterning process according to any one of [13] to [16], wherein the substrate to be processed is a substrate having a step or a structure with a height of 30 nm or more.
[18]. A method for forming a metal oxide film to act as a planarizing film used in a semiconductor device production process, the method comprising applying the composition for forming a metal oxide film according to any one of [1] to [12] onto a substrate to be processed, followed by heating at a temperature of 100°C or more and 600°C or less for 10 to 600 seconds to form a cured film.
[19]. A method for forming a metal oxide film to act as a planarizing film used in a semiconductor device production process, the method comprising applying the composition for forming a metal oxide film according to any one of [1] to [12] onto a substrate to be processed, followed by heating under an atmosphere with an oxygen concentration of 0.1 volume % or more and 21 volume % or less to form a cured film.
[20]. A method for forming a metal oxide film to act as a planarizing film used in a semiconductor device production process, the method comprising applying the composition for forming a metal oxide film according to any one of [1] to [12] onto a substrate to be processed, followed by heating under an atmosphere having an oxygen concentration of less than 0.1 volume % to form a cured film.

It should be noted that the present invention is not limited to the above-described embodiments. The embodiments are just examples, and any examples that substantially have the same configuration and demonstrate the same functions and effects as those in the technical concept disclosed in claims of the present invention are included in the technical scope of the present invention.

## Claims

1. A composition for forming a metal oxide film, comprising (A) an organic-inorganic composite material and (B) a solvent,
(A) the organic-inorganic composite material being a reaction product of a metal source (I) and an organic source (II),
the metal source (I) comprising one or more compounds selected from a metal compound represented by the following general formula (I-1), a hydrolysate of the metal compound represented by the general formula (I-1), and a hydrolysis condensate of the metal compound represented by the general formula (I-1), and
the organic source (II) comprising a compound having a constituent unit represented by the following general formula (II-1) and a cardo structure, 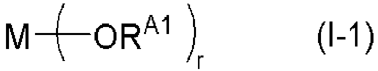 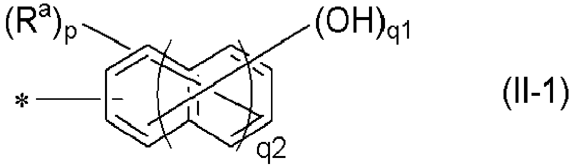 wherein M is a metal; each R^{A1} may be identical to or different from one another and represents a monovalent organic group having 1 to 30 carbon atoms with 0 or 1 hydroxy group; adjacent R^{A1} may be bonded to each other to form a spiro ring, and to form a ring together with O and M to which these R^{A1} are bonded; r is an integer of 3 to 6; R^{a} is an optionally substituted saturated monovalent organic group having 1 to 10 carbon atoms or an optionally substituted unsaturated monovalent organic group having 2 to 10 carbon atoms; "p" is an integer of 0 to 5; q₁ is an integer of 1 to 6; p+q₁ is an integer of 1 or more and 6 or less; q₂ is 0 or 1; and * represents a bonding site.

2. The composition for forming a metal oxide film according to claim 1, wherein the organic source (II) has a constituent unit represented by the following general formula (II-2), in addition to the constituent unit represented by the general formula (II-1) and a cardo structure, 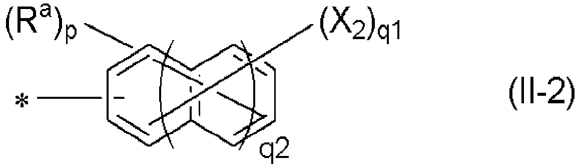 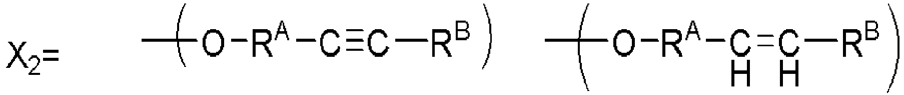 in the above general formula (II-2), R^{A} is an optionally substituted divalent organic group having 1 to 10 carbon atoms; R^{B} is a hydrogen atom or an optionally substituted monovalent organic group having 1 to 10 carbon atoms; and R^{a}, p, q₁, q₂, and * are as defined in the general formula (II-1).

3. The composition for forming a metal oxide film according to claim 2, wherein the organic source (II) as a whole satisfies relationships: a+b=1 and 0.2≤b≤0.8, wherein "a" represents the proportion of the constituent unit represented by the general formula (II-1), and "b" represents the proportion of the constituent unit represented by the general formula (II-2); preferably wherein, in the general formula (II-2), X₂ is a compound represented by the following general formula (X-1), 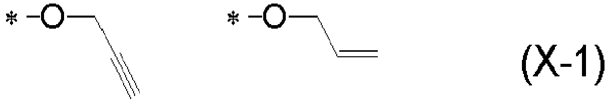 wherein * represents a bonding site.

4. The composition for forming a metal oxide film according to any one of claims 1 to 3, wherein the organic source (II) comprises compounds represented by the following general formulae (1) to (3), 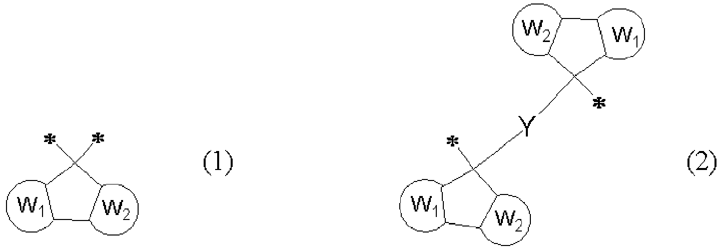 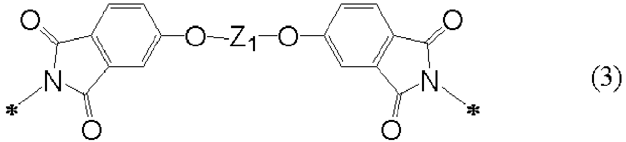 wherein W₁ and W₂ each independently represent a benzene ring or a naphthalene ring, and hydrogen atoms in the benzene ring and the naphthalene ring are optionally substituted with a hydrocarbon group having 1 to 6 carbon atoms; Y is a group represented by the following general formula (4); Z₁ is a group represented by the following general formula (5); and * is a site bonded with the constituent unit represented by the general formula (II-1), 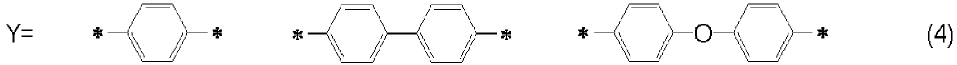 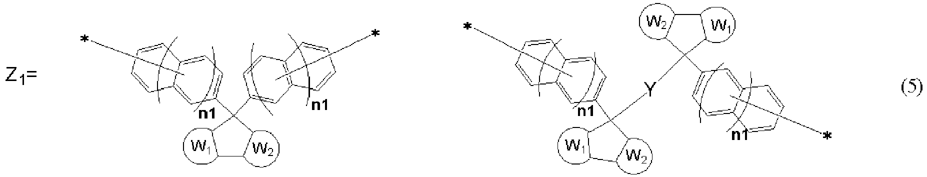 where W₁, W₂, and Y are as defined above, and n₁ is 0 or 1; and in the general formulae (4) and (5), * represents a bonding site.

5. The composition for forming a metal oxide film according to any one of claims 1 to 4, wherein a ratio Mw/Mn (dispersity) in the compound contained in the organic source (II) is in a range of 1.00≤Mw/Mn≤1.25, the Mw/Mn being a ratio of the weight average molecular weight Mw to the number average molecular weight Mn on polystyrene basis according to gel permeation chromatography.

6. The composition for forming a metal oxide film according to any one of claims 1 to 5, wherein M in the general formula (I-1) comprises a metal selected from the group consisting of Zr, Ta, Hf, Ti, Sn, Nb, Mo, Ge, and W.

7. The composition for forming a metal oxide film according to any one of claims 1 to 6, wherein the composition further comprises (C) a flowability accelerator having a weight reduction rate in a range from 30°C to 190°C of less than 30% and a weight reduction rate in a range from 30°C to 350°C of 98% or more; preferably
wherein (C) the flowability accelerator comprises one or more compounds selected from the following general formulae (i) to (iii), 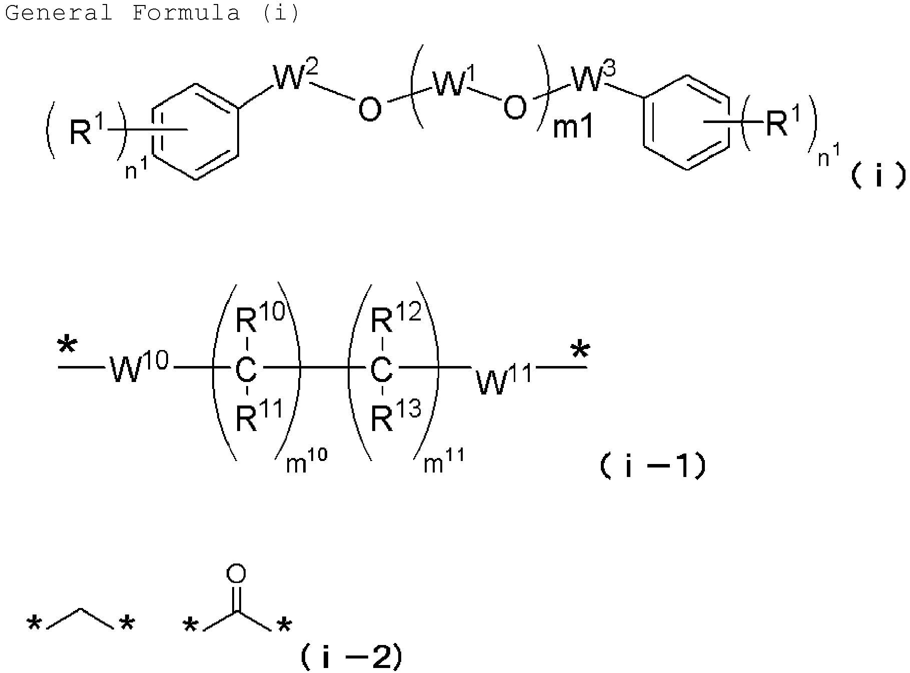 wherein R¹ independently represents a hydrogen atom, a hydroxyl group, or an optionally substituted organic group having 1 to 10 carbon atoms; W¹ is a phenylene group or a divalent group represented by the general formula (i-1); each of W² and W³ is a single bond or any of the divalent groups represented by the general formula (i-2); m¹ is an integer of 1 to 10; n¹ is an integer of 0 to 5; * represents a bonding site; each of R¹⁰, R¹¹, R¹², and R¹³ represents a hydrogen atom, a hydroxyl group, or an organic group having 1 to 10 carbon atoms; W¹⁰ and W¹¹ independently represent a single bond or a carbonyl group; each of m¹⁰ and m¹¹ is an integer of 0 to 10, and m¹⁰+m¹¹≥1, 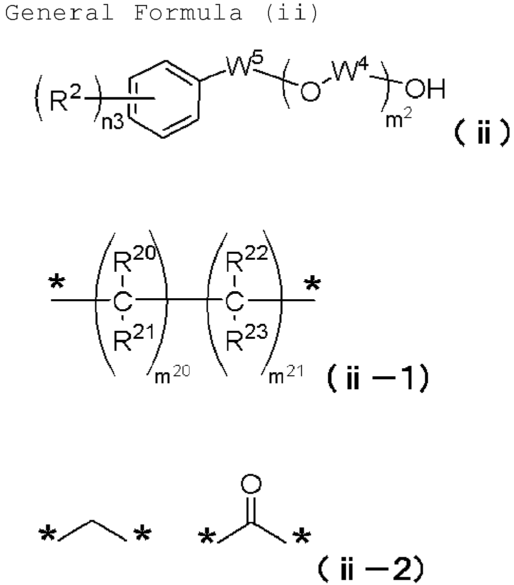 wherein R² independently represents a hydrogen atom, a hydroxyl group, or an optionally substituted organic group having 1 to 10 carbon atoms; W⁴ is a divalent group represented by the general formula (ii-1); W⁵ is a single bond or any of the divalent groups represented by the general formula (ii-2); m² is an integer of 2 to 10; n³ is an integer of 0 to 5; * represents a bonding site; and each of R²⁰, R²¹, R²², and R²³ represents a hydrogen atom, a hydroxyl group, or an organic group having 1 to 10 carbon atoms; each of m²⁰ and m²¹ is an integer of 0 to 10, and m²⁰+m²¹≥1, 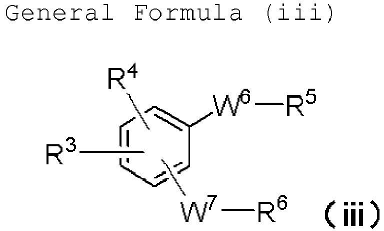 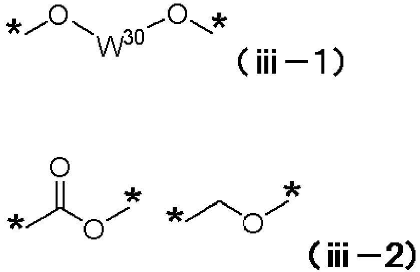 wherein each of R³ and R⁴ represents a hydrogen atom, a hydroxyl group, or an optionally substituted organic group having 1 to 10 carbon atoms, and R³ and R⁴ may be bonded to each other to form a cyclic structure; each of R⁵ and R⁶ is an organic group having 1 to 10 carbon atoms, and R³ is a group containing either an aromatic ring or a divalent group represented by the general formula (iii-1); each of W⁶ and W⁷ is a single bond or any of the divalent groups represented by the general formula (iii-2), and at least one of W⁶ and W⁷ is one of the divalent groups represented by the general formula (iii-2); W³⁰ is an organic group having 1 to 4 carbon atoms; and * represents a bonding site.

8. The composition for forming a metal oxide film according to any one of claims 1 to 7, wherein the composition for forming a metal oxide film further comprises (D) a metal oxide nanoparticle having an average primary particle size of 100 nm or less; preferably
wherein (D) the metal oxide nanoparticle is one or more selected from the group consisting of zirconium oxide nanoparticle, hafnium oxide nanoparticle, titanium oxide nanoparticle, tin oxide nanoparticle, and tungsten oxide nanoparticle.

9. The composition for forming a metal oxide film according to any one of claims 1 to 8, wherein the composition further comprises one or more of a crosslinking agent, a surfactant, an acid generator, and a plasticizer.

10. A patterning process for forming a pattern in a substrate to be processed, comprising the steps of:
a)
(I-1) applying the composition for forming a metal oxide film according to any one of claims 1 to 9 onto a substrate to be processed, followed by heating to form a metal oxide film;
(I-2) forming a resist upper layer film on the metal oxide film by using a photoresist material;
(I-3) subjecting the resist upper layer film to pattern exposure and then development with a developer to form a pattern in the resist upper layer film;
(I-4) transferring the pattern to the metal oxide film by dry etching while using the resist upper layer film having the formed pattern as a mask; and
(I-5) processing the substrate to be processed while using the metal oxide film having the formed pattern as a mask to form the pattern in the substrate to be processed; or
b)
(II-1) applying the composition for forming a metal oxide film according to any one of claims 1 to 9 onto a substrate to be processed, followed by heating to form a metal oxide film;
(II-2) forming a resist middle layer film on the metal oxide film;
(II-3) forming a resist upper layer film on the resist middle layer film by using a photoresist material;
(II-4) subjecting the resist upper layer film to pattern exposure and then development with a developer to form a pattern in the resist upper layer film;
(II-5) transferring the pattern to the resist middle layer film by dry etching while using the resist upper layer film having the formed pattern as a mask;
(II-6) transferring the pattern to the metal oxide film by dry etching while using the resist middle layer film having the transferred pattern as a mask; and
(II-7) processing the substrate to be processed while using the metal oxide film having the formed pattern as a mask to form the pattern in the substrate to be processed; or
c)
(III-1) applying the composition for forming a metal oxide film according to any one of claims 1 to 9 onto a substrate to be processed, followed by heating to form a metal oxide film;
(III-2) forming an inorganic hard mask middle layer film selected from a silicon oxide film, a silicon nitride film, and a silicon oxynitride film on the metal oxide film;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the metal oxide film by dry etching while using the inorganic hard mask middle layer film having the transferred pattern as a mask; and
(III-8) processing the substrate to be processed while using the metal oxide film having the formed pattern as a mask to form the pattern in the substrate to be processed; or
d)
(IV-1) forming a resist underlayer film on a substrate to be processed;
(IV-2) forming a resist middle layer film, or a combination of an inorganic hard mask middle layer film selected from a silicon oxide film, a silicon nitride film, and a silicon oxynitride film and an organic thin film on the resist underlayer film;
(IV-3) forming a resist upper layer film on the resist middle layer film, or the combination of the inorganic hard mask middle layer film and the organic thin film by using a photoresist material;
(IV-4) subjecting the resist upper layer film to pattern exposure and then development with a developer to form a pattern in the resist upper layer film;
(IV-5) transferring a pattern to the resist middle layer film or the organic thin film and the inorganic hard mask middle layer film by dry etching while using the resist upper layer film having the formed pattern as a mask;
(IV-6) transferring a pattern to the resist underlayer film by dry etching while using the resist middle layer film or the inorganic hard mask middle layer film having the transferred pattern as a mask;
(IV-7) applying the composition for forming a metal oxide film according to any one of claims 1 to 9 onto the resist underlayer film having the formed pattern, followed by heating to cover the resist underlayer film with a metal oxide film, thereby filling a space between the resist underlayer film patterns with the metal oxide film;
(IV-8) etching back the metal oxide film covering the resist underlayer film having the formed pattern by a chemical stripper or dry etching to uncover an upper surface of the resist underlayer film having the formed pattern;
(IV-9) removing the resist middle layer film or the hard mask middle layer film remaining on the upper surface of the resist underlayer film by dry etching;
(IV-10) removing the resist underlayer film having the formed pattern with its surface uncovered by dry etching to form a reverse pattern of an original pattern in the metal oxide film; and
(IV-11) processing the substrate to be processed while using the metal oxide film having the formed reversal pattern as a mask to form a reversal pattern in the substrate to be processed.

11. The patterning process according to claim 10, wherein the substrate to be processed is a substrate having a step or a structure with a height of 30 nm or more.

12. A method for forming a metal oxide film to act as a planarizing film used in a semiconductor device production process, the method comprising applying the composition for forming a metal oxide film according to any one of claims 1 to 9 onto a substrate to be processed; and
a)
followed by heating at a temperature of 100°C or more and 600°C or less for 10 to 600 seconds to form a cured film; or
b)
followed by heating under an atmosphere with an oxygen concentration of 0.1 volume % or more and 21 volume % or less to form a cured film; or
c)
followed by heating under an atmosphere having an oxygen concentration of less than 0.1 volume % to form a cured film.
